(19) Europäisches Patentamt
European Patent Office
Office européen des brevets

(11) EP 3 287 819 A1

(12) EUROPEAN PATENT APPLICATION
published in accordance with Art. 153(4) EPC

(43) Date of publication:
**28.02.2018 Bulletin 2018/09**

(21) Application number: **16783062.9**

(22) Date of filing: **12.04.2016**

(51) Int Cl.:
***G02B 5/30*** *(2006.01)* ***B05D 7/24*** *(2006.01)*
***B32B 7/02*** *(2006.01)* ***B32B 27/00*** *(2006.01)*
***H01L 51/50*** *(2006.01)* ***H05B 33/02*** *(2006.01)*

(86) International application number:
**PCT/JP2016/061824**

(87) International publication number:
**WO 2016/171041 (27.10.2016 Gazette 2016/43)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **24.04.2015 JP 2015089498**

(71) Applicant: **Zeon Corporation**
**Tokyo 100-8246 (JP)**

(72) Inventors:
- **IKEDA Akira**
  **Tokyo 100-8246 (JP)**
- **SAITO, Masakazu**
  **Tokyo 100-8246 (JP)**

(74) Representative: **Maiwald Patentanwalts GmbH**
**Elisenhof**
**Elisenstrasse 3**
**80335 München (DE)**

# (54) MULTILAYER FILM MANUFACTURING METHOD AND MULTILAYER FILM

(57) A method for producing a multilayer film including a substrate and an optically anisotropic layer, the method comprising: a step of coating a surface of the substrate with a liquid crystal composition containing a polymerizable liquid crystal compound capable of expressing an inverse wavelength dispersion birefringence to form a layer of the liquid crystal composition; and a step of polymerizing the polymerizable liquid crystal compound contained in the layer of the liquid crystal composition to obtain an optically anisotropic layer, wherein the surface of the substrate has a surface free energy of 50 mN/m or less, and the liquid crystal composition has a surface tension of 26 mN/m or more.

FIG.1

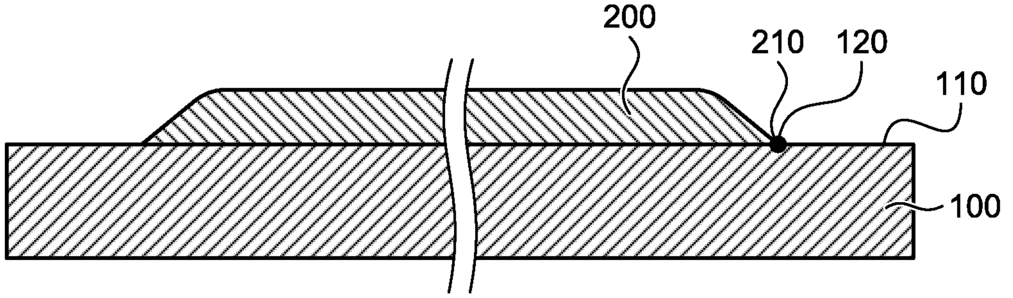


EP 3 287 819 A1

## Description

### Field

The present invention relates to a multilayer film which is produced with a liquid crystal composition and includes an optically anisotropic layer, and a method for producing the same.

### Background

When an optical film is produced with a liquid crystal compound, a desired optical film may be produced by coating a surface of an appropriate substrate with a composition containing the liquid crystal compound to obtain a layer, and curing the layer. In such a method, it may be required that the liquid crystal compound is appropriately oriented. Accordingly, there have been considered various techniques for orienting the liquid crystal compound (see Patent Literatures 1 to 3).
Also, the technique disclosed in Patent Literature 4 is known.

### Citation List

### Patent Literature

Patent Literature 1: Japanese Patent Application Laid-Open No. 2001-100213 A
Patent Literature 2: Japanese Patent Application Laid-Open No. 2008-209509 A
Patent Literature 3: Japanese Patent Publication No. 2631015 B
Patent Literature 4: Japanese Patent Application Laid-Open No. 2006-281176 A

### Summary

### Technical Problem

As one of optical films, there is a film which includes an optically anisotropic layer. Such an optically anisotropic layer usually has retardation, and may be used for uses such as a 1/4 wave plate and a 1/2 wave plate.
The optically anisotropic layer desirably has an inverse wavelength dispersion retardation so that the optically anisotropic layer uniformly exerts its function in a wide wavelength band. Therefore, for achieving the inverse wavelength dispersion retardation of the optically anisotropic layer, a technique of producing an optically anisotropic layer with a liquid crystal compound containing a polymerizable liquid crystal composition capable of expressing an inverse wavelength dispersion birefringence is required to be developed.
Also, when the optically anisotropic layer is formed by coating with the liquid crystal composition, the liquid crystal composition is required to have favorable coating properties in order to improve the quality of the produced optically anisotropic layer. Here, the favorable coating properties of the liquid crystal composition refers to a matter in which the coating adherence of the liquid crystal composition is favorable with little cissing. In general, it is known that when a certain surface is coated with a certain liquid, the coating adherence of the liquid is favorable with little cissing, if the surface free energy of the surface is sufficiently higher than the surface tension of the liquid. Therefore, when the optically anisotropic layer is formed by coating a substrate with the liquid crystal composition, the surface of the substrate was often subjected to a surface treatment such as an oriented film-forming treatment and a corona treatment for increasing the surface free energy of the surface of the substrate.
However, for suppressing production costs and improving production efficiency, it is desirable that the step of subjecting the surface of the substrate to a surface treatment is omitted. Therefore, the present inventors have attempted to reduce the surface tension of the liquid crystal composition such that it is sufficiently lower than the surface free energy of the surface of the substrate, aiming at improving the coating properties of the liquid crystal composition. However, it became clear that when the surface free energy of the surface of the substrate is low, coating becomes poor, or cissing occurs to a large extent, even when the surface tension of the liquid crystal composition is made sufficiently low.
The present invention has been devised in view of the aforementioned problem. An object of the present invention is to provide: a method for producing a multilayer film including a substrate and an optically anisotropic layer, the method including a step of coating, with favorable coating properties, a surface of the substrate having a low surface free energy with a liquid crystal composition containing a polymerizable liquid crystal compound capable of expressing an inverse wavelength dispersion birefringence; and a multilayer film obtained by coating, with favorable coating properties, a surface of the substrate having a low surface free energy with a liquid crystal composition containing a polymerizable liquid crystal compound capable of expressing an inverse wavelength dispersion birefringence.

Solution to Problem

The present inventors have intensively conducted research for solving the aforementioned problem, and as a result, have found that when the surface of the substrate having a low surface free energy is coated with a liquid crystal composition containing a polymerizable liquid crystal compound capable of expressing an inverse wavelength dispersion birefringence, the coating properties of the liquid crystal composition can be improved when the surface tension of the liquid crystal composition falls within a specific range. Thus, the present invention has been completed.

That is, the present invention is as follows.

(1) A method for producing a multilayer film including a substrate and an optically anisotropic layer, the method comprising:

a step of coating a surface of the substrate with a liquid crystal composition containing a polymerizable liquid crystal compound capable of expressing an inverse wavelength dispersion birefringence to form a layer of the liquid crystal composition; and
a step of polymerizing the polymerizable liquid crystal compound contained in the layer of the liquid crystal composition to obtain an optically anisotropic layer, wherein
the surface of the substrate has a surface free energy of 50 mN/m or less, and
the liquid crystal composition has a surface tension of 26 mN/m or more.

(2) The method for producing a multilayer film according to (1), wherein the polymerizable liquid crystal compound contains a main-chain mesogene and a side-chain mesogene linked to the main-chain mesogene in a molecule of the polymerizable liquid crystal compound.
(3) The method for producing a multilayer film according to (1) or (2), wherein the polymerizable liquid crystal compound is represented by the following Formula (I):

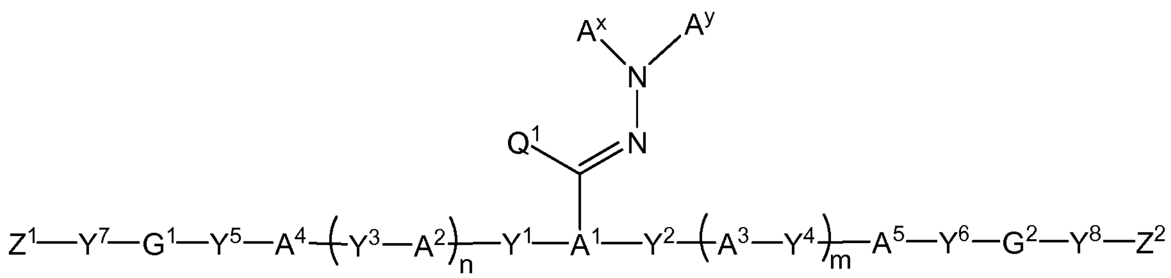

(I)

(in the Formula (I),

$Y^1$ to $Y^8$ are each independently a chemical single bond, -O-, -S-, -O-C(=O)-, -C(=O)-O-, -O-C(=O)-O-, $-NR^1-C(=O)-$,$-C(=O)-NR^1-$, $-O-C(=O)-NR^1-$, $-NR^1-C(=O)-O-$, $-NR^1-C(=O)-NR^1-$,$-O-NR^1-$, or $-NR^1-O-$, wherein $R^1$ is a hydrogen atom or an alkyl group of 1 to 6 carbon atoms;
$G^1$ and $G^2$ are each independently a divalent aliphatic group of 1 to 20 carbon atoms optionally having a substituent; the aliphatic groups may have one or more per one aliphatic group of -O-, -S-, -O-C(=O)-, -C(=O)-O-, -O-C(=O)-O-, $-NR^2-C(=O)-$, $-C(=O)-NR^2-$, $-NR^2-$, or -C(=O)-inserted therein; provided that a case where two or more-O- or -S- groups are adjacently inserted are excluded, wherein $R^2$ is a hydrogen atom or an alkyl group of 1 to 6 carbon atoms;
$Z^1$ and $Z^2$ are each independently an alkenyl group of 2 to 10 carbon atoms optionally being substituted by a halogen atom;
$A^x$ is an organic group of 2 to 30 carbon atoms having at least one aromatic ring selected from the group consisting of an aromatic hydrocarbon ring and an aromatic heterocyclic ring;
$A^y$ is a hydrogen atom, an alkyl group of 1 to 20 carbon atoms optionally having a substituent, an alkenyl group of 2 to 20 carbon atoms optionally having a substituent, a cycloalkyl group of 3 to 12 carbon atoms optionally

having a substituent, an alkynyl group of 2 to 20 carbon atoms optionally having a substituent, -C(=O)-$R^3$, -$SO_2$-$R^4$, -C(=S)NH-$R^9$, or an organic group of 2 to 30 carbon atoms having at least one aromatic ring selected from the group consisting of an aromatic hydrocarbon ring and an aromatic heterocyclic ring, wherein $R^3$ is an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, or an aromatic hydrocarbon ring group of 5 to 12 carbon atoms; $R^4$ is an alkyl group of 1 to 20 carbon atoms, an alkenyl group of 2 to 20 carbon atoms, a phenyl group, or a 4-methylphenyl group; $R^9$ is an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, or an aromatic group of 5 to 20 carbon atoms optionally having a substituent; the aromatic ring that $A^x$ and $A^y$ have may have a substituent; and $A^x$ and $A^y$ may form a ring together;
$A^1$ is a trivalent aromatic group optionally having a substituent;
$A^2$ and $A^3$ are each independently a divalent alicyclic hydrocarbon group of 3 to 30 carbon atoms optionally having a substituent;
$A^4$ and $A^5$ are each independently a divalent aromatic group of 6 to 30 carbon atoms optionally having a substituent;
$Q^1$ is a hydrogen atom or an alkyl group of 1 to 6 carbon atoms optionally having a substituent; and
m and n are each independently 0 or 1).

(4) The method for producing a multilayer film according to any one of (1) to (3), wherein the substrate is a stretched film.
(5) The method for producing a multilayer film according to any one of (1) to (4), wherein the substrate is formed of a resin which includes an alicyclic structure-containing polymer.
(6) The method for producing a multilayer film according to any one of (1) to (5), wherein the surface of the substrate is an untreated surface which is not subjected to a surface treatment.
(7) A multilayer film comprising:

a substrate; and
an optically anisotropic layer obtained by coating a surface of the substrate having a surface free energy of 50 mN/m or less, with a liquid crystal composition which contains a polymerizable liquid crystal compound capable of expressing an inverse wavelength dispersion birefringence and has a surface tension of 26 mN/m or more, and then polymerizing the polymerizable liquid crystal compound.

## Advantageous Effects of Invention

According to the present invention, there can be provided: a method for producing a multilayer film including a substrate and an optically anisotropic layer, the method including a step of coating, with favorable coating properties, a surface of the substrate having a low surface free energy with a liquid crystal composition containing a polymerizable liquid crystal compound capable of expressing an inverse wavelength dispersion birefringence; and a multilayer film obtained by coating, with favorable coating properties, a surface of the substrate having a low surface free energy with a liquid crystal composition containing a polymerizable liquid crystal compound capable of expressing an inverse wavelength dispersion birefringence.

## Brief Description of Drawings

Fig. 1 is a cross-sectional view which schematically illustrates an example of a liquid crystal composition layer immediately after a coating surface of a substrate was coated with a liquid crystal composition.
Fig. 2 is a cross-sectional view which schematically illustrates an example of a liquid crystal composition layer after the time has elapsed since a coating surface of a substrate was coated with a liquid crystal composition.
Fig. 3 is a cross-sectional view which schematically illustrates an example of a liquid crystal composition layer after the time has elapsed since a coating surface of a substrate was coated with a liquid crystal composition.
Fig. 4 is a perspective view schematically illustrating an example of a liquid crystal composition layer in which a cissing portion is generated by a foreign substance adhering to a coating surface of a substrate.

Description of Embodiments

Hereinafter, the present invention will be described in detail with reference to examples and embodiments. However, the present invention is not limited to the following examples and embodiments and may be freely modified and practiced without departing from the scope of claims of the present invention and the scope of their equivalents.
In the following description, the resin having a positive intrinsic birefringence value means a resin having a refractive index in a stretching direction which is larger than the refractive index in a direction orthogonal to the stretching direction. The resin having a negative intrinsic birefringence value means a resin having a refractive index in a stretching direction which is smaller than the refractive index in a direction orthogonal to the stretching direction. The intrinsic birefringence value may be calculated from a dielectric constant distribution.
In the following description, the retardation of a certain layer refers to an in-plane retardation Re, unless otherwise stated. This in-plane retardation Re is a value represented by Re = (nx - ny) $\times$ d, unless otherwise stated. Here, nx represents a refractive index in a direction which provides a maximum refractive index among the directions that are perpendicular to the thickness direction of a layer (in-plane directions). ny represents a refractive index in a direction in the layer orthogonal to the direction of nx among the in-plane directions. d represents the thickness of a layer. The measurement wavelength of retardation is 550 nm, unless otherwise stated.
In the following description, the direction of the slow axis of a certain layer means the direction of the slow axis among the in-plane directions, unless otherwise stated.
In the following description, the "polarizing plate" and "wave plate" are used as terms which encompass a flexible film or a flexible sheet such as a resin film, unless otherwise stated.
In the following description, when the direction of an element is "parallel" and "perpendicular", it may contain an error within the range that does not impair the effects of the present invention, for example, within the range of $\pm$ 5°, preferably $\pm$ 3°, and more preferably $\pm$ 1°, unless otherwise stated.

[1. Outline of Method for Producing Multilayer Film]

The method for producing a multilayer film according to the present invention includes: a step of coating a surface of a substrate with a liquid crystal composition containing a polymerizable liquid crystal compound capable of expressing an inverse wavelength dispersion birefringence to form a layer of this liquid crystal composition; and a step of polymerizing the polymerizable liquid crystal compound contained in the layer of the liquid crystal composition to obtain an optically anisotropic layer. According to this production method, a multilayer film which includes a substrate and an optically anisotropic layer can be produced. In the following description, the surface of the substrate to be coated with the liquid crystal composition is sometimes appropriately referred to as a "coating surface". In the following description, the polymerizable liquid crystal compound capable of expressing an inverse wavelength dispersion birefringence is sometimes appropriately referred to as an "inverse wavelength polymerizable liquid crystal compound".

[2. Preparation of Substrate]

As the substrate, a member having a surface having a specific surface free energy is used, and a film is usually used. The substrate may have a surface having a specific surface free energy on one side or on both sides. In the method for producing a multilayer film according to the present invention, the surface having a specific surface free energy of the substrate is used as the coating surface to be coated with the liquid crystal composition. However, the coating surface of the substrate has a specific surface free energy when the coating surface is coated with the liquid crystal composition, and the surface free energy after the inverse wavelength polymerizable liquid crystal compound contained in the liquid crystal composition has been polymerized is arbitrary.
The surface free energy of the coating surface of the substrate is usually 50 mN/m or less, preferably 45 mN/m or less, and particularly preferably 40 mN/ or less. It has hitherto been difficult to perform favorable coating of the surface having such a low surface free energy of the substrate with the liquid crystal composition. However, favorable coating of the substrate can be specifically performed with a specific liquid crystal composition which contains an inverse wavelength polymerizable liquid crystal compound. The lower limit value of the surface free energy of the coating surface of the substrate is preferably 25 mN/m or more, more preferably 30 mN/m or more, and particularly preferably 35 mN/m or more, although not limited thereto. The substrate with a coating surface having the surface free energy which is equal to or more than the aforementioned lower limit value of the range can be produced without a treatment to adjust the surface free energy. This reduces the production costs of the multilayer film.
Examples of the method for confining the surface free energy of the coating surface of the substrate to the aforementioned range may include selecting an appropriate material as a material of the substrate, and avoiding a treatment to the substrate for increasing the surface free energy of the coating surface.
The surface free energy of the coating surface of the substrate may be obtained by measuring the contact

angles of pure water ($H_2O$) and diiodomethane ($CH_2I_2$) on the coating surface, and calculating the surface free energy from the measured contact angles in accordance with the Owens-Wendt analysis theory. For this analysis theory, reference may be made to "D. K. Owens, R. C. Wendt, J. Appl. Polym. Sci., 13, 1741, (1969)".

Specifically, the surface free energy may be measured by the following method.

The contact angle $\theta_{H2O}$ of pure water $H_2O$ and the contact angle $\theta_{CH2I2}$ of diiodomethane $CH_2I_2$ are experimentally measured on the coating surface of the substrate. The measurement of the contact angles is performed by adjusting the humidity of the substrate under the condition of 25°C in temperature and 60% in humidity for one hour or more, and thereafter measuring the contact angles under the same condition.

From the measured contact angles $\theta_{H2O}$ and $\theta_{CH2I2}$, component $\gamma^d$ and component $\gamma^h$ are calculated by the following simultaneous equations (X) and (Y). In the following formulae (X) and (Y), $\gamma_{H2O}{}^d$ = 21.8, $\gamma_{H2O}{}^h$ = 51.0, $\gamma_{H2O}{}^v$ = 72.8, $\gamma_{CH2I2}{}^d$ = 49.5, $\gamma_{CH2I2}{}^h$ = 1.3, and $\gamma_{CH2I2}{}^v$ = 50.8.

Then, the sum of the calculated component $\gamma^d$ and component $\gamma^h$ is calculated, thereby to obtain the surface free energy $\gamma$ (= $\gamma^d$ + $\gamma^h$) on the coating surface of the substrate.

$$1+\cos\theta_{H2O} = 2\sqrt{\gamma^d}\left(\frac{\sqrt{\gamma_{H2O}{}^d}}{\gamma_{H2O}{}^v}\right) + 2\sqrt{\gamma^h}\left(\frac{\sqrt{\gamma_{H2O}{}^h}}{\gamma_{H2O}{}^v}\right) \qquad (X)$$

$$1+\cos\theta_{CH2I2} = 2\sqrt{\gamma^d}\left(\frac{\sqrt{\gamma_{CH2I2}{}^d}}{\gamma_{CH2I2}{}^v}\right) + 2\sqrt{\gamma^h}\left(\frac{\sqrt{\gamma_{CH2I2}{}^h}}{\gamma_{CH2I2}{}^v}\right) \qquad (Y)$$

As the material for forming the substrate, resin is usually used. As the resin, there may be used any resin from which the substrate with a coating surface having the aforementioned specific surface free energy can be obtained. As such a resin, a resin having a positive intrinsic birefringence value is preferable, from the viewpoint of a high orientation regulating force, high mechanical strength, and low costs. In particular, a resin including an alicyclic structure-containing polymer is preferable, because it is excellent in transparency, low hygroscopicity, size stability, and lightweight properties.

The alicyclic structure-containing polymer is a polymer of which the structural unit contains an alicyclic structure, and is usually an amorphous polymer without a melting point. This alicyclic structure-containing polymer may have an alicyclic structure in its main chain, or may have an alicyclic structure in its side chain. In particular, the alicyclic structure-containing polymer preferably contains an alicyclic structure in its main chain, from the viewpoint of mechanical strength and heat resistance.

Examples of the alicyclic structure may include a saturated alicyclic hydrocarbon (cycloalkane) structure, and an unsaturated alicyclic hydrocarbon (cycloalkene, cycloalkyne) structure. In particular, from the viewpoint of mechanical strength and thermal stability, a cycloalkane structure and a cycloalkene structure are preferable, and a cycloalkane structure is particularly preferable.

The number of carbon atoms which constitute the alicyclic structure is preferably 4 or more, more preferably 5 or more, and particularly preferably 6 or more, and is preferably 30 or less, more preferably 20 or less, and particularly preferably 15 or less per one alicyclic structure. When the number of carbon atoms which constitute the alicyclic structure falls within this range, the mechanical strength, heat resistance, and molding properties of the substrate can be highly balanced.

In the alicyclic structure-containing polymer, the ratio of the structural unit having an alicyclic structure may be appropriately selected depending on the intended use. The ratio of the structural unit having an alicyclic structure in the alicyclic structure-containing polymer is preferably 50% by weight or more, more preferably 70% by weight or more, and particularly preferably 90% by weight or more. When the ratio of the structural unit having an alicyclic structure in the alicyclic structure-containing polymer falls within this range, the substrate can have favorable transparency and heat resistance.

Examples of the alicyclic structure-containing polymer may include a norbornene-based polymer, a monocyclic olefin-based polymer, a cyclic conjugated diene-based polymer, a vinyl alicyclic hydrocarbon polymer, and hydrogenated products thereof. Among these, a norbornene-based polymer is more preferable, because it has favorable transparency and molding properties.

Examples of the norbornene-based polymer may include: a ring-opening polymer of a monomer having a norbornene structure, and a hydrogenated product thereof; and an addition polymer of a monomer having a norbornene structure, and a hydrogenated product thereof. Examples of the ring-opening polymer of a monomer having a norbornene

structure may include a ring-opening homopolymer of one type of monomer having a norbornene structure, a ring-opening copolymer of two or more types of monomers each having a norbornene structure, and a ring-opening copolymer of a monomer having a norbornene structure and an optional monomer which is capable of being copolymerized with the monomer having a norbornene structure. Furthermore, examples of the addition polymer of a monomer having a norbornene structure may include an addition homopolymer of one type of monomer having a norbornene structure, an addition copolymer of two or more types of monomers each having a norbornene structure, and an addition copolymer of a monomer having a norbornene structure and an optional monomer which is capable of being copolymerized with the monomer having a norbornene structure. Among these, the hydrogenated product of the ring-opening polymer of a monomer having a norbornene structure is particularly suitable, from the viewpoint of molding properties, heat resistance, low hygroscopicity, size stability, lightweight properties, and the like.

Examples of the monomer having a norbornene structure may include bicyclo[2.2.1]hept-2-ene (common name: norbornene), tricyclo[4.3.0.$1^{2,5}$]dec-3,7-diene (common name: dicyclopentadiene), 7,8-benzotricyclo[4.3.0.$1^{2,5}$]dec-3-ene (common name: methanotetrahydrofluorene), tetracyclo [4.4.0.$1^{2,5}$.$1^{7,10}$] dodeca-3-ene (common name: tetracyclododecene), and derivatives of these compounds (for example, a derivative having a substituent on the ring). Examples of the substituent herein may include an alkyl group, an alkylene group, and a polar group. These substituents may be the same as or different from each other, and a plurality of substituents may be bonded on the ring. As the monomer having a norbornene structure, one type thereof may be solely used, and two or more types thereof may also be used in combination at any ratio.

Examples of the polar group may include a hetero atom, and an atomic group having a hetero atom. Examples of the hetero atom may include an oxygen atom, a nitrogen atom, a sulfur atom, a silicon atom, and a halogen atom. Specific examples of the polar group may include a carboxyl group, a carbonyloxycarbonyl group, an epoxy group, a hydroxyl group, an oxy group, an ester group, a silanol group, a silyl group, an amino group, a nitrile group, and a sulfonic acid group.

Examples of the monomer which is capable of being ring-opening copolymerized with the monomer having a norbornene structure may include monocyclic olefins such as cyclohexene, cycloheptene, cyclooctene, and derivatives thereof; and cyclic conjugated diene such as cyclohexadiene and cycloheptadiene, and derivatives thereof. As the monomer which is capable of being ring-opening copolymerized with the monomer having a norbornene structure, one type thereof may be solely used, and two or more types thereof may also be used in combination at any ratio.

The ring-opening polymer of a monomer having a norbornene structure may be produced by, for example, polymerization or copolymerization of the monomer in the presence of a ring-opening polymerization catalyst.

Examples of the monomer which is capable of being addition-copolymerized with the monomer having a norbornene structure may include $\alpha$-olefin having 2 to 20 carbon atoms such as ethylene, propylene, and 1-butene, and derivatives thereof; cycloolefin such as cyclobutene, cyclopentene and cyclohexene, and derivatives thereof; and non-conjugated diene such as 1,4-hexadiene, 4-methyl-1,4-hexadiene, and 5-methyl-1,4-hexadiene. Among these, $\alpha$-olefin is preferable, and ethylene is more preferable. As the monomer which is capable of being addition-copolymerized with the monomer having a norbornene structure, one type thereof may be solely used, and two or more types thereof may also be used in combination at any ratio.

The addition polymer of a monomer having a norbornene structure may be produced by, for example, polymerization or copolymerization of the monomer in the presence of an addition polymerization catalyst.

The hydrogenated product of the aforementioned ring-opening polymer or addition polymer may be produced by, for example, hydrogenating preferably 90% or more of unsaturated carbon-carbon bonds in a solution of the ring-opening polymer or the addition polymer, in the presence of a hydrogenation catalyst which contains transition metal such as nickel and palladium.

The weight-average molecular weight (Mw) of the alicyclic structure-containing polymer is preferably 10,000 or more, more preferably 15,000 or more, and particularly preferably 25,000 or more, and is preferably 100,000 or less, more preferably 80,000 or less, and particularly preferably 50,000 or less. When the weight-average molecular weight falls within such a range, the mechanical strength and molding processability of the substrate can be highly balanced.

The molecular weight distribution (weight-average molecular weight (Mw) / number-average molecular weight (Mn)) of the alicyclic structure-containing polymer is preferably 1.0 or more, more preferably 1.2 or more, and particularly preferably 1.5 or more, and is preferably 10.0 or less, more preferably 4.0 or less, and particularly preferably 3.5 or less. When the molecular weight distribution is equal to or more than the lower limit value of the aforementioned range, productivity of a polymer can be enhanced, and production costs can thereby be reduced. When the molecular weight distribution is equal to or less than the upper limit value, the amount of a low molecular component is reduced, and thereby relaxation during exposure to high temperature can be suppressed. Consequently, stability of the substrate can be enhanced.

The weight-average molecular weight (Mw) and the number-average molecular weight (Mn) may be measured as a value of polyisoprene equivalent by gel permeation chromatography with cyclohexane as a solvent. When a sample is not dissolved in cyclohexane in the gel permeation chromatography, toluene may be used as a solvent. When toluene

is used as a solvent, the weight-average molecular weight (Mw) and the number-average molecular weight (Mn) may be measured as a value of polystyrene equivalent.

The glass transition temperature of the alicyclic structure-containing polymer is preferably 80°C or higher, and more preferably 100°C or higher, and is preferably 250°C or lower, more preferably 160°C or lower, and particularly preferably 140°C or lower. When the glass transition temperature of the alicyclic structure-containing polymer is equal to or more than the lower limit value of the aforementioned range, deformation and stress generation under the high temperature environment can be suppressed, and durability of the substrate can thereby be enhanced. When the glass transition temperature of the alicyclic structure-containing polymer is equal to or less than the upper limit value of the aforementioned range, stretching treatment to the substrate can be easily performed.

The content of the resin component having a molecular weight of 2,000 or less (that is, an oligomer component) in the resin including the alicyclic structure-containing polymer is preferably 5% by weight or less, more preferably 3% by weight or less, and further preferably 2% by weight or less. When the amount of the oligomer component falls within the aforementioned range, generation of fine convex portions on the surface of the substrate decreases, whereby thickness variations is reduced and surface accuracy is improved. The method for reducing the amount of the oligomer component may include optimizing the selection of a polymerization catalyst and a hydrogenation catalyst, the reaction conditions such as those for polymerization and hydrogenation, and the temperature conditions in the step of obtaining pellets of resin as a molding material. The amount of such an oligomer component can be measured by the aforementioned gel permeation chromatography.

The ratio of the alicyclic structure-containing polymer in the resin which contains the alicyclic structure-containing polymer is preferably 70% by weight or more, more preferably 80% by weight or more, and particularly preferably 90% by weight or more. With such a ratio, heat resistance of the substrate can be effectively enhanced, and surface free energy of the coating surface of the substrate can be reduced.

The resin for forming the substrate may further contain an optional component, in combination with the aforementioned polymers. Examples of the optional component may include additives such as: a coloring agent such as a pigment and a dye; a plasticizer; a fluorescent brightener; a dispersant; a thermal stabilizer; a light stabilizer; an antistatic agent; a UV absorber; an antioxidant; and a surfactant. One type thereof may be solely used, and two or more types thereof may also be used in combination at any ratio.

Suitable specific examples of the resin which contains the alicyclic structure-containing polymer may include "ZEONOR 1420" and "ZEONOR 1420R" manufactured by ZEON Corporation.

The coating surface of the substrate preferably has an orientation regulating force, in order to promote the orientation of the inverse wavelength polymerizable liquid crystal compound in the layer of the liquid crystal composition. The orientation regulating force refers to the property of the coating surface which can cause orientation of the inverse wavelength polymerizable liquid crystal compound in the liquid crystal composition coated on the coating surface. When the coating surface has the orientation regulating force, an optically anisotropic layer can be formed on the coating surface.

Examples of the method for imparting the orientation regulating force to the coating surface while achieving the aforementioned range of the surface free energy of the coating surface may include a stretching treatment. Therefore, as the substrate, it is preferable to use a stretched film. When the substrate is subjected to a stretching treatment under an appropriate condition, molecules of the polymers contained in the substrate can be oriented. Accordingly, the orientation regulating force, which causes orientation of the inverse wavelength polymerizable liquid crystal compound in the orientation direction of the molecules of the polymers contained in the substrate, can be imparted to the coating surface of the substrate. In particular, by such a stretching treatment, approximately uniform orientation of the molecular directors can be caused in an entire thickness direction of the substrate. Therefore, according to the stretching treatment, the time-dependent relaxation of the orientation regulating force attributable to environmental influences (such as heat, light, and oxygen) is unlikely to be caused, compared to the method of imparting the orientation regulating force to the substrate only by the molecular orientation in the vicinity of the surface of the substrate, like a rubbing treatment. Furthermore, by the stretching treatment, dust generation, scratches, and contamination with foreign substances, which are observed in the rubbing treatment, can be suppressed. Accordingly, an optically anisotropic layer having few orientation defects is likely to be obtained.

The stretching of the substrate is preferably performed such that anisotropy is imparted to the substrate, and a slow axis is expressed in the substrate. By such stretching, the orientation regulating force, which causes the inverse wavelength polymerizable liquid crystal compound to be oriented in the direction parallel to or perpendicular to the slow axis of the substrate, is usually imparted to the surface of the substrate. For example, when the resin having a positive intrinsic birefringence value is used as a material of the substrate, orientation of molecules of the polymers contained in the substrate in the stretching direction usually causes expression of the slow axis parallel to the stretching direction. Therefore, the orientation regulating force, which causes the inverse wavelength polymerizable liquid crystal compound to be oriented in the direction parallel to the slow axis of the substrate, is imparted to the surface of the substrate. Thus, the stretching direction of the substrate may be set depending on the desired orientation direction in which the inverse wavelength polymerizable liquid crystal compound is intended to be oriented. The stretching may be performed only in

one direction, and may also be performed in two or more directions.

The stretching ratio may be set such that the birefringence Δn of the stretched substrate falls within a desired range. The birefringence Δn of the stretched substrate is preferably 0.000050 or more, and more preferably 0.000070 or more, and is preferably 0.007500 or less, and more preferably 0.007000 or less. When the birefringence Δn of the stretched substrate is equal to or more than the lower limit value of the aforementioned range, a favorable orientation regulating force can be imparted to the surface of the substrate. When the birefringence Δn is equal to or less than the upper limit value of the aforementioned range, the retardation of the substrate can be reduced, so that the substrate can be used for various uses in combination with the optically anisotropic layer, without peeling the substrate from the optically anisotropic layer.

The stretching may be performed using a stretching machine such as a tenter stretching machine.

The coating surface of the substrate is preferably an untreated surface which is not subjected to a surface treatment. Examples of the surface treatment may include a rubbing treatment, an oriented film forming treatment, an energy ray irradiation treatment, and a chemical treatment. Examples of the energy ray irradiation treatment may include a corona discharging treatment, a plasma treatment, an electron beam irradiation treatment, and a UV irradiation treatment. Examples of the chemical treatment may include a saponification treatment and an oxidizing agent solution treatment. With the use of the substrate having an untreated surface as the coating surface, the labor and costs which are required for the production of the substrate can be reduced. Consequently, production efficiency of the multilayer film can be enhanced.

The coating surface of the substrate is preferably a flat surface without concave and convex portions, from the viewpoint of achieving a favorable surface state of the optically anisotropic layer.

The substrate may have a retardation depending on an intended use. For example, when the multilayer film is used as an optical film such as a retardation film and an optical compensation film, the substrate preferably has a retardation. The retardation Re of the substrate may be set depending on the use of the multilayer film, and is preferably 30 nm or more, and more preferably 50 nm or more, and is preferably 500 nm or less, and more preferably 300 nm or less.

The substrate preferably has excellent transparency. Specifically, the total light transmittance of the substrate is preferably 80% or more, more preferably 85% or more, and particularly preferably 88% or more. The haze of the substrate is preferably 5% or less, more preferably 3% or less, and particularly preferably 1% or less. The total light transmittance of the substrate may be measured in the range of a wavelength of 400 nm to 700 nm, using a UV-visible spectrometer. The haze of the substrate may be measured by cutting the substrate at a randomly selected site to obtain a 50 mm × 50 mm square thin film sample, and thereafter measuring the haze of the thin film sample using a haze meter.

Although a sheet piece film may be used as the substrate, a long-length film is preferably used such that the production by a roll-to-roll process can be therewith performed for improving production efficiency. Here, "long-length" refers to a shape having a length of 5 times or more, and preferably 10 times or more, the width. Specifically, the long-length shape has a length with which a film can be wound up to a roll for storage or transportation.

Furthermore, when the long-length substrate is used, the slow axis of the substrate may be parallel to the lengthwise direction of the substrate, perpendicular to the lengthwise direction of the substrate, and in the oblique direction which is neither parallel nor perpendicular to the lengthwise direction of the substrate. The specific slow axis direction of the substrate may be set depending on the direction of a slow axis which is intended to be expressed in the optically anisotropic layer. Examples of the angle formed between the slow axis of the substrate and the lengthwise direction of the substrate may include 15° ± 5°, 22.5° ± 5°, 45° ± 5°, 67.5 ± 5°, and 75° ± 5°.

The thickness of the substrate is not particularly limited, and is preferably 1 μm or more, more preferably 5 μm or more, and particularly preferably 30 μm or more, and is preferably 1000 μm or less, more preferably 300 μm or less, and particularly preferably 100 μm or less, from the viewpoint of productivity improvement and reduction in thickness and weight.

The method for producing the substrate is not limited. For example, the substrate including a thermoplastic resin like the resin containing an alicyclic structure-containing polymer may be produced by a production method which includes: a step of molding a resin into a film shape to obtain a pre-stretch substrate; and a step of stretching the pre-stretch substrate so that an orientation regulating force is expressed, thereby to obtain a desired substrate.

Examples of the method for molding a resin may include a melt molding method and a solution casting method. Examples of the melt molding method may include a melt extrusion method of molding a resin through melt extrusion, as well as a press molding method, an inflation molding method, an injection molding method, a blow molding method, and a stretch molding method. Among these methods, a melt extrusion method, an inflation molding method, and a press molding method are preferable, from the viewpoint of obtaining a pre-stretch substrate which is excellent in mechanical strength and surface accuracy. Among these, a melt extrusion method is particularly preferable, because the amount of a remaining solvent can be reduced, and the production can be efficiently and simply performed.

Usually, in the melt extrusion method, a resin is melted, and the melted resin is extruded through a die to be molded into a film shape. At this time, the melting temperature of the resin in an extruder equipped with a die is preferably Tg + 80°C or higher, and more preferably Tg + 100°C or higher, and is preferably Tg + 180°C or lower, and more

preferably Tg + 150°C or lower. Here, Tg represents the glass transition temperature of a resin. When the melting temperature of a resin in an extruder is equal to or more than the lower limit value of the aforementioned range, fluidity of the resin can be sufficiently enhanced. When the melting temperature is equal to or less than the upper limit value, deterioration of the resin can be suppressed.

By molding a resin into a film shape as described above, a pre-stretch substrate formed of the resin can be obtained. The pre-stretch substrate is usually obtained as a long-length film. By subjecting this pre-stretch substrate to a stretching treatment, a desired substrate to which an orientation regulating force has been imparted can be produced.

The stretching to be performed may be a uniaxial stretching treatment in which a stretching treatment is performed only in one direction, and may also be a biaxial stretching treatment in which a stretching treatment is performed in different two directions. The biaxial stretching treatment to be performed may be a simultaneous biaxial stretching treatment in which a stretching treatment is simultaneously performed in two directions, and may also be a sequential biaxial stretching treatment in which a stretching treatment in a certain direction is followed by a stretching treatment in another direction. Furthermore, the stretching may be performed by a longitudinal stretching treatment in which a stretching treatment is performed in the lengthwise direction of the pre-stretch substrate, a lateral stretching treatment in which a stretching treatment is performed in the widthwise direction of the pre-stretch substrate, an oblique stretching treatment in which a stretching treatment is performed in an oblique direction which is neither parallel nor perpendicular to the lengthwise direction of the pre-stretch substrate, and combinations thereof. The oblique stretching treatment is particularly preferable. Examples of the system for a stretching treatment may include a roll system, a float system, and a tenter system.

The stretching temperature and the stretching ratio may be optionally set within the range in which the substrate with the coating surface having a desired surface free energy and a desired orientation regulating force can be obtained. Specifically, the stretching temperature is preferably Tg - 30°C or higher, and more preferably Tg - 10°C or higher, and is preferably Tg + 10°C or lower, and more preferably Tg or lower. The stretching ratio is preferably 1.1 times or more, more preferably 1.2 times or more, and particularly preferably 1.5 times or more, and is preferably 30 times or less, more preferably 10 times or less, and particularly preferably 5 times or less.

[3. Preparation of Liquid Crystal Composition]

The liquid crystal composition has a specific surface tension, and includes an inverse wavelength polymerizable liquid crystal compound. This liquid crystal composition is usually fluid under the environment (for example, 25°C in temperature and 60% in humidity) in which it is applied onto the coating surface of the substrate.

<3.1. Surface Tension of Liquid Crystal Composition>

The surface tension of the liquid crystal composition is usually 26 mN/m or more, preferably 28 mN/m or more, and more preferably 30 mN/m or more, and is preferably 45 mN/m or less, more preferably 40 mN/m or less, and particularly preferably 35 mN/m or less. The liquid crystal composition having a surface tension within such a range and containing an inverse wavelength polymerizable liquid crystal compound can be applied, with favorable coating properties, onto the coating surface of the substrate having a specific low surface free energy as previously described.

Examples of the method for confining the surface tension of the liquid crystal composition to the aforementioned range may include: appropriately selecting the type of a solvent and, when a plurality of solvents is used, the ratios of the solvents in the liquid crystal composition; and appropriately selecting the types, combination, and amounts of surfactants.

The surface tension of the liquid crystal composition may be measured under an environment of 25°C in temperature and 60% in humidity, by the Wilhelmy method.

<3.2. Inverse wavelength Polymerizable Liquid Crystal Compound>

The inverse wavelength polymerizable liquid crystal compound contained in the liquid crystal composition is a liquid compound having polymerization properties. Since this inverse wavelength polymerizable liquid crystal compound is a liquid crystal compound having liquid crystallizability, the inverse wavelength polymerizable liquid crystal compound can have a liquid crystal phase when it is oriented. Since the inverse wavelength polymerizable liquid crystal compound is a compound having polymerization properties, the inverse wavelength polymerizable liquid crystal compound can be polymerized while having a liquid crystal phase as previously described, and become a polymer while maintaining the molecular orientation in the liquid crystalline phase.

Furthermore, the inverse wavelength polymerizable liquid crystal compound is a compound which can express an inverse wavelength dispersion birefringence. Here, the compound which can express an inverse wavelength dispersion birefringence refers to a compound in which, when the compound becomes a polymer as previously described, the

resulting polymer expresses an inverse wavelength dispersion birefringence.

The inverse wavelength dispersion birefringence refers to a birefringence in which the birefringence Δn(450) at a wavelength of 450 nm and the birefringence Δn(650) at a wavelength of 650 nm satisfy the following formula (D1). The inverse wavelength polymerizable liquid crystal compound which can express such an inverse wavelength dispersion birefringence can usually express a larger birefringence as the measurement wavelength is longer. Therefore, the birefringence of the polymer obtained by polymerizing the inverse wavelength polymerizable liquid crystal compound as previously described usually satisfies the following formula (D2). In the following formula (D2), Δn(550) represents a birefringence at a measurement wavelength of 550 nm.

$$\Delta n(450) < \Delta n(650) \quad (D1)$$

$$\Delta n(450) < \Delta n(550) < \Delta n(650) \quad (D2)$$

An example of the inverse wavelength polymerizable liquid crystal compound to be used may be a compound which contains a main-chain mesogene and a side-chain mesogene linked to the main-chain mesogene in the molecule of the inverse wavelength polymerizable liquid crystal compound. In the inverse wavelength polymerizable liquid crystal compound which contains a main-chain mesogene and a side-chain mesogene, the side-chain mesogene may be oriented in a direction different from the main-chain mesogene when the inverse wavelength polymerizable liquid crystal compound is oriented. Thus, in the polymer obtained by polymerizing the inverse wavelength polymerizable liquid crystal compound while maintaining such an orientation, a main-chain mesogene and a side-chain mesogene may be oriented in different directions. By this orientation, the previously-described polymer can express an inverse wavelength dispersion birefringence.

The molecular weight of the inverse wavelength polymerizable liquid crystal compound is preferably 300 or more, more preferably 700 or more, and is particularly preferably 1000 or more, and preferably 2000 or less, more preferably 1700 or less, and particularly preferably 1500 or less. The fact that the inverse wavelength polymerizable liquid crystal compound has the aforementioned molecular weight represents that the inverse wavelength polymerizable liquid crystal compound is a monomer. With the use of the inverse wavelength polymerizable liquid crystal compound as a monomer instead of as a polymer, the liquid crystal composition can have particularly favorable coating properties.

As the inverse wavelength polymerizable liquid crystal compound, one type thereof may be solely used, and two or more types thereof may also be used in combination at any ratio.

Specific examples of preferable inverse wavelength polymerizable liquid crystal compounds may include a compound represented by the following formula (I). In the following description, the compound represented by the formula (I) may be appropriately referred to as "compound (I)".

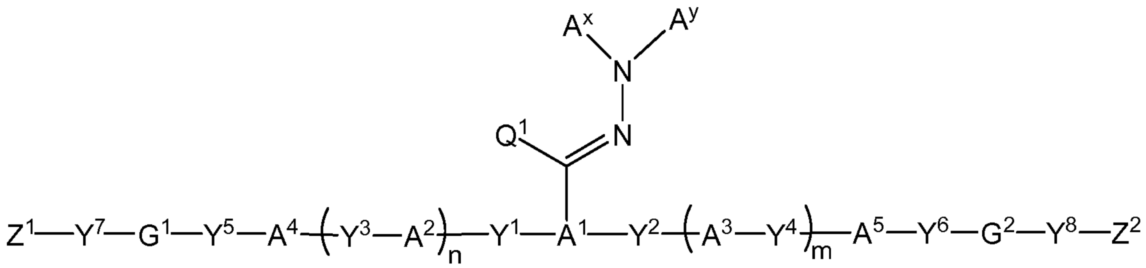

(I)

As shown in the following formula, the compound (I) usually includes two mesogen skeletons including a main chain mesogen 1a composed of a group $-Y^5-A^4-(Y^3-A^2)_n-Y^1-A^1-Y^2-(A^3-Y^4)_m-A^5-Y^6-$ and a side chain mesogen 1b composed of a group $>A^1-C(Q^1)=N-N(A^x)A^y$. The main chain mesogen 1a and the side chain mesogen 1b cross each other. The aforementioned main chain mesogen 1a and side chain mesogen 1b may be collectively regarded as one mesogen, but in the present invention, are described as two separate mesogens.

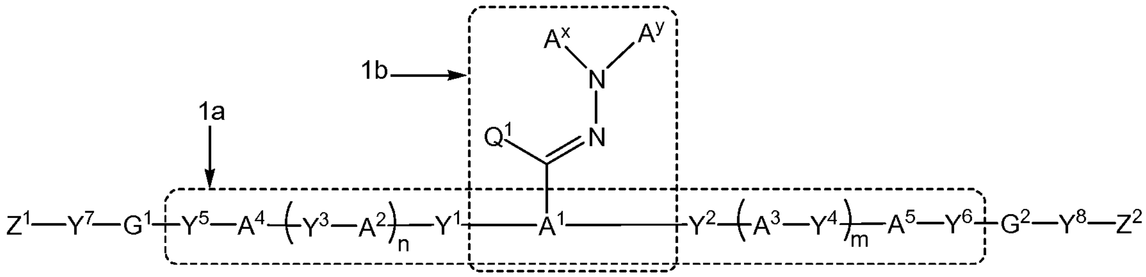

The refractive index of the main chain mesogen 1a in the long-axis direction is denoted by n1, and the refractive index of the side chain mesogen 1b in the long-axis direction is denoted by n2. In this case, the absolute value and wavelength dispersion of the refractive index n1 usually depend on the molecular structure of the main chain mesogen 1a. The absolute value and wavelength dispersion of the refractive index n2 usually depend on the molecular structure of the side chain mesogen 1b. Herein, the polymerizable liquid crystal compound with inverse wavelength dispersion is usually subjected to rotational motion around the long-axis direction of the main chain mesogen 1a as a rotational axis in the liquid crystal phase. Therefore, the refractive indices n1 and n2 herein represent the refractive index of a rotating body.

Due to the molecular structures of the main chain mesogen 1a and the side chain mesogen 1b, the absolute value of the refractive index n1 is larger than the absolute value of the refractive index n2. Further, the refractive indices n1 and n2 usually exhibit forward wavelength dispersion. A refractive index with forward wavelength dispersion herein means a refractive index of which the absolute value becomes smaller as the measurement wavelength is longer. The refractive index n1 of the main chain mesogen 1a exhibits small forward wavelength dispersion. Therefore, the refractive index measured at a long wavelength is not at a level that is extremely smaller than the refractive index measured at a short wavelength.

In contrast, the refractive index n2 of the side chain mesogen 1b exhibits large forward wavelength dispersion. Therefore, the refractive index measured at a long wavelength is extremely smaller than the refractive index measured at a short wavelength. Consequently, the difference $\Delta n$ between the refractive index n1 and the refractive index n2 is small at the short measurement wavelength, and the difference $\Delta n$ between the refractive index n1 and the refractive index n2 is large at the long measurement wavelength. Accordingly, the ratio of birefringence with inverse wavelength dispersion can be expressed on the basis of the main chain mesogen 1a and the side chain mesogen 1b.

In the formula (I) mentioned above, $Y^1$ to $Y^8$ are each independently a chemical single bond, -O-, -S-, -O-C(=O)-, -C(=O)-O-, -O-C(=O)-O-, $-NR^1-C(=O)-$, $-C(=O)-NR^1-$,$-O-C(=O)-NR^1-$, $-NR^1-C(=O)-O-$, $-NR^1-C(=O)-NR^1-$, $-O-NR^1-$, or$-NR^1-O-$.

Herein, $R^1$ is a hydrogen atom or an alkyl group of 1 to 6 carbon atoms.

Examples of the alkyl group of 1 to 6 carbon atoms of $R^1$ may include a methyl group, an ethyl group, a n-propyl group, an isopropyl group, a n-butyl group, a sec-butyl group, a t-butyl group, a n-pentyl group, and a n-hexyl group.

It is preferable that $R^1$ is a hydrogen atom or an alkyl group of 1 to 4 carbon atoms.

In the compound (I), it is preferable that $Y^1$ to $Y^8$ are each independently a chemical single bond, -O-, -O-C(=O)-, -C(=O)-O-, or -O-C(=O)-O-.

In the formula (I) mentioned above, $G^1$ and $G^2$ are each independently a divalent aliphatic group of 1 to 20 carbon atoms optionally having a substituent.

Examples of the divalent aliphatic group of 1 to 20 carbon atoms may include a divalent aliphatic group having a linear structure, such as an alkylene group of 1 to 20 carbon atoms and an alkenylene group of 2 to 20 carbon atoms; and a divalent aliphatic group, such as a cycloalkanediyl group of 3 to 20 carbon atoms, a cycloalkenediyl group of 4 to 20 carbon atoms, and a divalent alicyclic fused ring group of 10 to 30 carbon atoms.

Examples of the substituent in the divalent aliphatic group of $G^1$ and $G^2$ may include a halogen atom, such as a fluorine atom, a chlorine atom, a bromine atom, and an iodine atom; and an alkoxy group of 1 to 6 carbon atoms, such as a methoxy group, an ethoxy group, a n-propoxy group, an isopropoxy group, a n-butoxy group, a sec-butoxy group, a t-butoxy group, a n-pentyloxy group, and a n-hexyloxy group. Among these, a fluorine atom, a methoxy group, and an ethoxy group are preferable.

The aforementioned aliphatic groups may have one or more per one aliphatic group of -O-, -S-, -O-C(=O)-,-C(=O)-O-, -O-C(=O)-O-, $-NR^2-C(=O)-$, $-C(=O)-NR^2-$, $-NR^2-$, or-C(=O)- inserted therein. However, cases where two or more -O- or -S- are adjacently inserted are excluded. Herein, $R^2$ is a hydrogen atom or an alkyl group of 1 to 6 carbon atoms. It is preferable that $R^2$ is a hydrogen atom or a methyl group.

It is preferable that the group inserted into the aliphatic groups is -O-, -O-C(=O)-, -C(=O)-O-, or -C(=O)-.

Specific examples of the aliphatic groups into which the group is inserted may include $-CH_2-CH_2-O-CH_2-CH_2-$, $-CH_2-CH_2-S-CH_2-CH_2-$, $-CH_2-CH_2-O-C(=O)-CH_2-CH_2-$, $-CH_2-CH_2-C(=O)-O-CH_2-CH_2-$, $-CH_2-CH_2-C(=O)-O-CH_2-$,

$-CH_2-O-C(=O)-O-CH_2-CH_2-$, $-CH_2-CH_2-NR^2-C(=O)-CH_2-CH_2-$, $-CH_2-CH_2-C(=O)-NR^2-CH_2-$,$-CH_2-NR^2-CH_2-CH_2-$, and $-CH_2-C(=O)-CH_2-$.

Among these, from the viewpoint of more favorably expressing the desired effect of the present invention, $G^1$ and $G^2$ are each independently preferably a divalent aliphatic group having a linear structure, such as an alkylene group of 1 to 20 carbon atoms and an alkenylene group of 2 to 20 carbon atoms, more preferably an alkylene group of 1 to 12 carbon atoms, such as a methylene group, an ethylene group, a trimethylene group, a propylene group, a tetramethylene group, a pentamethylene group, a hexamethylene group, an octamethylene group, and a decamethylene group $[-(CH_2)_{10}-]$, and particularly preferably a tetramethylene group $[-(CH_2)_4-]$, a hexamethylene group $[-(CH_2)_6-]$, an octamethylene group $[-(CH_2)_8-]$, or a decamethylene group $[-(CH_2)_{10}-]$.

In the formula (I) mentioned above, $Z^1$ and $Z^2$ are each independently an alkenyl group of 2 to 10 carbon atoms that may be substituted by a halogen atom.

It is preferable that the number of carbon atoms in the alkenyl group is 2 to 6. Examples of the halogen atom that is a substituent in the alkenyl group of $Z^1$ and $Z^2$ may include a fluorine atom, a chlorine atom, and a bromine atom. A chlorine atom is preferable.

Specific examples of the alkenyl group of 2 to 10 carbon atoms of $Z^1$ and $Z^2$ may include $CH_2=CH-$, $CH_2=C(CH_3)-$, $CH_2=CH-CH_2-$, $CH_3-CH=CH-$, $CH_2=CH-CH_2-CH_2-$, $CH_2=C(CH_3)-CH_2-CH_2-$, $(CH_3)_2C=CH-CH_2-$, $(CH_3)_2C=CH-CH_2-CH_2-$, $CH_2=C(Cl)-$, $CH_2=C(CH_3)-CH_2-$, and $CH_3-CH=CH-CH_2-$.

Among these, from the viewpoint of favorably expressing the desired effect of the present invention, $Z^1$ and $Z^2$ are each independently preferably $CH_2=CH-$, $CH_2=C(CH_3)-$, $CH_2=C(Cl)-$, $CH_2=CH-CH_2-$, $CH_2=C(CH_3)-CH_2-$, or $CH_2=C(CH_3)-CH_2-CH_2-$, more preferably $CH_2=CH-$, $CH_2=C(CH_3)-$ or $CH_2=C(Cl)-$, and particularly preferably $CH_2=CH-$.

In the formula (I) mentioned above, $A^x$ is an organic group of 2 to 30 carbon atoms having at least one aromatic ring selected from the group consisting of an aromatic hydrocarbon ring and an aromatic heterocyclic ring. The "aromatic ring" means a cyclic structure having aromaticity in the broad sense based on Huckel rule, that is, a cyclic conjugated structure having (4n+2) $\pi$ electrons, and a cyclic structure that exhibits aromaticity by involving a lone pair of electrons of a heteroatom, such as sulfur, oxygen, and nitrogen, in a $\pi$ electron system, typified by thiophene, furan, and benzothiazole.

The organic group of 2 to 30 carbon atoms having at least one aromatic ring selected from the group consisting of an aromatic hydrocarbon ring and an aromatic heterocyclic ring, of $A^x$, may have a plurality of aromatic rings, or have both an aromatic hydrocarbon ring and an aromatic heterocyclic ring.

Examples of the aromatic hydrocarbon ring may include a benzene ring, a naphthalene ring, and an anthracene ring. Examples of the aromatic heterocyclic ring may include a monocyclic aromatic heterocyclic ring, such as a pyrrole ring, a furan ring, a thiophene ring, a pyridine ring, a pyridazine ring, a pyrimidine ring, a pyrazine ring, a pyrazole ring, an imidazole ring, an oxazole ring, and a thiazole ring; and a fused aromatic heterocyclic ring, such as a benzothiazole ring, a benzoxazole ring, a quinoline ring, a phthalazine ring, a benzimidazole ring, a benzopyrazole ring, a benzofuran ring, a benzothiophene ring, a thiazolopyridine ring, an oxazolopyridine ring, a thiazolopyrazine ring, an oxazolopyrazine ring, a thiazolopyridazine ring, an oxazolopyridazine ring, a thiazolopyrimidine ring, and an oxazolopyrimidine ring.

The aromatic ring of $A^x$ may have a substituent. Examples of the substituent may include a halogen atom, such as a fluorine atom and a chlorine atom; a cyano group; an alkyl group of 1 to 6 carbon atoms, such as a methyl group, an ethyl group, and a propyl group; an alkenyl group of 2 to 6 carbon atoms, such as a vinyl group and an allyl group; a halogenated alkyl group of 1 to 6 carbon atoms, such as a trifluoromethyl group; a substituted amino group, such as a dimethylamino group; an alkoxy group of 1 to 6 carbon atoms, such as a methoxy group, an ethoxy group, and an isopropoxy group; a nitro group; an aryl group, such as a phenyl group and a naphthyl group; $-C(=O)-R^5$; $-C(=O)-OR^5$; and $-SO_2R^6$. Herein, $R^5$ is an alkyl group of 1 to 20 carbon atoms, an alkenyl group of 2 to 20 carbon atoms, or a cycloalkyl group of 3 to 12 carbon atoms. $R^6$ is an alkyl group of 1 to 20 carbon atoms, an alkenyl group of 2 to 20 carbon atoms, a phenyl group, or a 4-methylphenyl group, which are the same as those for $R^4$ which will be described later.

The aromatic ring of $A^x$ may have a plurality of substituents that may be the same or different, and two adjacent substituents may be bonded together to form a ring. The formed ring may be a monocycle or a fused polycycle, and may be an unsaturated ring or a saturated ring.

The "number of carbon atoms" in the organic group of 2 to 30 carbon atoms of $A^x$ means the total number of carbon atoms in the entire organic group which excludes carbon atoms in the substituents (the same applies to $A^y$ which will be described later).

Examples of the organic group of 2 to 30 carbon atoms having at least one aromatic ring selected from the group consisting of an aromatic hydrocarbon ring and an aromatic heterocyclic ring, of $A^x$, may include an aromatic hydrocarbon ring group; an aromatic heterocyclic group; an alkyl group of 3 to 30 carbon atoms having at least one aromatic ring selected from the group consisting of an aromatic hydrocarbon ring and an aromatic heterocyclic ring; an alkenyl group of 4 to 30 carbon atoms having at least one aromatic ring selected from the group consisting of an aromatic hydrocarbon ring and an aromatic heterocyclic ring; and an alkynyl group of 4 to 30 carbon atoms having at least one aromatic ring selected from the group consisting of an aromatic hydrocarbon ring and an aromatic heterocyclic ring.

Preferable specific examples of $A^x$ are as follows. However, $A^x$ is not limited to the following examples. In the following formulae, "-" represents an atomic bonding at any position of the ring (the same applies to the following).

(1) An aromatic hydrocarbon ring group

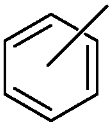
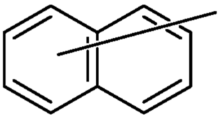
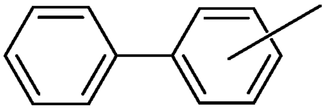
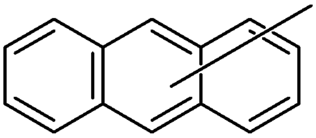
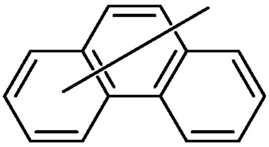
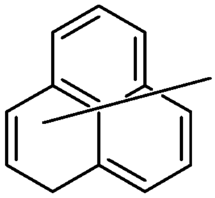
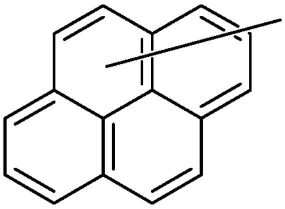
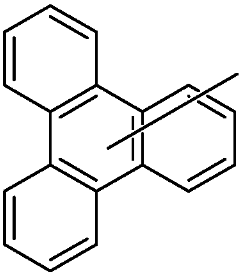
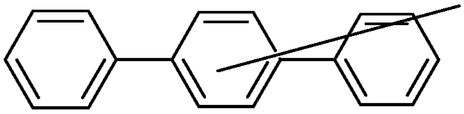
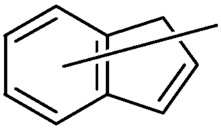
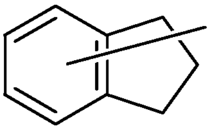
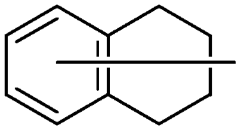
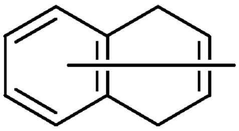
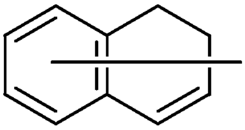
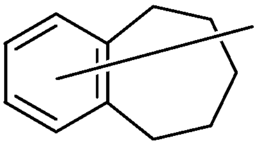
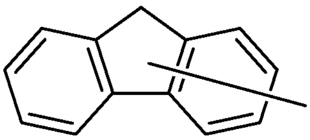
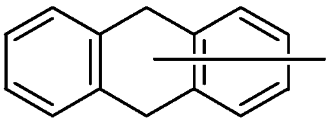
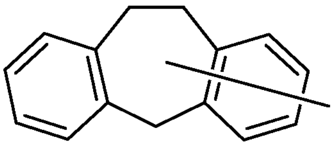
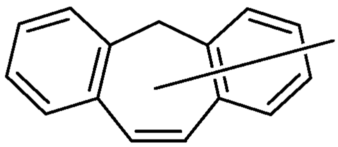

(2) An aromatic heterocyclic group

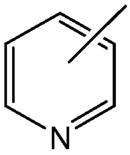 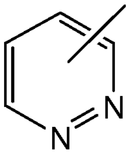 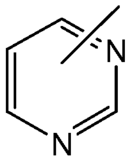 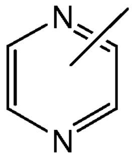

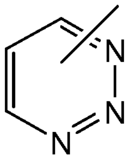 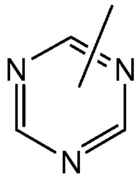 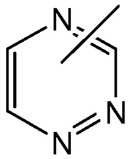

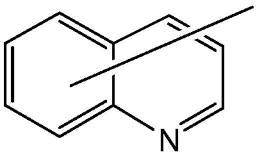 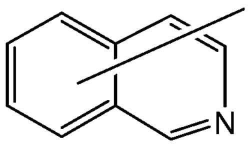 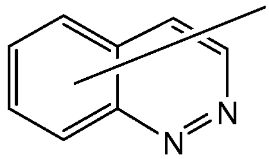

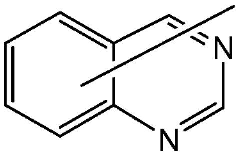 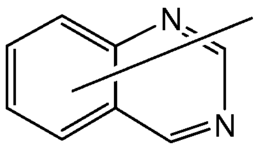 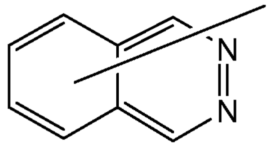

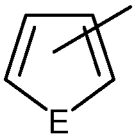 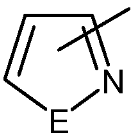 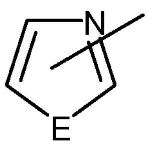

In the aforementioned formulae, E is $NR^{6a}$, an oxygen atom, or a sulfur atom. Herein, $R^{6a}$ is a hydrogen atom; or an alkyl group of 1 to 6 carbon atoms, such as a methyl group, an ethyl group, and a propyl group.

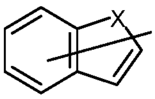 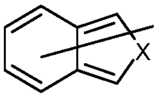 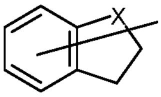 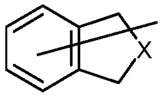 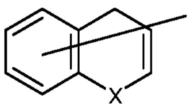 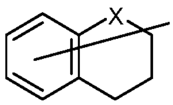

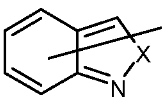 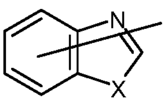 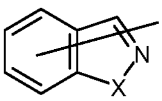 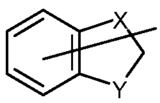 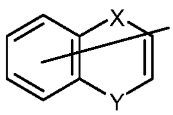

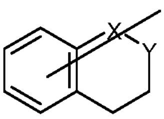 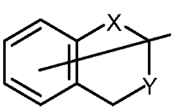 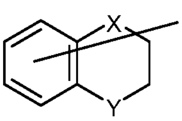 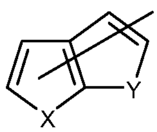 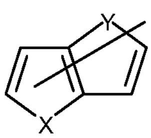

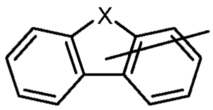
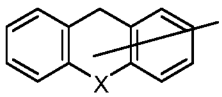
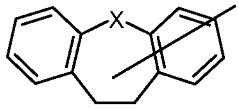
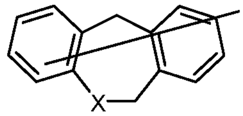

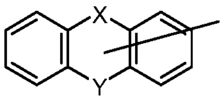
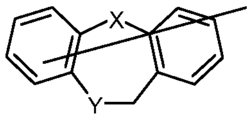
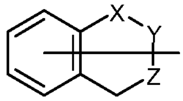
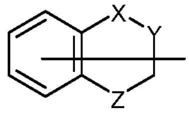

In the aforementioned formulae, X, Y, and Z are each independently $NR^7$, an oxygen atom, a sulfur atom, -SO-, or $-SO_2-$ (provided that cases where an oxygen atom, a sulfur atom, -SO-, and $-SO_2-$ are each adjacent are excluded). $R^7$ is a hydrogen atom, or an alkyl group of 1 to 6 carbon atoms, such as a methyl group, an ethyl group, and a propyl group, which are the same as those for $R^{6a}$ described above.

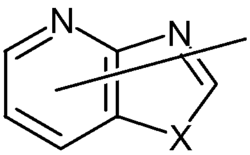
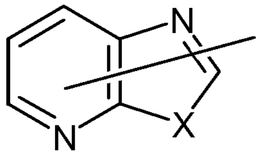
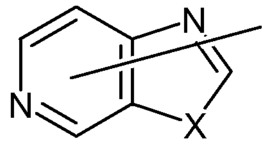

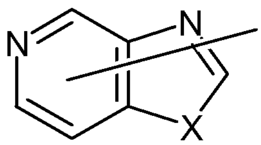
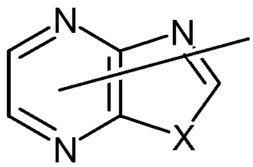
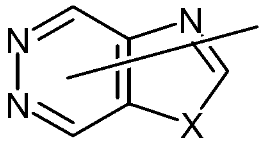

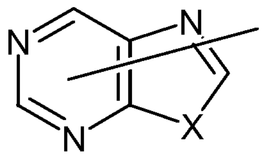
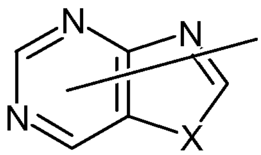

(In the aforementioned formulae, X has the same meanings as described above.)

(3) An alkyl group having at least one aromatic ring selected from the group consisting of an aromatic hydrocarbon ring and an aromatic heterocyclic ring

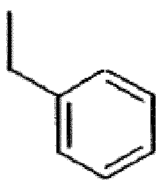
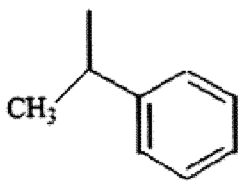
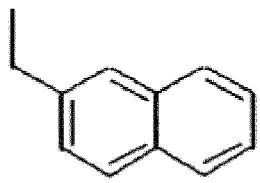

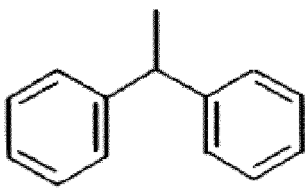
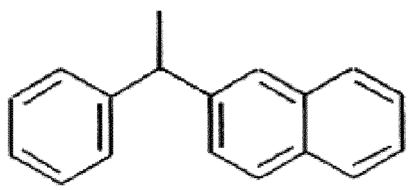

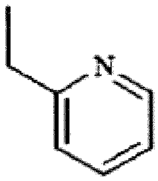
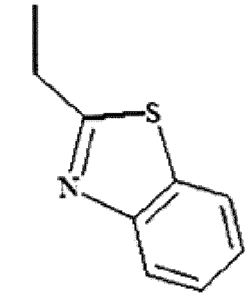
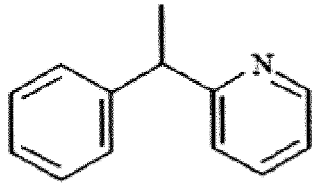

(4) An alkenyl group having at least one aromatic ring selected from the group consisting of an aromatic hydrocarbon ring and an aromatic heterocyclic ring

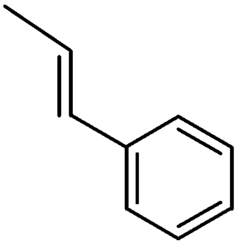
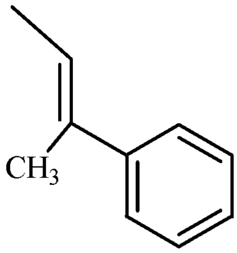
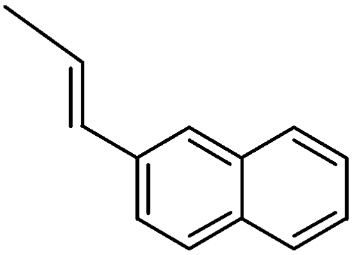
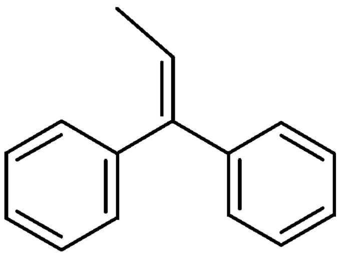
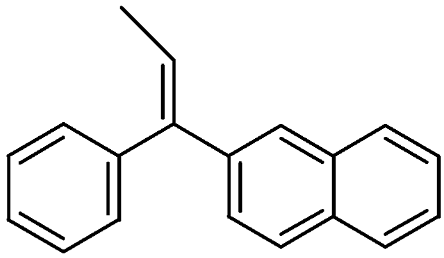

(5) An alkynyl group having at least one aromatic ring selected from the group consisting of an aromatic hydrocarbon ring and an aromatic heterocyclic ring

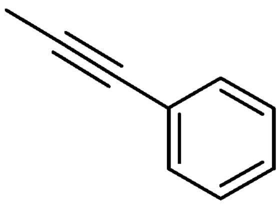
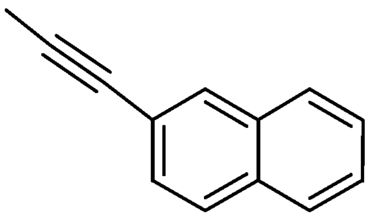

Of $A^x$ described above, an aromatic hydrocarbon ring group of 6 to 30 carbon atoms and an aromatic heterocyclic group of 4 to 30 carbon atoms are preferable, and any of the groups shown below are more preferable.

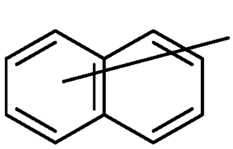
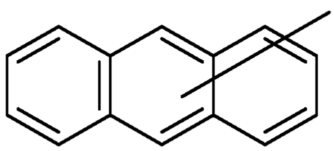

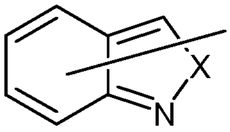
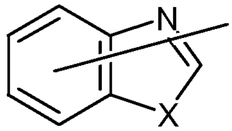
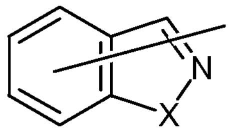
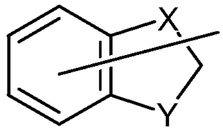

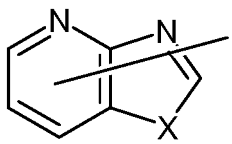
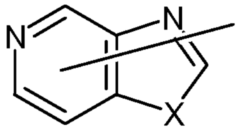
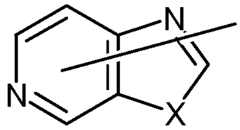
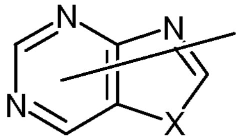

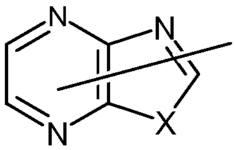
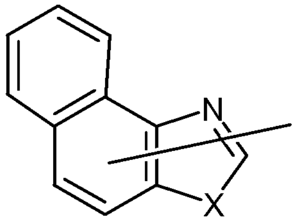
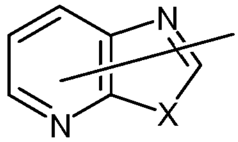

It is further preferable that $A^x$ is any of the following groups.

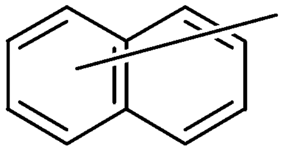
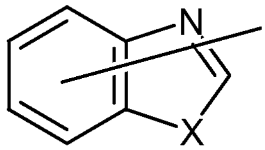

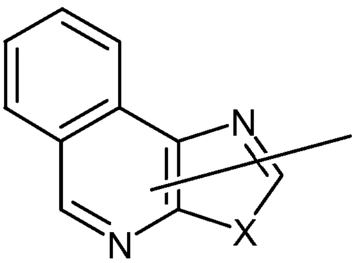
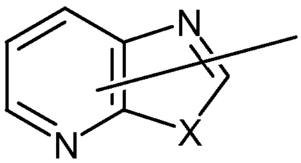
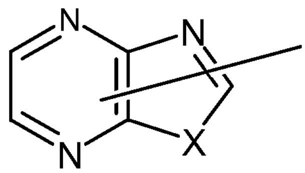

The ring that $A^x$ has may have a substituent. Examples of such a substituent may include a halogen atom, such as a fluorine atom and a chlorine atom; a cyano group; an alkyl group of 1 to 6 carbon atoms, such as a methyl group, an ethyl group, and a propyl group; an alkenyl group of 2 to 6 carbon atoms, such as a vinyl group and an allyl group; a halogenated alkyl group of 1 to 6 carbon atoms, such as a trifluoromethyl group; a substituted amino group, such as a dimethylamino group; an alkoxy group of 1 to 6 carbon atoms, such as a methoxy group, an ethoxy group, and an isopropoxy group; a nitro group; an aryl group, such as a phenyl group and a naphthyl group; $-C(=O)-R^8$; $-C(=O)-OR^8$; and $-SO_2R^6$. Herein, $R^8$ is an alkyl group of 1 to 6 carbon atoms, such as a methyl group and an ethyl group; or an aryl group of 6 to 14 carbon atoms, such as a phenyl group. In particular, it is preferable that the substituent is a halogen atom, a cyano group, an alkyl group of 1 to 6 carbon atoms, or an alkoxy group of 1 to 6 carbon atoms.

The ring that $A^x$ has may have a plurality of substituents that may be the same or different, and two adjacent substituents may be bonded together to form a ring. The formed ring may be a monocycle or a fused polycycle.

The "number of carbon atoms" in the organic group of 2 to 30 carbon atoms of $A^x$ means the total number of carbon atoms in the entire organic group which excludes carbon atoms in the substituents (the same applies to $A^y$ which will be described later).

In the aforementioned formula (I), $A^y$ is a hydrogen atom, an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, an alkynyl group of 2 to 20 carbon atoms optionally having a

substituent, -C(=O)-$R^3$, -$SO_2$-$R^4$, - C(=S)NH-$R^9$, or an organic group of 2 to 30 carbon atoms having at least one aromatic ring selected from the group consisting of an aromatic hydrocarbon ring and an aromatic heterocyclic ring. Herein, $R^3$ is an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, or an aromatic hydrocarbon ring group of 5 to 12 carbon atoms. $R^4$ is an alkyl group of 1 to 20 carbon atoms, an alkenyl group of 2 to 20 carbon atoms, a phenyl group, or a 4-methylphenyl group. $R^9$ is an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, or an aromatic group of 5 to 20 carbon atoms optionally having a substituent.

Examples of the alkyl group of 1 to 20 carbon atoms in the alkyl group of 1 to 20 carbon atoms optionally having a substituent, of $A^y$, may include a methyl group, an ethyl group, a n-propyl group, an isopropyl group, a n-butyl group, an isobutyl group, a 1-methylpentyl group, a 1-ethylpentyl group, a sec-butyl group, a t-butyl group, a n-pentyl group, an isopentyl group, a neopentyl group, a n-hexyl group, an isohexyl group, a n-heptyl group, a n-octyl group, a n-nonyl group, a n-decyl group, a n-undecyl group, a n-dodecyl group, a n-tridecyl group, a n-tetradecyl group, a n-pentadecyl group, a n-hexadecyl group, a n-heptadecyl group, a n-octadecyl group, a n-nonadecyl group, and a n-icosyl group. The number of carbon atoms in the alkyl group of 1 to 20 carbon atoms optionally having a substituent is preferably 1 to 12, and further preferably 4 to 10.

Examples of the alkenyl group of 2 to 20 carbon atoms in the alkenyl group of 2 to 20 carbon atoms optionally having a substituent, of $A^y$, may include a vinyl group, a propenyl group, an isopropenyl group, a butenyl group, an isobutenyl group, a pentenyl group, a hexenyl group, a heptenyl group, an octenyl group, a decenyl group, an undecenyl group, a dodecenyl group, a tridecenyl group, a tetradecenyl group, a pentadecenyl group, a hexadecenyl group, a heptadecenyl group, an octadecenyl group, a nonadecenyl group, and an icocenyl group. The number of carbon atoms in the alkenyl group of 2 to 20 carbon atoms optionally having a substituent is preferably 2 to 12.

Examples of the cycloalkyl group of 3 to 12 carbon atoms in the cycloalkyl group of 3 to 12 carbon atoms optionally having a substituent, of $A^y$, may include a cyclopropyl group, a cyclobutyl group, a cyclopentyl group, a cyclohexyl group, and a cyclooctyl group.

Examples of the alkynyl group of 2 to 20 carbon atoms in the alkynyl group of 2 to 20 carbon atoms optionally having a substituent, of $A^y$, may include an ethynyl group, a propynyl group, a 2-propynyl group (propargyl group), a butynyl group, a 2-butynyl group, a 3-butynyl group, a pentynyl group, a 2-pentynyl group, a hexynyl group, a 5-hexynyl group, a heptynyl group, an octynyl group, a 2-octynyl group, a nonanyl group, a decanyl group, and a 7-decanyl group.

Examples of the substituents in the alkyl group of 1 to 20 carbon atoms optionally having a substituent and the alkenyl group of 2 to 20 carbon atoms optionally having a substituent, of $A^y$, may include a halogen atom, such as a fluorine atom and a chlorine atom; a cyano group; a substituted amino group, such as a dimethylamino group; an alkoxy group of 1 to 20 carbon atoms, such as a methoxy group, an ethoxy group, an isopropyl group, and a butoxy group; an alkoxy group of 1 to 12 carbon atoms that is substituted by an alkoxy group of 1 to 12 carbon atoms, such as a methoxymethoxy group and a methoxyethoxy group; a nitro group; an aryl group, such as a phenyl group and a naphthyl group; a cycloalkyl group of 3 to 8 carbon atoms, such as a cyclopropyl group, a cyclopentyl group, and a cyclohexyl group; a cycloalkyloxy group of 3 to 8 carbon atoms, such as a cyclopentyloxy group, and a cyclohexyloxy group; a cyclic ether group of 2 to 12 carbon atoms, such as a tetrahydrofuranyl group, a tetrahydropyranyl group, a dioxolanyl group, and a dioxanyl group; an aryloxy group of 6 to 14 carbon atoms, such as a phenoxy group, and a naphthoxy group; a fluoroalkoxy group of 1 to 12 carbon atoms in which at least one is substituted by a fluoro atom, such as a trifluoromethyl group, a pentafluoroethyl group, and -$CH_2CF_3$; a benzofuryl group; a benzopyranyl group; a benzodioxolyl group; a benzodioxanyl group; -C(=O)-$R^{7a}$;-C(=O)-O$R^{7a}$; -$SO_2R^{8a}$; -S$R^{10}$; an alkoxy group of 1 to 12 carbon atoms substituted by -S$R^{10}$; and a hydroxyl group. Herein, $R^{7a}$ and $R^{10}$ are each independently an alkyl group of 1 to 20 carbon atoms, an alkenyl group of 2 to 20 carbon atoms, a cycloalkyl group of 3 to 12 carbon atoms, or an aromatic hydrocarbon ring group of 6 to 12 carbon atoms. $R^{8a}$ is an alkyl group of 1 to 20 carbon atoms, an alkenyl group of 2 to 20 carbon atoms, a phenyl group, or a 4-methylphenyl group, which are the same as those for $R^4$ described above.

Examples of the substituent in the cycloalkyl group of 3 to 12 carbon atoms optionally having a substituent, of $A^y$, may include a halogen atom, such as a fluorine atom and a chlorine atom; a cyano group; a substituted amino group, such as a dimethylamino group; an alkyl group of 1 to 6 carbon atoms, such as a methyl group, an ethyl group, and a propyl group; an alkoxy group of 1 to 6 carbon atoms, such as a methoxy group, an ethoxy group, and an isopropoxy group; a nitro group; an aryl group, such as a phenyl group and a naphthyl group; a cycloalkyl group of 3 to 8 carbon atoms, such as a cyclopropyl group, a cyclopentyl group, and a cyclohexyl group; -C(=O)-$R^{7a}$;-C(=O)-O$R^{7a}$; -$SO_2R^{8a}$; and a hydroxyl group. Herein, $R^{7a}$ and $R^{8a}$ have the same meanings as described above.

Examples of the substituent in the alkynyl group of 2 to 20 carbon atoms optionally having a substituent, of $A^y$, may include subustituents that are the same as the substituents in the alkyl group of 1 to 20 carbon atoms optionally having a substituent and the alkenyl group of 2 to 20 carbon atoms optionally having a substituent.

In the group represented by -C(=O)-$R^3$ of $A^y$, $R^3$ is an alkyl group of 1 to 20 carbon atoms optionally having a

substituent, an alkenyl group of 2 to 20 carbon atoms optionally having a substituent, a cycloalkyl group of 3 to 12 carbon atoms optionally having a substituent, or an aromatic hydrocarbon ring group of 5 to 12 carbon atoms. Specific examples thereof may include those exemplified as the examples of the alkyl group of 1 to 20 carbon atoms optionally having a substituent, the alkenyl group of 2 to 20 carbon atoms optionally having a substituent, and the cycloalkyl group of 3 to 12 carbon atoms optionally having a substituent, of $A^y$; and the aromatic hydrocarbon ring group of 5 to 12 carbon atoms, among the aromatic hydrocarbon ring groups described in $A^x$ described above.

In the group represented by $-SO_2-R^4$ of $A^y$, $R^4$ is an alkyl group of 1 to 20 carbon atoms, an alkenyl group of 2 to 20 carbon atoms, a phenyl group, or a 4-methylphenyl group. Specific examples of the alkyl group of 1 to 20 carbon atoms and the alkenyl group of 2 to 20 carbon atoms, of $R^4$, may include those exemplified as the examples of the alkyl group of 1 to 20 carbon atoms, and the alkenyl group of 2 to 20 carbon atoms, of $A^y$ described above.

In the group represented by $-C(=S)NH-R^9$ of $A^y$, $R^9$ is an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, or an aromatic group of 5 to 20 carbon atoms optionally having a substituent. Specific examples thereof may include those exemplified as the examples of the alkyl group of 1 to 20 carbon atoms optionally having a substituent, the alkenyl group of 2 to 20 carbon atoms optionally having a substituent, and the cycloalkyl group of 3 to 12 carbon atoms optionally having a substituent, of $A^y$ described above; and the aromatic hydrocarbon ring group of 5 to 20 carbon atoms and aromatic heteroaromatic ring group of 5 to 20 carbon atoms, among the aromatic hydrocarbon ring groups and aromatic heteroaromatic ring groups described in $A^x$ described above.

Examples of the organic group of 2 to 30 carbon atoms having at least one aromatic ring selected from the group consisting of an aromatic hydrocarbon ring and an aromatic heterocyclic ring of $A^y$ may include those exemplified as the examples of $A^x$ described above.

Among these, $A^y$ is preferably a hydrogen atom, an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, an alkynyl group of 2 to 20 carbon atoms optionally having a substituent, $-C(=O)-R^3$, $-SO_2-R^4$, or an organic group of 2 to 30 carbon atoms having at least one aromatic ring selected from the group consisting of an aromatic hydrocarbon ring and an aromatic heterocyclic ring, and further preferably a hydrogen atom, an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, an alkynyl group of 2 to 20 carbon atoms optionally having a substituent, an aromatic hydrocarbon ring group of 6 to 12 carbon atoms optionally having a substituent, an aromatic heterocyclic group of 3 to 9 carbon atoms optionally having a substituent, $-C(=O)-R^3$, or a group represented by $-SO_2-R^4$. Herein, $R^3$ and $R^4$ have the same meanings as described above.

It is preferable that substituents in the alkyl group of 1 to 20 carbon atoms optionally having a substituent, the alkenyl group of 2 to 20 carbon atoms optionally having a substituent, and the alkynyl group of 2 to 20 carbon atoms optionally having a substituent, of $A^y$, are a halogen atom, a cyano group, an alkoxy group of 1 to 20 carbon atoms, an alkoxy group of 1 to 12 carbon atoms that is substituted by an alkoxy group of 1 to 12 carbon atoms, a phenyl group, a cyclohexyl group, a cyclic ether group of 2 to 12 carbon atoms, an aryloxy group of 6 to 14 carbon atoms, a hydroxyl group, a benzodioxanyl group, a phenylsulfonyl group, a 4-methylphenylsulfonyl group, a benzoyl group, or $-SR^{10}$. Herein, $R^{10}$ has the same meanings as described above.

It is preferable that substituents in the cycloalkyl group of 3 to 12 carbon atoms optionally having a substituent, the aromatic hydrocarbon ring group of 6 to 12 carbon atoms optionally having a substituent, and the aromatic heterocyclic group of 3 to 9 carbon atoms optionally having a substituent, of $A^y$, are a fluorine atom, an alkyl group of 1 to 6 carbon atoms, an alkoxy group of 1 to 6 carbon atoms, or a cyano group.

$A^x$ and $A^y$ may form a ring together. Examples of the ring may include an unsaturated heterocyclic ring of 4 to 30 carbon atoms optionally having a substituent and an unsaturated carbon ring of 6 to 30 carbon atoms optionally having a substituent.

The aforementioned unsaturated heterocyclic ring of 4 to 30 carbon atoms and the aforementioned unsaturated carbon ring of 6 to 30 carbon atoms are not particularly restricted, and may or may not have aromaticity.

Examples of the ring formed by $A^x$ and $A^y$ together may include rings shown below. The rings shown below are a moiety of:

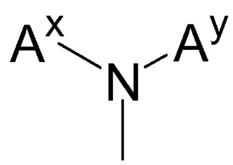

in the formula (I).

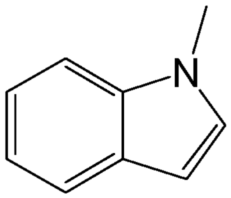
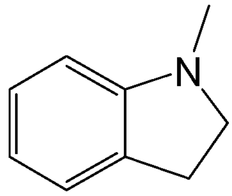
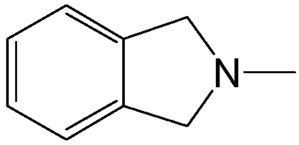
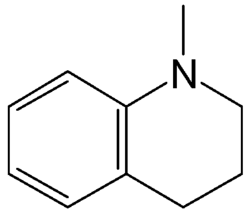
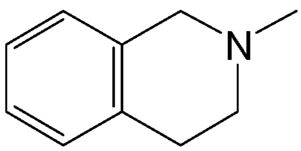
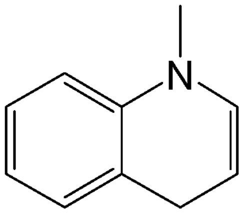
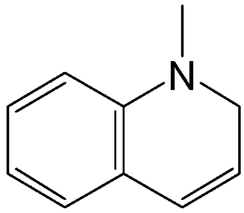
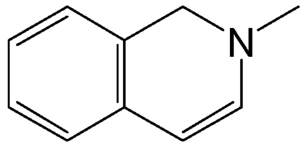
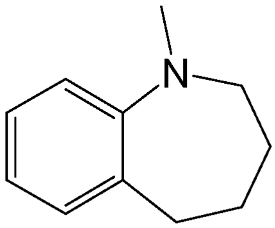
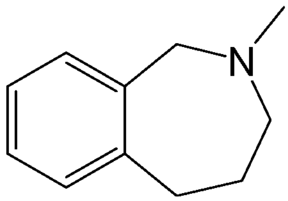
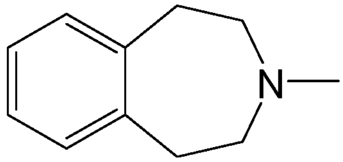
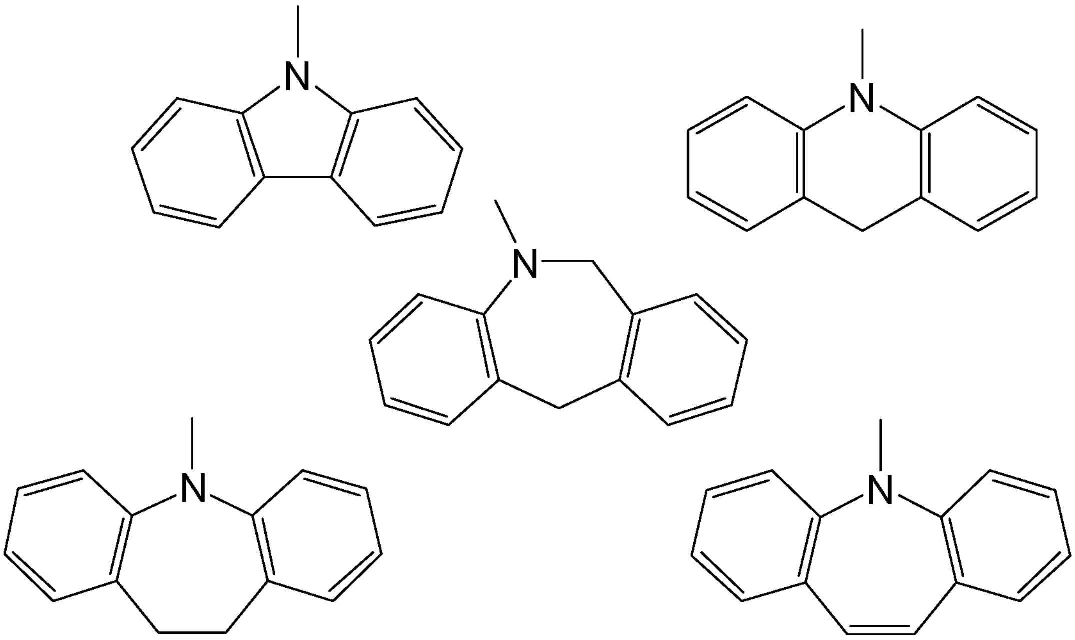

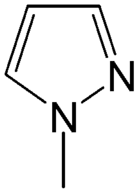
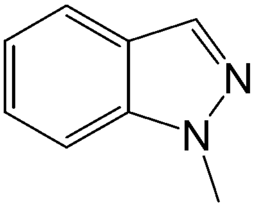
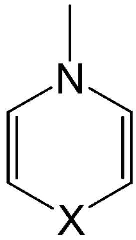
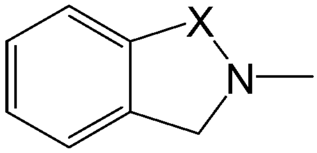
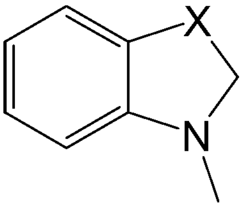
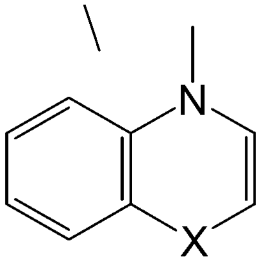
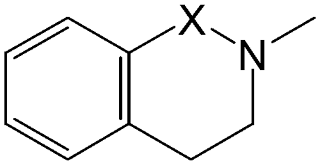
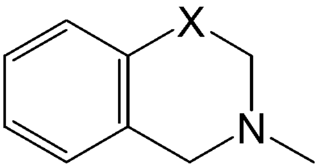
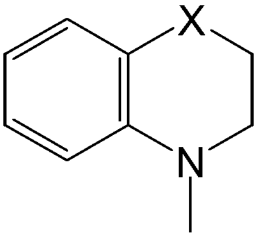
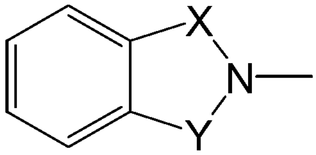
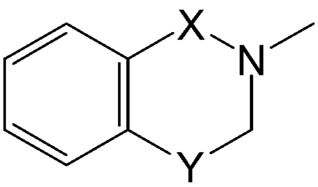
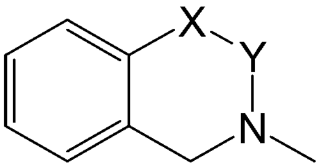
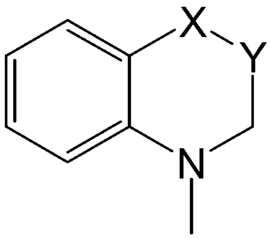
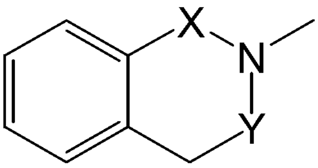
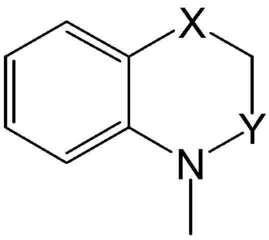
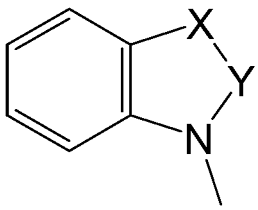
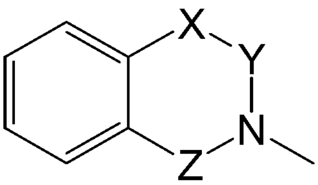
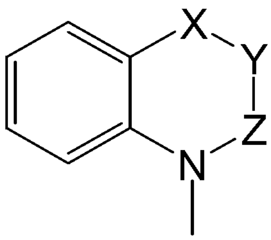

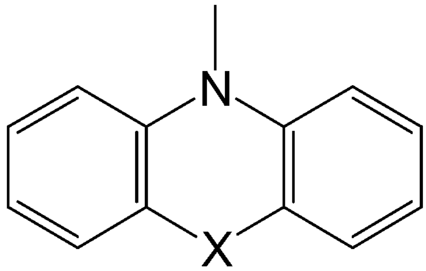
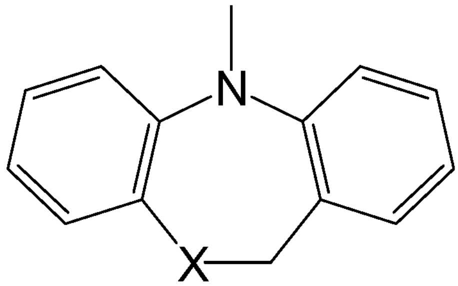
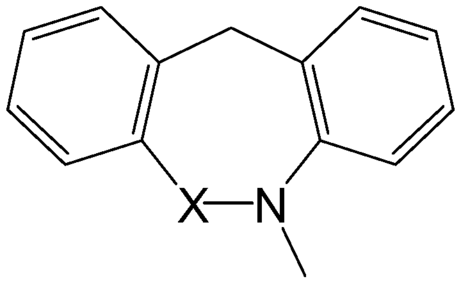
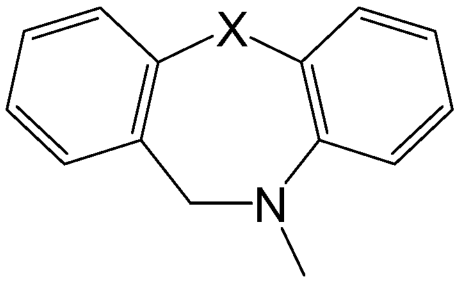
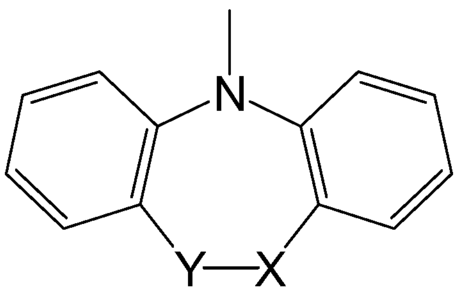
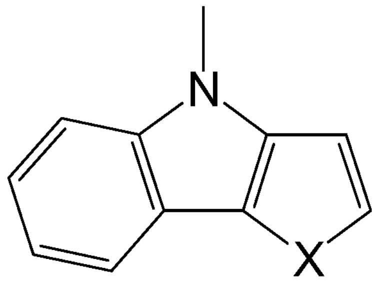
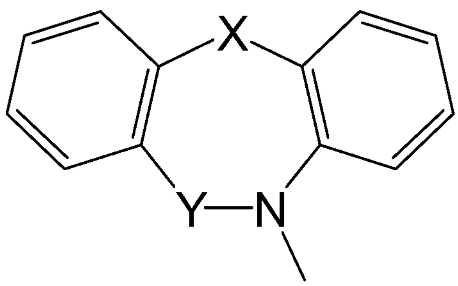
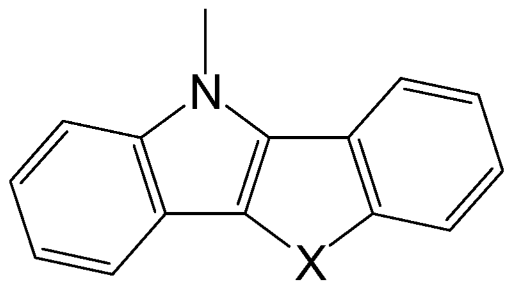

(In the formulae, X, Y, and Z have the same meanings as described above.)

The rings may have a substituent. Examples of the substituent may include those described as the substituent in the aromatic ring of $A^x$.

The total number of π electrons contained in $A^x$ and $A^y$ is preferably 4 or more, more preferably 6 or more and preferably 24 or less, more preferably 20 or less, and further preferably 18 or less from the viewpoint of favorably expressing the desired effect of the present invention.

Examples of preferred combination of $A^x$ and $A^y$ may include the following combinations (α) and (β).

(α) a combination of $A^x$ and $A^y$ in which $A^x$ is an aromatic hydrocarbon ring group of 4 to 30 carbon atoms or an aromatic heterocyclic group of 4 to 30 carbon atoms, $A^y$ is a hydrogen atom, a cycloalkyl group of 3 to 8 carbon atoms, an aromatic hydrocarbon ring group of 6 to 12 carbon atoms optionally having a substituent (a halogen atom, a cyano group, an alkyl group of 1 to 6 carbon atoms, an alkoxy group of 1 to 6 carbon atoms, or a cycloalkyl group of 3 to 8 carbon atoms), an aromatic heterocyclic group of 3 to 9 carbon atoms optionally having a substituent (a

halogen atom, an alkyl group of 1 to 6 carbon atoms, an alkoxy group of 1 to 6 carbon atoms, or a cyano group), an alkyl group of 1 to 20 carbon atoms optionally having a substituent, an alkenyl group of 1 to 20 carbon atoms optionally having a substituent, or an alkynyl group of 2 to 20 carbon atoms optionally having a substituent, and the substituent is any of a halogen atom, a cyano group, an alkoxy group of 1 to 20 carbon atoms, an alkoxy group of 1 to 12 carbon atoms that is substituted by an alkoxy group of 1 to 12 carbon atoms, a phenyl group, a cyclohexyl group, a cyclic ether group of 2 to 12 carbon atoms, an aryloxy group of 6 to 14 carbon atoms, a hydroxyl group, a benzodioxanyl group, a benzenesulfonyl group, a benzoyl group, and $-SR^{10}$.

(β) a combination of $A^x$ and $A^y$ in which $A^x$ and $A^y$ together form an unsaturated heterocyclic ring or an unsaturated carbon ring. Herein, $R^{10}$ has the same meanings as described above.

Examples of more preferred combination of $A^x$ and $A^y$ may include the following combination (γ).

(γ) a combination of $A^x$ and $A^y$ in which $A^x$ is any of groups having the following structures, $A^y$ is a hydrogen atom, a cycloalkyl group of 3 to 8 carbon atoms, an aromatic hydrocarbon ring group of 6 to 12 carbon atoms optionally having a substituent (a halogen atom, a cyano group, an alkyl group of 1 to 6 carbon atoms, an alkoxy group of 1 to 6 carbon atoms, or a cycloalkyl group of 3 to 8 carbon atoms), an aromatic heterocyclic group of 3 to 9 carbon atoms optionally having a substituent (a halogen atom, an alkyl group of 1 to 6 carbon atoms, an alkoxy group of 1 to 6 carbon atoms, or a cyano group), an alkyl group of 1 to 20 carbon atoms optionally having a substituent, an alkenyl group of 1 to 20 carbon atoms optionally having a substituent, or an alkynyl group of 2 to 20 carbon atoms optionally having a substituent, and the substituent is any of a halogen atom, a cyano group, an alkoxy group of 1 to 20 carbon atoms, an alkoxy group of 1 to 12 carbon atoms that is substituted by an alkoxy group of 1 to 12 carbon atoms, a phenyl group, a cyclohexyl group, a cyclic ether group of 2 to 12 carbon atoms, an aryloxy group of 6 to 14 carbon atoms, a hydroxyl group, a benzodioxanyl group, a benzenesulfonyl group, a benzoyl group, and $-SR^{10}$. Herein, $R^{10}$ has the same meanings as described above.

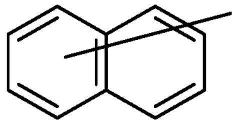
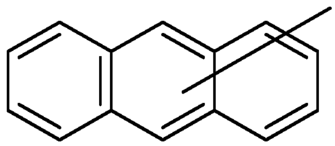

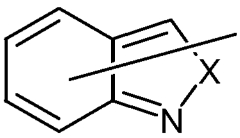
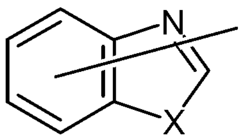
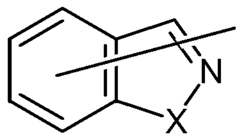
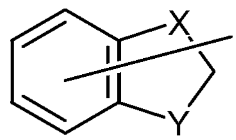

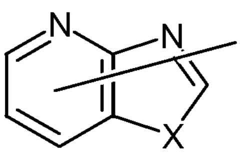
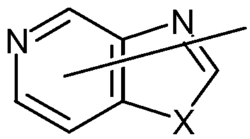
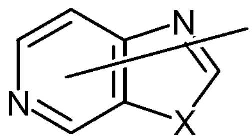

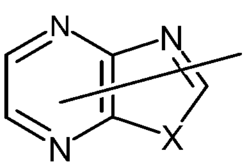
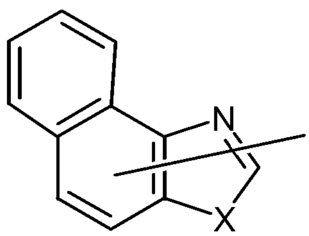
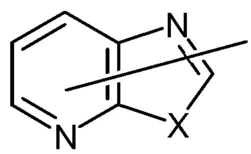

**[0144]** [0149] (In the formulae, X and Y have the same meanings as described above.)

Examples of particularly preferred combination of $A^x$ and $A^y$ may include the following combination (δ).

(δ) a combination of $A^x$ and $A^y$ in which $A^x$ is any of groups having the following structures, $A^y$ is a hydrogen atom, a cycloalkyl group of 3 to 8 carbon atoms, an aromatic hydrocarbon ring group of 6 to 12 carbon atoms optionally

having a substituent (a halogen atom, a cyano group, an alkyl group of 1 to 6 carbon atoms, an alkoxy group of 1 to 6 carbon atoms, or a cycloalkyl group of 3 to 8 carbon atoms), an aromatic heterocyclic group of 3 to 9 carbon atoms optionally having a substituent (a halogen atom, an alkyl group of 1 to 6 carbon atoms, an alkoxy group of 1 to 6 carbon atoms, or a cyano group), an alkyl group of 1 to 20 carbon atoms optionally having a substituent, an alkenyl group of 1 to 20 carbon atoms optionally having a substituent, or an alkynyl group of 2 to 20 carbon atoms optionally having a substituent, and the substituent is any of a halogen atom, a cyano group, an alkoxy group of 1 to 20 carbon atoms, an alkoxy group of 1 to 12 carbon atoms that is substituted by an alkoxy group of 1 to 12 carbon atoms, a phenyl group, a cyclohexyl group, a cyclic ether group of 2 to 12 carbon atoms, an aryloxy group of 6 to 14 carbon atoms, a hydroxyl group, a benzodioxanyl group, a benzenesulfonyl group, a benzoyl group, and $-SR^{10}$.
In the following formulae, X has the same meanings as described above. Herein, $R^{10}$ has the same meanings as described above.

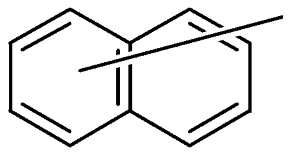
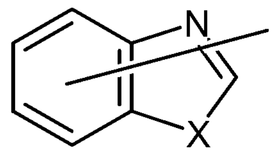

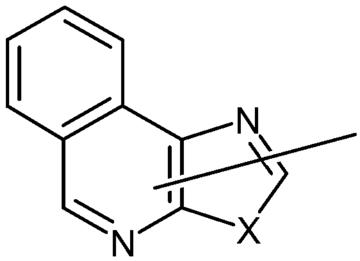
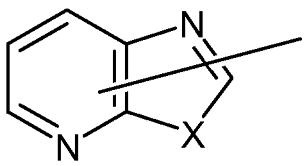
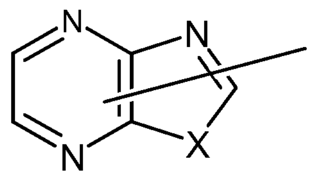

In the formula (I) mentioned above, $A^1$ is a trivalent aromatic group optionally having a substituent. The trivalent aromatic group may be a trivalent carbocyclic aromatic group or a trivalent heterocyclic aromatic group. From the viewpoint of favorably expressing the desired effect of the present invention, the trivalent aromatic group is preferably the trivalent carbocyclic aromatic group, more preferably a trivalent benzene ring group or a trivalent naphthalene ring group, and further preferably a trivalent benzene ring group or a trivalent naphthalene ring group that is represented by the following formula.
In the following formulae, substituents $Y^1$ and $Y^2$ are described for the sake of convenience to clearly show a bonding state ($Y^1$ and $Y^2$ have the same meanings as described above, and the same applies to the following).

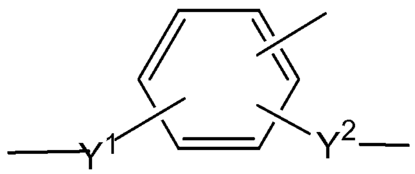
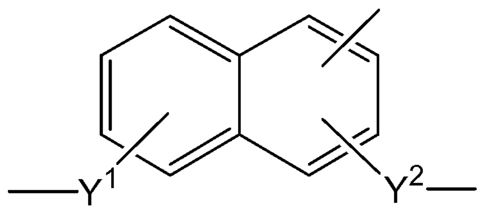

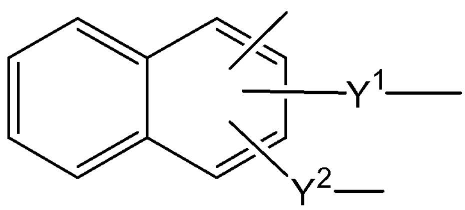
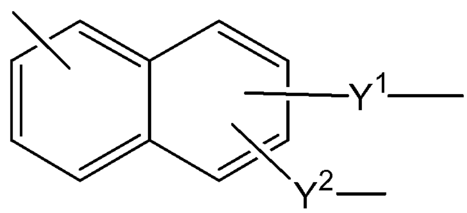

Among these, $A^1$ is more preferably a group represented by each of the following formulae (A11) to (A25), further preferably a group represented by the formula (A11), (A13), (A15), (A19), or (A23), and particularly preferably a group represented by the formula (A11) or (A23).

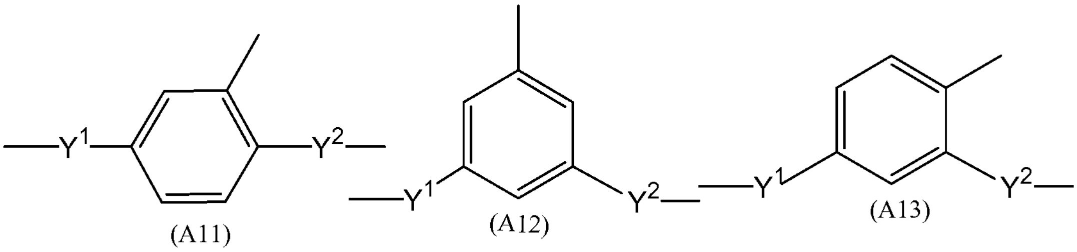

(A11) (A12) (A13)

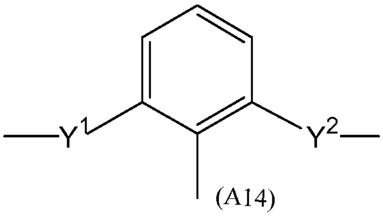

(A14)

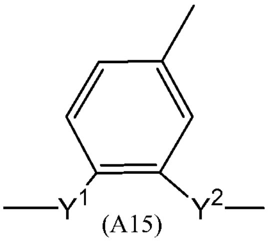

(A15)

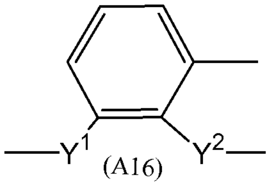

(A16)

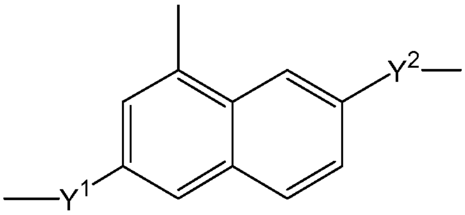

(A17)

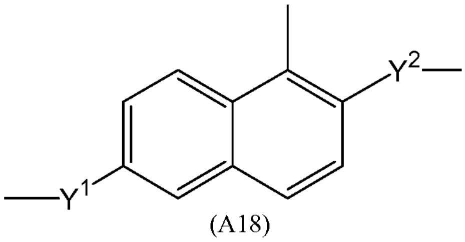

(A18)

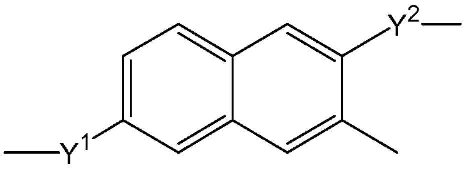

(A19)

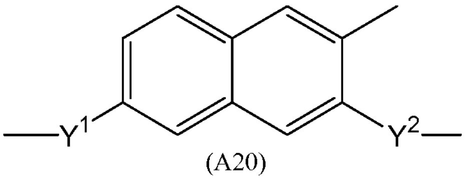

(A20)

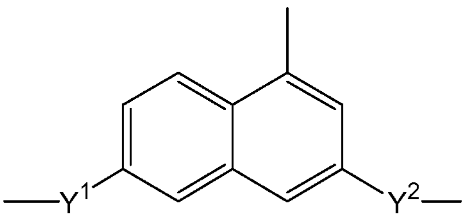

(A21)

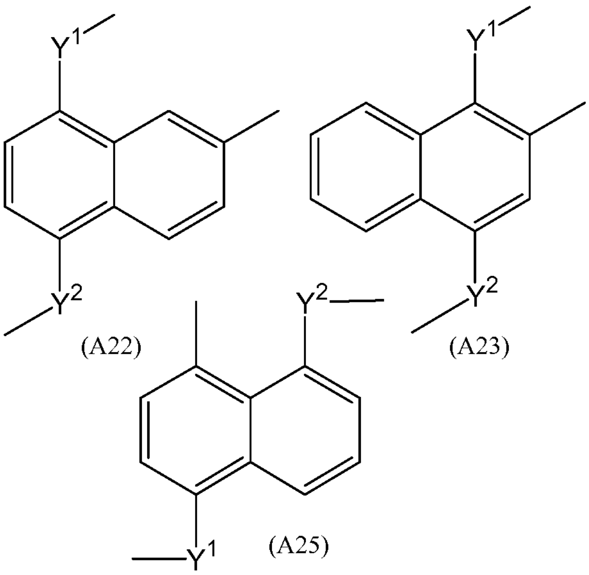

(A22) (A23) (A25)

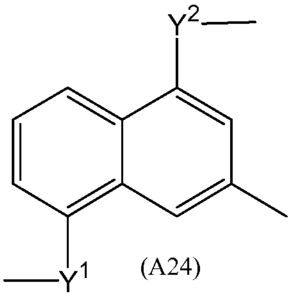

(A24)

Examples of the substituent that may be included in the trivalent aromatic group of $A^1$ may include those described as the substituent in the aromatic ring of $A^x$ described above. It is preferable that $A^1$ is a trivalent aromatic

group having no substituent.

In the formula (I) mentioned above, $A^2$ and $A^3$ are each independently a divalent alicyclic hydrocarbon group of 3 to 30 carbon atoms optionally having a substituent. Examples of the divalent alicyclic hydrocarbon group of 3 to 30 carbon atoms may include a cycloalkanediyl group of 3 to 30 carbon atoms, and a divalent alicyclic fused ring group of 10 to 30 carbon atoms.

Examples of the cycloalkanediyl group of 3 to 30 carbon atoms may include a cyclopropanediyl group; a cyclobutanediyl group, such as a cyclobutane-1,2-diyl group and a cyclobutane-1,3-diyl group; a cyclopentanediyl group, such as a cyclopentane-1,2-diyl group and a cyclopentane-1,3-diyl group; a cyclohexanediyl group, such as a cyclohexane-1,2-diyl group, a cyclohexane-1,3-diyl group, and a cyclohexane-1,4-diyl group; a cycloheptanediyl group, such as a cycloheptane-1,2-diyl group, a cycloheptane-1,3-diyl group, and a cycloheptane-1,4-diyl group; a cyclooctanediyl group, such as a cyclooctane-1,2-diyl group, a cyclooctane-1,3-diyl group, a cyclooctane-1,4-diyl group, and a cyclooctane-1,5-diyl group; a cyclodecanediyl group, such as a cyclodecane-1,2-diyl group, a cyclodecane-1,3-diyl group, a cyclodecane-1,4-diyl group, and a cyclodecane-1,5-diyl group; a cyclododecanediyl group, such as a cyclododecane-1,2-diyl group, a cyclododecane-1,3-diyl group, a cyclododecane-1,4-diyl group, and a cyclododecane-1,5-diyl group; a cyclotetradecanediyl group, such as a cyclotetradecane-1,2-diyl group, a cyclotetradecane-1,3-diyl group, a cyclotetradecane-1,4-diyl group, a cyclotetradecane-1,5-diyl group, and a cyclotetradecane-1,7-diyl group; and a cycloeicosanediyl group, such as a cycloeicosane-1,2-diyl group and a cycloeicosane-1,10-diyl group.

Examples of the divalent alicyclic fused ring group of 10 to 30 carbon atoms may include a decalindiyl group, such as a decalin-2,5-diyl group and a decalin-2,7-diyl group; an adamantanediyl group, such as an adamantane-1,2-diyl group and an adamantane-1,3-diyl group; and a bicyclo[2.2.1]heptanediyl group, such as a bicyclo[2.2.1]heptane-2,3-diyl group, a bicyclo[2.2.1]heptane-2,5-diyl group, and a bicyclo[2.2.1]heptane-2,6-diyl group.

The divalent alicyclic hydrocarbon groups may further have a substituent at any position. Examples of the substituent may include those described as the substituent in the aromatic ring of $A^x$ described above.

Among these, $A^2$ and $A^3$ are preferably a divalent alicyclic hydrocarbon group of 3 to 12 carbon atoms, more preferably a cycloalkanediyl group of 3 to 12 carbon atoms, further preferably a group represented by each of the following formulae (A31) to (A34), and particularly preferably the group represented by the following formula (A32).

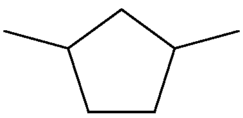
(A31)

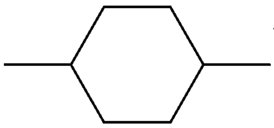
(A32)

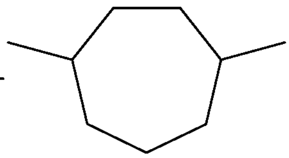
(A33)

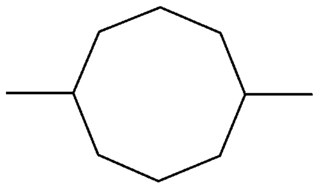
(A34)

The divalent alicyclic hydrocarbon group of 3 to 30 carbon atoms may exist in forms of cis- and trans-stereoisomers that are on the basis of difference of stereoconfiguration of carbon atoms bonded to $Y^1$ and $Y^3$ (or $Y^2$ and $Y^4$). For example, when the group is a cyclohexane-1,4-diyl group, a cis-isomer (A32a) and a trans-isomer (A32b) may exist, as described below.

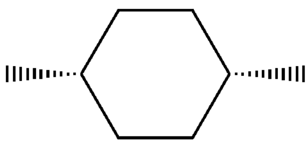
(A32a)

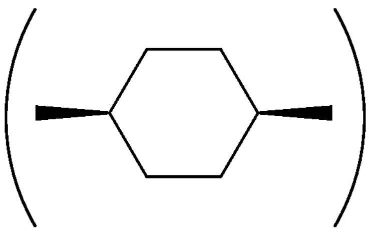

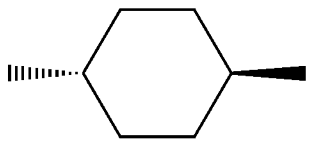
(A32b)

The aforementioned divalent alicyclic hydrocarbon group of 3 to 30 carbon atoms may be a cis-isomer, a trans-isomer, or an isomeric mixture of cis- and trans-isomers. Since the orientation is favorable, the group is preferably the trans-isomer or the cis-isomer, and more preferably the trans-isomer.

In the formula (I) mentioned above, $A^4$ and $A^5$ are each independently a divalent aromatic group of 6 to 30 carbon atoms optionally having a substituent. The aromatic group of $A^4$ and $A^5$ may be monocyclic or polycyclic. Specific preferable examples of $A^4$ and $A^5$ are as follows.

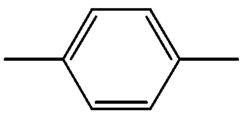
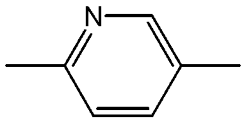
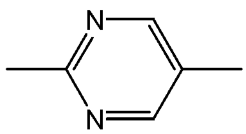
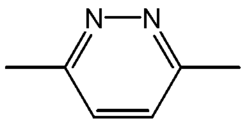

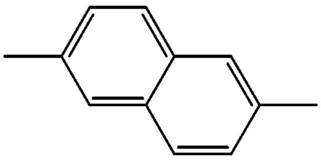
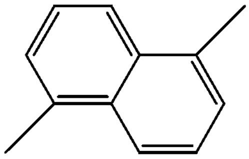
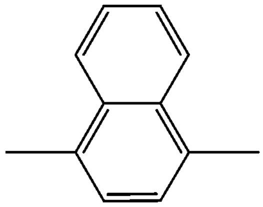

The divalent aromatic groups of $A^4$ and $A^5$ described above may have a substituent at any position. Examples of the substituent may include a halogen atom, a cyano group, a hydroxyl group, an alkyl group of 1 to 6 carbon atoms, an alkoxy group of 1 to 6 carbon atoms, a nitro group, and a -C(=O)-$OR^{8b}$ group. Herein, $R^{8b}$ is an alkyl group of 1 to 6 carbon atoms. In particular, it is preferable that the substituent is a halogen atom, an alkyl group of 1 to 6 carbon atoms, or an alkoxy group. Of the halogen atoms, a fluorine atom is more preferable, of the alkyl groups of 1 to 6 carbon atoms, a methyl group, an ethyl group, and a propyl group are more preferable, and of the alkoxy groups, a methoxy group and an ethoxy group are more preferable.

Among these, from the viewpoint of favorably expressing the desired effect of the present invention, $A^4$ and $A^5$ are each independently preferably a group represented by the following formula (A41), (A42), or (A43) and optionally having a substituent, and particularly preferably the group represented by the formula (A41) and optionally having a substituent.

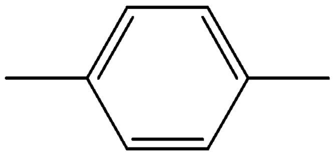
(A41)

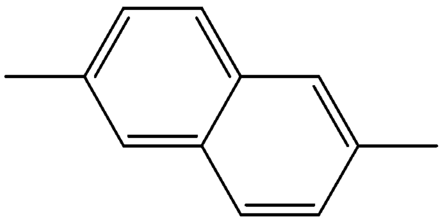
(A42)

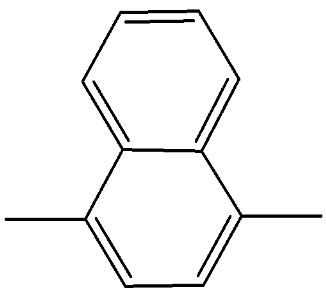
(A43)

In the formula (I) mentioned above, $Q^1$ is a hydrogen atom or an alkyl group of 1 to 6 carbon atoms optionally having a substituent. Examples of the alkyl group of 1 to 6 carbon atoms optionally having a substituent may include the alkyl group of 1 to 6 carbon atoms among the alkyl groups of 1 to 20 carbon atoms optionally having a substituent that are described as $A^y$ described above. Among these, $Q^1$ is preferably a hydrogen atom or an alkyl group of 1 to 6 carbon atoms, and more preferably a hydrogen atom or a methyl group.

In the formula (I) mentioned above, m and n are each independently 0 or 1. Among these, m is preferably 1,

and n is preferably 1.

The compound (I) may be produced, for example, by the following reaction.

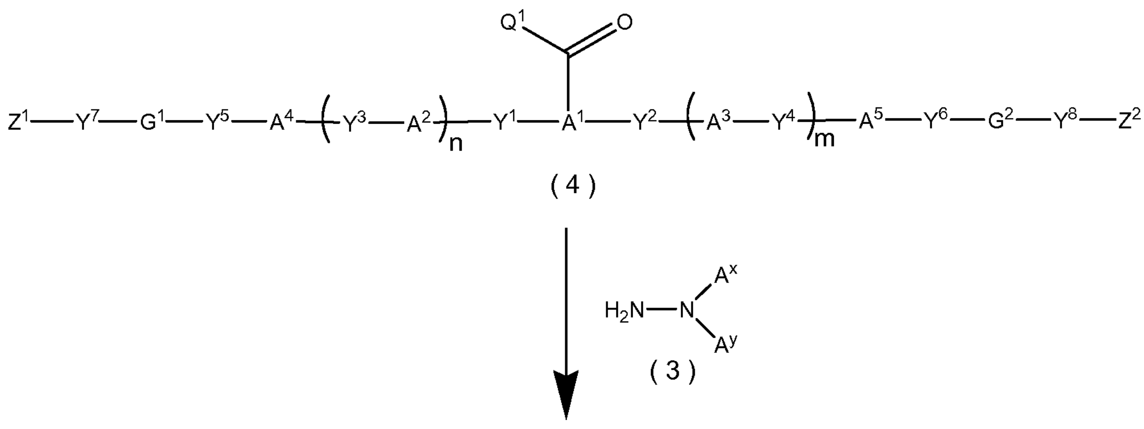

(4)

(3)

(I)

(In the formula, $Y^1$ to $Y^8$, $G^1$, $G^2$, $Z^1$, $Z^2$, $A^x$, $A^y$, $A^1$ to $A^5$, $Q^1$, m, and n have the same meanings as described above.)

As shown in the aforementioned reaction formula, the compound (I) may be produced by a reaction of a hydrazine compound represented by a formula (3) with a carbonyl compound represented by a formula (4). Hereinafter, the hydrazine compound represented by the formula (3) may be referred to as "hydrazine compound (3)" as appropriate. The carbonyl compound represented by the formula (4) may be referred to as "carbonyl compound (4)" as appropriate.

In the aforementioned reaction, the molar ratio of "the hydrazine compound (3) : the carbonyl compound (4)" is preferably 1:2 to 2:1, and more preferably 1:1.5 to 1.5:1. When the compounds are reacted at such a molar ratio, the compound (I) as a target can be highly selectively produced in high yield.

In this case, the reaction system may include an acid catalyst including an organic acid, such as (±)-10-camphorsulfonic acid and p-toluene sulfonic acid; and an inorganic acid, such as hydrochloric acid and sulfuric acid. When the acid catalyst is used, the reaction time may be shortened, and the yield may be improved. The amount of the acid catalyst is usually 0.001 mol to 1 mol relative to 1 mol of the carbonyl compound (4). The acid catalyst as it is may be mixed in the reaction system. Alternatively, the acid catalyst to be mixed may be in a solution form in which the acid catalyst is dissolved in an appropriate solution.

As the solvent for use in the reaction, a solvent inert to the reaction may be used. Examples of the solvent may include an alcohol-based solvent, such as methyl alcohol, ethyl alcohol, n-propyl alcohol, isopropyl alcohol, n-butyl alcohol, isobutyl alcohol, sec-butyl alcohol, and t-butyl alcohol; an ether-based solvent, such as diethyl ether, tetrahydrofuran, 1,2-dimethoxyethane, 1,4-dioxane, and cyclopentyl methyl ether; an ester-based solvent, such as ethyl acetate, propyl acetate, and methyl propionate; an aromatic hydrocarbon-based solvent, such as benzene, toluene, and xylene; an aliphatic hydrocarbon-based solvent, such as n-pentane, n-hexane, and n-heptane; an amide-based solvent, such as N,N-dimethylformamide, N-methylpyrrolidone, and hexamethylphosphoric triamide; a sulfur-containing solvent, such as dimethylsulfoxide, and sulfolane; and a mixed solvent of two or more types thereof. Among these, the alcohol-based solvent, the ether-based solvent, and a mixed solvent of the alcohol-based solvent and the ether-based solvent are preferable.

The amount of the solvent used is not particularly limited, and may be determined in consideration of type of compound to be used, reaction scale, and the like. The specific amount of the solvent used is usually 1 g to 100 g relative to 1 g of the hydrazine compound (3).

The reaction can smoothly proceed in a temperature range that is usually -10°C or higher and equal to or lower than the boiling point of the solvent used.

The reaction time of each reaction may vary depending on the reaction scale, and is usually several minutes to several hours.

The hydrazine compound (3) may be produced as follows.

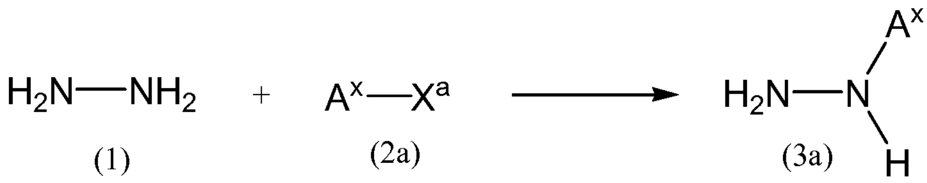

(1) (2a) (3a)

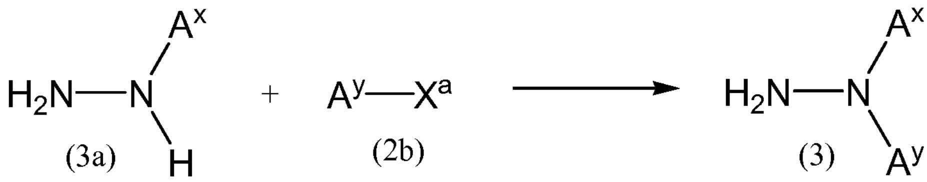

(3a) (2b) (3)

(wherein, $A^x$ and $A^y$ have the same meanings as described above, and $X^a$ is a leaving group, such as a halogen atom, a methanesulfonyloxy group, and a p-toluenesulfonyloxy group.)

As shown in the aforementioned reaction formula, a corresponding hydrazine compound (3a) can be obtained by a reaction of a compound represented by a formula (2a) with hydrazine (1) in an appropriate solvent. In this reaction, the molar ratio of "the compound (2a) : the hydrazine (1)" is preferably 1:1 to 1:20, and more preferably 1:2 to 1:10. Further, the hydrazine compound (3a) can be reacted with a compound represented by a formula (2b) to obtain the hydrazine compound (3).

As hydrazine (1), hydrazine monohydrate may be usually used. As hydrazine (1), a commercially available product as it is may be used.

As the solvent for use in this reaction, a solvent inert to the reaction may be used. Examples of the solvent may include an alcohol-based solvent, such as methyl alcohol, ethyl alcohol, n-propyl alcohol, isopropyl alcohol, n-butyl alcohol, isobutyl alcohol, sec-butyl alcohol, and t-butyl alcohol; an ether-based solvent, such as diethyl ether, tetrahydrofuran, 1,2-dimethoxyethane, 1,4-dioxane, and cyclopentyl methyl ether; an aromatic hydrocarbon-based solvent, such as benzene, toluene, and xylene; an aliphatic hydrocarbon-based solvent, such as n-pentane, n-hexane, and n-heptane; an amide-based solvent, such as N,N-dimethylformamide, N-methylpyrrolidone, and hexamethylphosphoric triamide; a sulfur-containing solvent, such as dimethylsulfoxide, and sulfolane; and a mixed solvent of two or more types thereof. Among these, the alcohol-based solvent, the ether-based solvent, and a mixed solvent of the alcohol-based solvent and the ether-based solvent are preferable.

The amount of the solvent used is not particularly limited, and may be determined in consideration of type of compound to be used, reaction scale, and the like. For example, the specific amount of the solvent used is usually 1 g to 100 g relative to 1 g of hydrazine.

The reaction can smoothly proceed in a temperature range that is usually -10°C or higher and equal to or lower than the boiling point of the solvent used.
The reaction time of each reaction may vary depending on the reaction scale, and is usually several minutes to several hours.

The hydrazine compound (3) may also be produced by reducing a diazonium salt (5) through a known method, as described below.

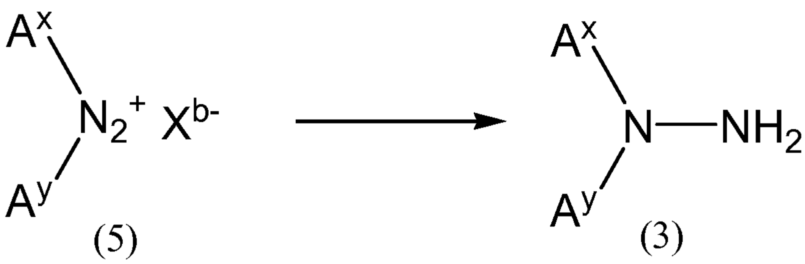

(5) (3)

In the formula (5), $A^x$ and $A^y$ have the same meanings as described above, and $X^{b-}$ is an anion that is a counter ion of diazonium. Examples of $X^{b-}$ may include an inorganic anion, such as a hexafluorophosphate ion, a fluoroborate ion, a chloride ion, and a sulfate ion; and an organic anion, such as a polyfluoroalkylcarbonate ion, a polyfluoroalkylsulfonate ion, a tetraphenylborate ion, an aromatic carboxylate ion, and an aromatic sulfonate ion.

Examples of the reducing agent used in the aforementioned reaction may include a metal salt reducing agent. The metal salt reducing agent is generally a compound containing low-valent metal or a compound composed of a metal

ion and a hydride source (see "Yuki Gosei Jikkenhou Handbook (Organic synthesis experimental method handbook)", 1990, edited by The Society of Synthetic Organic Chemistry, Japan, published by Maruzen Co., Ltd., p. 810).

Examples of the metal salt reducing agent may include $NaAlH_4$, $NaAlH_p(Or)_q$ (wherein p and q are each independently an integer of 1 to 3, p + q = 4, and r is an alkyl group of 1 to 6 carbon atoms), $LiAlH_4$, $iBu_2AlH$, $LiBH_4$, $NaBH_4$, $SnCl_2$, $CrCl_2$, and $TiCl_3$. Herein, "iBu" represents an isobutyl group.

In the reduction reaction, a known reaction condition may be adopted. For example, the reaction may be performed under conditions described in documents including Japanese Patent Application Laid-Open No. 2005-336103 A, Shin Jikken Kagaku Koza (New course of experimental chemistry), 1978, published by Maruzen Co., Ltd., vol. 14, and Jikken Kagaku Koza (Course of experimental chemistry), 1992, published by Maruzen Co., Ltd., vol. 20.

The diazonium salt (5) may be produced from a compound such as aniline by an ordinary method.

The carbonyl compound (4) may be produced, for example, by appropriately bonding and modifying a plurality of known compounds having a desired structure through any combination of reactions of forming an ether linkage (-O-), an ester linkage (-C(=O)-O- and -O-C(=O)-), a carbonate linkage (-O-C(=O)-O-), and an amide linkage (-C(=O)NH- and -NH-C(=O)-).

An ether linkage may be formed as follows.

(i) A compound represented by a formula: D1-hal (hal is a halogen atom, and the same applies to the following) and a compound represented by a formula: D2-OMet (Met is an alkaline metal (mainly sodium), and the same applies to the following) are mixed and condensed (Williamson synthesis). In the formulae, D1 and D2 are an optional organic group (the same applies to the following).

(ii) A compound represented by a formula: D1-hal and a compound represented by a formula: D2-OH are mixed in the presence of a base, such as sodium hydroxide and potassium hydroxide and condensed.

(iii) A compound represented by a formula: D1-J (J is an epoxy group) and a compound represented by a formula: D2-OH are mixed in the presence of a base, such as sodium hydroxide and potassium hydroxide and condensed.

(iv) A compound represented by a formula: D1-OFN (OFN is a group having an unsaturated bond) and a compound represented by a formula: D2-OMet are mixed in the presence of a base, such as sodium hydroxide and potassium hydroxide and subjected to an addition reaction.

(v) A compound represented by a formula: D1-hal and a compound represented by a formula: D2-OMet are mixed in the presence of copper or cuprous chloride and condensed (Ullmann condensation).

An ester linkage and an amide linkage may be formed as follows.

(vi) A compound represented by a formula: D1-COOH and a compound represented by a formula: D2-OH or D2-$NH_2$ are subjected to dehydration condensation in the presence of a dehydration condensation agent (N,N-dicyclohexylcarbodiimide, etc.).

(vii) A compound represented by a formula: D1-COOH is reacted with a halogenating agent to obtain a compound represented by a formula: D1-CO-hal, and the compound is reacted with a compound represented by a formula: D2-OH or D2-$NH_2$ in the presence of a base.

(viii) A compound represented by a formula: D1-COOH is reacted with an acid anhydride to obtain a mixed acid anhydride, and the mixed acid anhydride is reacted with a compound represented by a formula: D2-OH or D2-$NH_2$.

(ix) A compound represented by a formula: D1-COOH and a compound represented by a formula: D2-OH or D2-$NH_2$ are subjected to dehydration condensation in the presence of an acid catalyst or a base catalyst.

More specifically, the carbonyl compound (4) may be produced through a process shown in the following reaction formula.

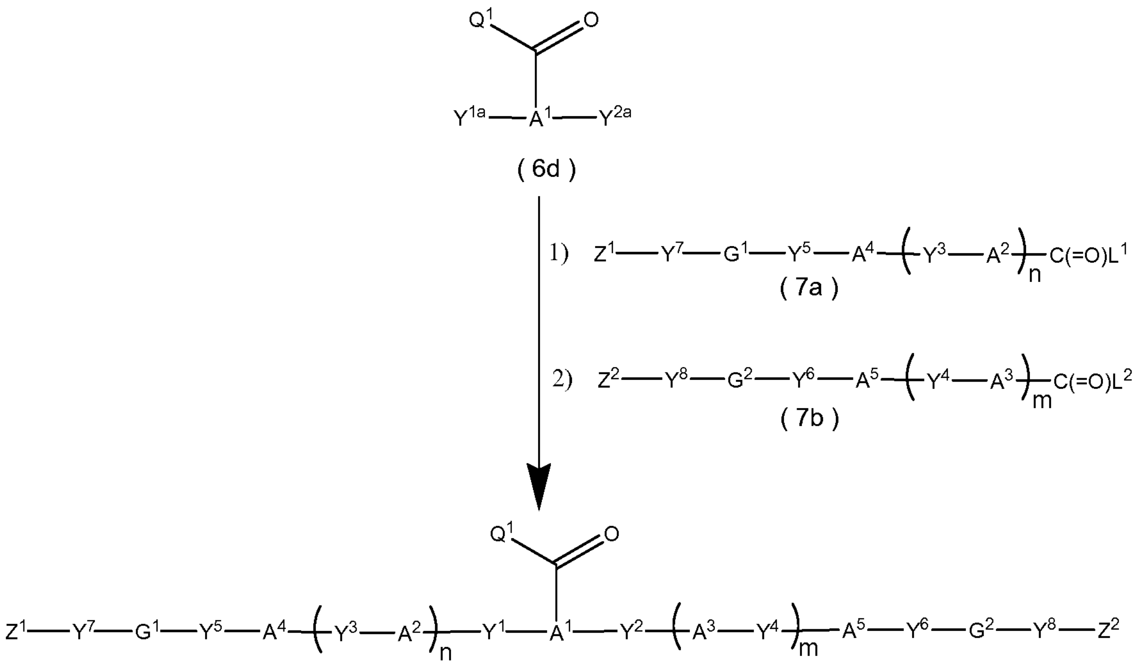


( 4 )

(In the formula, $Y^1$ to $Y^8$, $G^1$, $G^2$, $Z^1$, $Z^2$, $A^1$ to $A^5$, $Q^1$, m, and n have the same meanings as described above; $L^1$ and $L^2$ are each independently a leaving group, such as a hydroxyl group, a halogen atom, a methanesulfonyloxy group, and a p-toluenesulfonyloxy group; $-Y^{1a}$ is a group that is capable of being reacted with $-L^1$ to be $-Y^1-$; and $-Y^{2a}$ is a group that is capable of being reacted with $-L^2$ to be $-Y^2-$.)

As shown in the aforementioned reaction formula, the carbonyl compound (4) may be produced by reacting a compound represented by a formula (6d) with a compound represented by a formula (7a) followed by a compound represented by a formula (7b) by using a reaction of forming an ether linkage (-O-), an ester linkage (-C(=O)-O- and -O-C(=O)-), or a carbonate linkage (-O-C(=O)-O-).

Specifically, a method for producing a compound (4') in which $Y^1$ is a group represented by a formula: $Y^{11}$-C(=O)-O- and a group represented by a formula: $Z^2$-$Y^8$-$G^2$-$Y^6$-$A^5$-$(Y^4$-$A^3)_m$-$Y^2$- is the same as a group represented by a formula: $Z^1$-$Y^7$-$G^1$-$Y^5$-$A^4$-$(Y^3$-$A^2)_n$-$Y^1$- is as follows.

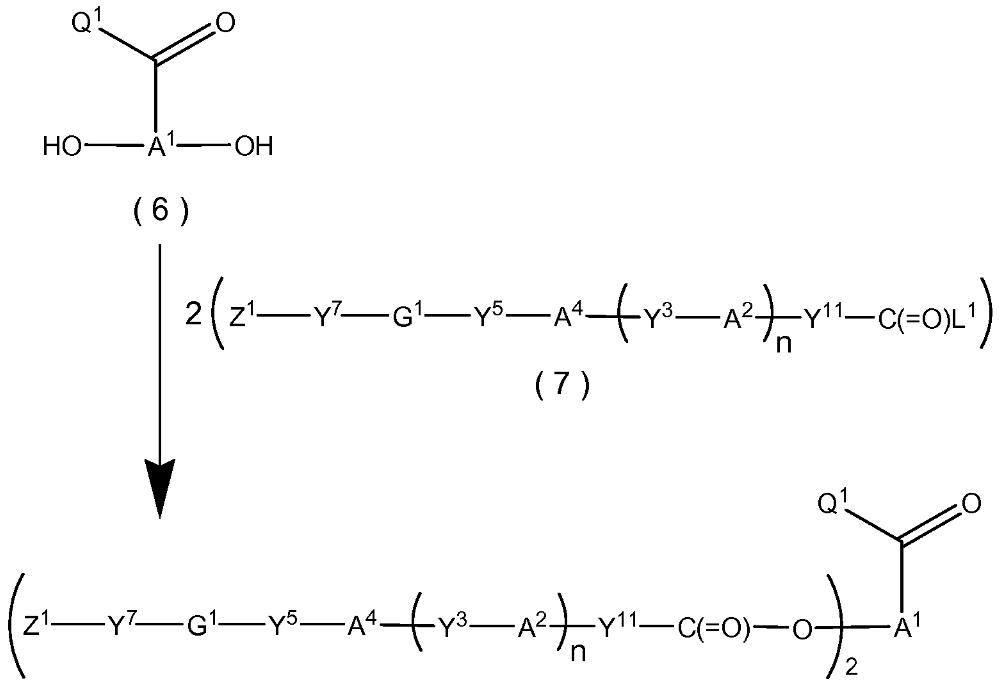

(6)

(7)

(4')

(In the formula, $Y^3$, $Y^5$, $Y^7$, $G^1$, $Z^1$, $A^1$, $A^2$, $A^4$, $Q^1$, n, and $L^1$ have the same meanings as described above; $Y^{11}$ is a group having a structure with which $Y^{11}$-C(=O)-O-corresponds to $Y^1$; and $Y^1$ has the same meanings as described above.)

As shown in the aforementioned reaction formula, the compound (4') may be produced by a reaction of a dihydroxy compound represented by a formula (6) (compound (6)) with a compound represented by a formula (7) (compound (7)). In the aforementioned reaction, the molar ratio of "the compound (6): the compound (7)" is preferably 1:2 to 1:4, and more preferably 1:2 to 1:3. When the compounds are reacted at such a molar ratio, the compound (4') as a target can be highly selectively produced in high yield.

When the compound (7) is a compound in which $L^1$ is a hydroxyl group (carboxylic acid), the reaction may be performed in the presence of a dehydration condensation agent such as 1-ethyl-3-(3-dimethylaminopropyl)carbodiimide hydrochloride and dicyclohexyl carbodiimide, to obtain a target compound. The amount of the dehydration condensation agent used is usually 1 mol to 3 mol relative to 1 mol of the compound (7).

When the compound (7) is a compound in which $L^1$ is a hydroxyl group (carboxylic acid), the reaction may be performed in the presence of sulfonyl halide such as methanesulfonyl chloride and p-toluenesulfonyl chloride, and a base such as triethylamine, diisopropylethylamine, pyridine, and 4-(dimethylamino)pyridine, to obtain a target compound. The amount of the sulfonyl halide used is usually 1 mol to 3 mol relative to 1 mol of the compound (7). The amount of base used is usually 1 mol to 3 mol relative to 1 mol of the compound (7). In this case, a compound in which $L^1$ in the formula (7) is a sulfonyloxy group (mixed acid anhydride) may be isolated, before performing the subsequent reaction.

When the compound (7) is a compound in which $L^1$ is a halogen atom (acid halide), the reaction may be performed in the presence of a base to obtain a target compound. Examples of the base may include an organic base such as triethylamine and pyridine; and an inorganic base such as sodium hydroxide, sodium carbonate, and sodium hydrogen carbonate. The amount of base used is usually 1 mol to 3 mol relative to 1 mol of the compound (7).

Examples of a solvent for use in the reaction may include a chlorinated solvent, such as chloroform, and methylene chloride; an amide-based solvent, such as N-methylpyrrolidone, N,N-dimethylformamide, N,N-dimethylacetamide, and hexamethylphosphoric triamide; an ether-based solvent, such as 1,4-dioxane, cyclopentyl methyl ether, tetrahydrofuran, tetrahydropyran, and 1,3-dioxolane; a sulfur-containing solvent, such as dimethylsulfoxide, and sulfolane; an aromatic hydrocarbon-based solvent, such as benzene, toluene, and xylene; an aliphatic hydrocarbon-based solvent, such as n-pentane, n-hexane, and n-octane; an alicyclic hydrocarbon-based solvent, such as cyclopentane, and cyclohexane; and a mixed solvent of two or more types thereof.

The amount of the solvent used is not particularly limited, and may be determined in consideration of type of compound to be used, reaction scale, and the like. The specific amount of the solvent used is usually 1 g to 50 g relative to 1 g of the hydroxy compound (6).

Most of compounds (6) are known substances, and may be produced by known methods. For example, the compound (6) may be produced by a process shown in the following reaction formula (see International publication

WO2009/042544 and The Journal of Organic Chemistry, 2011, 76, 8082-8087). A product commercially available as the compound (6) may be used with, if desired, purification.

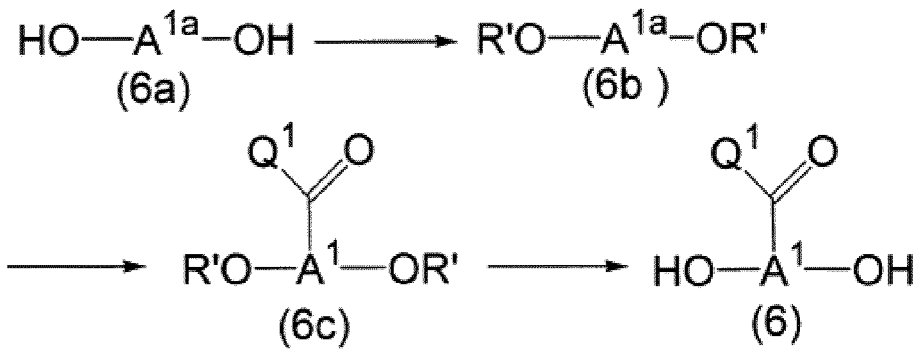


(wherein $A^1$ and $Q^1$ have the same meanings as described above; $A^{1a}$ is a divalent aromatic group that is capable of being formylated or acylated to form $A^1$; and R' is a protecting group of a hydroxyl group, such as an alkyl group of 1 to 6 carbon atoms such as a methyl group and an ethyl group and an alkoxyalkyl group of 2 to 6 carbon atoms such as a methoxymethyl group.)

As shown in the aforementioned reaction formula, a hydroxyl group of a dihydroxy compound represented by a formula (6a) (1,4-dihydroxybenzene, 1,4-dihydroxynaphthalene, etc.) is alkylated to obtain a compound represented by a formula (6b). Subsequently, an ortho position of an OR' group is formylated or acylated by a known method, to obtain a compound represented by a formula (6c). The obtained compound may be subjected to deprotection (dealkylation), to produce the compound (6) as a target.

The product commercially available as the compound (6) as it is may be used or with, if desired, purification.

Most of compounds (7) are known compounds, and may be produced, for example, by appropriately bonding and modifying a plurality of known compounds having a desired structure through any combination of reactions of forming an ether linkage (-O-), an ester linkage (-C(=O)-O- and -O-C(=O)-), a carbonate linkage (-O-C(=O)-O-), and an amide linkage (-C(=O)NH- and -NH-C(=O)-).

For example, when the compound (7) is a compound represented by the following formula (7') (compound (7')), the compound (7') may be produced as follows, using a dicarboxylic acid represented by a formula (9') (compound (9')).

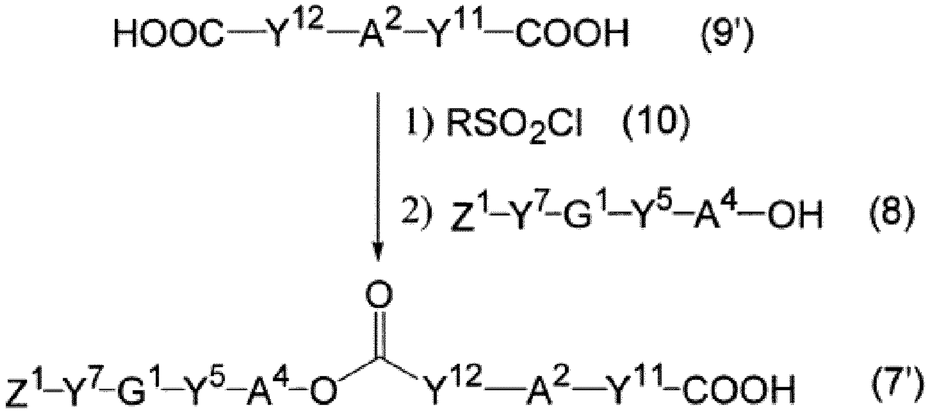


(In the formula, $Y^5$, $Y^7$, $G^1$, $Z^1$, $A^2$, $A^4$, and $Y^{11}$ have the same meanings as described above; $Y^{12}$ is a group having a structure with which -O-C(=O)-$Y^{12}$ corresponds to $Y^3$; and R is an alkyl group, such as a methyl group and an ethyl group, or an aryl group optionally having a substituent, such as a phenyl group and a p-methylphenyl group.)

The compound (9') is first reacted with sulfonyl chloride represented by a formula (10) in the presence of a base such as triethylamine or 4-(dimethylamino)pyridine. Subsequently, to the reaction mixture, a compound (8) and a base such as triethylamine or 4-(dimethylamino)pyridine are added to perform a reaction.

The amount of sulfonyl chloride used is usually 0.5 equivalents to 0.7 equivalents relative to 1 equivalent of the compound (9').

The amount of compound (8) used is usually 0.5 equivalents to 0.6 equivalents relative to 1 equivalent of the compound (9').

The amount of base used is usually 0.5 equivalents to 0.7 equivalents relative to 1 equivalent of the compound (9').

The reaction temperature is 20°C to 30°C, and the reaction time may vary depending on the reaction scale, and the like, and is several minutes to several hours.

Examples of the solvent for use in the aforementioned reaction may include those exemplified as the examples of the solvent that may be used for producing the compound (4'). Among these, an ether solvent is preferable.

The amount of the solvent used is not particularly limited, and may be determined in consideration of type of compound to be used, reaction scale, and the like. For example, the specific amount of the solvent used is usually 1 g to 50 g relative to 1 g of the hydroxy compound (9').

In any of the reactions, a usual post-treatment operation in organic synthesis chemistry may be performed after completion of the reactions. If desired, a known separation and purification treatment such as column chromatography, recrystallization, and distillation may be performed to isolate a target compound.

The structure of the target compound may be identified by measurement such as NMR spectrometry, IR spectrometry, and mass spectrometry, and elemental analysis.

<3.3. Surfactant>

For adjusting the surface tension of the liquid crystal composition within a desired range, the liquid crystal composition preferably includes a surfactant.

As the surfactant, there may be used any surfactant with which the surface tension of the liquid crystal composition can be adjusted within a desired range. In particular, a surfactant which contains a fluorine atom in a molecule of the surfactant is preferable as the surfactant. With the use of the surfactant which contains a fluorine atom in the molecule, the surface tension of the liquid crystal composition can be easily adjusted within a desired range.

The surfactant which contains a fluorine atom in the molecule preferably contains a fluoroalkyl group. As the fluoroalkyl group, a perfluoroalkyl group is preferable, and a $-C_6F_{13}$ group is particularly preferable, from the viewpoint of improvement of the surface state of the optically anisotropic layer, improvement of orientation properties, suppression of uneven retardation, and suppression of uneven thickness.

The ratio of the fluorine atom in the molecule of the surfactant is preferably 5% by weight or more, more preferably 10% by weight or more, and particularly preferably 15% by weight or more, and preferably 50% by weight or less, more preferably 40% by weight or less, and particularly preferably 30% by weight or less. When the ratio of the fluorine atom in the molecule of the surfactant is equal to or more than the lower limit value of the aforementioned range, the optically anisotropic layer can have a favorable surface state and favorable orientation properties. When the ratio of the fluorine atom in the molecule of the surfactant is equal to or more than the upper limit value of the aforementioned range, the optically anisotropic layer can have a favorable surface state and favorable orientation properties, and also suppress unevenness in retardation and thickness.

The ratio of the fluorine atom in the molecule of the surfactant may be measured by the following method.

A surfactant as a sample is weighted, and burned in a combustion tube of an analyzer. A gas generated by the burning is absorbed into an appropriate solution to obtain an absorbing liquid. After that, part of the absorbing liquid may be analyzed by ion chromatography to measure the ratio of a fluorine atom in the molecule of the surfactant.

The surfactant for use may be those having an oligomer structure which contains two or more repeating units in the molecule of the surfactant, or may be those having a monomer structure which does not contain a repeating unit in the molecule of the surfactant.

The surfactant for use may be without polymerization properties, or may be with polymerization properties. Since the surfactant having polymerization properties can be polymerized when polymerizing the inverse wavelength polymerizable liquid crystal compound, the surfactant is usually contained as a part of the molecule of the polymer in the optically anisotropic layer produced with the liquid crystal composition.

Examples of the surfactant containing a fluorine atom as described above may include SURFLON series available from AGC Seimi Chemical Co., Ltd. (S242, S243, S386, S611, S651, etc.), MEGAFACE available from DIC Corporation (F251, F554, F556, F562, RS-75, RS-76-E, etc.), and FTERGENT series available from NEOS COMPANY LIMITED (FTX601AD, FTX602A, FTX601ADH2, FTX650A, etc.). As the surfactant, one type thereof may be solely used, and two or more types thereof may also be used in combination at any ratio.

The amount of the surfactant in the liquid crystal composition with respect to 100 parts by weight of the inverse wavelength polymerizable liquid crystal compound is preferably 0.05 parts by weight or more, more preferably 0.1 parts by weight or more, and particularly preferably 0.3 parts by weight or more, and is preferably 5.0 parts by weight or less, more preferably 1.0 parts by weight or less, and particularly preferably 0.5 parts by weight or less. When the amount of the surfactant is equal to or more than the lower limit value of the aforementioned range, the coating adherence of the liquid crystal composition on the coating surface of the substrate can become particularly favorable. When the amount is equal to or less than the upper limit value, the surface state of the liquid crystal composition can be enhanced while

maintaining orientation properties.

<3.4. Optional Component>

The liquid crystal composition may further include an optional component in combination with the inverse wavelength polymerizable liquid crystal compound and the surfactant which have been previously described.

For example, the liquid crystal composition may include a solvent. A solvent in which the inverse wavelength polymerizable liquid crystal compound can be dissolved is preferable as the solvent. As such a solvent, an organic solvent is usually used. Examples of the organic solvent may include: ketone solvents such as cyclopentanone, cyclohexanone, methyl ethyl ketone, acetone, and methyl isobutyl ketone; acetic acid ester solvents such as butyl acetate and amyl acetate; halogenated hydrocarbon solvents such as chloroform, dichloromethane, and dichloroethane; ether solvents such as 1,4-dioxane, cyclopentyl methyl ether, tetrahydrofuran, tetrahydropyran, 1,3-dioxolane, and 1,2-dimethoxyethane; and aromatic hydrocarbon such as toluene, xylene, and mesitylene.

As the solvent, one type thereof may be solely used, and two or more types thereof may also be used in combination at any ratio. For example, use of a combination of a ketone solvent such as cyclopentanone and an ether solvent such as 1,3-dioxolane is preferable. In such a combination, the weight ratio between the ketone solvent and the ether solvent (ketone solvent/ether solvent) is preferably 10/90 or more, more preferably 30/70 or more, and particularly preferably 40/60 or more, and is preferably 90/10 or less, more preferably 70/30 or less, and particularly preferably 50/50 or less. Use of the ketone solvent and the ether solvent at the previously-described weight ratio can suppress the occurrence of defects during coating.

The boiling point of the solvent is preferably 60°C to 250°C, and more preferably 60°C to 150°C, from the viewpoint of excellent handleability.

The amount of the solvent with respect to 100 parts by weight of the inverse wavelength polymerizable liquid crystal compound is preferably 300 parts by weight or more, more preferably 350 parts by weight or more, and particularly preferably 400 parts by weight or more, and is preferably 700 parts by weight or less, more preferably 600 parts by weight or less, and particularly preferably 500 parts by weight or less. When the amount of the solvent is equal to or more than the lower limit value of the aforementioned range, generation of foreign substances can be suppressed. When the amount is equal to or less than the upper limit value, a drying load can be reduced.

For example, the liquid crystal composition may include a polymerization initiator. The polymerization initiator may be selected depending on the type of the inverse wavelength polymerizable liquid crystal compound. For example, when the inverse wavelength polymerizable liquid crystal compound is radical polymerizable, a radical polymerization initiator may be used. When the inverse wavelength polymerizable liquid crystal compound is anion polymerizable, an anionic polymerization initiator may be used. Furthermore, when the inverse wavelength polymerizable liquid crystal compound is cation polymerizable, a cationic polymerization initiator may be used.

As the radical polymerization initiator, any of the following may be used: a thermal radical generator which is a compound for generating an active species capable of initiating polymerization of the inverse wavelength polymerizable liquid crystal compound by heating; and a photo radical generator which is a compound for generating an active species capable of initiating polymerization of the inverse wavelength polymerizable liquid crystal compound by exposure to exposing light such as visible light, UV light (such as i rays), far-UV light, electron beams, and X-rays. Among these, a photo radical generator is suitable as the radical polymerization initiator.

Examples of the photo radical generator may include an acetophenone-based compound, a biimidazole-based compound, a triazine-based compound, an O-acyloxime-based compound, an onium salt-based compound, a benzoin-based compound, a benzophenone-based compound, an $\alpha$-diketone-based compound, a polynuclear quinone-based compound, a xanthone-based compound, a diazo-based compound, and an imide sulfonate-based compound. These compounds are capable of generating an active radical, an active acid, or both of an active radical and an active acid, by exposure to light.

Specific examples of the acetophenone-based compound may include 2-hydroxy-2-methyl-1-phenylpropan-1-one, 2-methyl-1-[4-(methylthio)phenyl]-2-morpholinopropan-1-one, 2-benzyl-2-dimethylamino-1-(4-morpholinophenyl)-butan-1-one, 1-hydroxycyclohexyl phenyl ketone, 2,2-dimethoxy-1,2-diphenylethan-1-one, 1,2-octanedione, and 2-benzyl-2-dimethylamino-4'-morpholinobutyrophenone.

Specific examples of the biimidazole-based compound may include 2,2'-bis(2-chlorophenyl)-4,4',5,5'-tetrakis(4-ethoxycarbonylphenyl)-1,2'-biimidazole, 2,2'-bis(2-bromophenyl)-4,4',5,5'-tetrakis(4-ethoxycarbonylphenyl)-1,2'-biimidazole, 2,2'-bis(2-chlorophenyl)-4,4',5,5'-tetraphenyl-1,2'-biimidazole, 2,2'-bis(2,4-dichlorophenyl)-4,4',5,5'-tetraphenyl-1,2'-biimidazole, 2,2'-bis(2,4,6-trichlorophenyl)-4,4',5,5'-tetraphenyl-1,2'-biimidazole, 2,2'-bis(2-bromophenyl)-4,4',5,5'-tetraphenyl-1,2'-biimidazole, 2,2'-bis(2,4-dibromophenyl)-4,4',5,5'-tetraphenyl-1,2'-biimidazole, and 2,2'-bis(2,4,6-tribromophenyl)-4,4',5,5'-tetraphenyl-1,2'-biimidazole.

When a biimidazole-based compound is used as a polymerization initiator, a hydrogen donor may be used in combination with the biimidazole-based compound, for further enhancing sensitivity. Here, the "hydrogen donor" means

a compound which is capable of providing a hydrogen atom to a radical generated from the biimidazole-based compound by exposure to light. As the hydrogen donor, a mercaptan-based compound and an amine-based compound, which will be exemplified later, are preferable.

Examples of the mercaptane-based compound may include 2-mercaptobenzothiazole, 2-mercaptobenzoxazole, 2-mercaptobenzimidazole, 2,5-dimercapto-1,3,4-thiadiazole, and 2-mercapto-2,5-dimethylaminopyridine. Examples of the amine-based compound may include 4,4'-bis(dimethylamino)benzophenone, 4,4'-bis(diethylamino)benzophenone, 4-diethylaminoacetophenone, 4-dimethylaminopropiophenone, ethyl-4-dimethylaminobenzoate, 4-dimethylaminobenzoic acid, and 4-dimethylaminobenzonitrile.

Examples of the triazine-based compound may include a triazine-based compound having a halomethyl group, such as 2,4,6-tris(trichloromethyl)-s-triazine, 2-methyl-4,6-bis(trichloromethyl)-s-triazine, 2-[2-(5-methylfuran-2-yl)ethenyl]-4,6-bis(trichloromethyl)-s-triazine, 2-[2-(furan-2-yl)ethenyl]-4,6-bis(trichloromethyl)-s-triazine, 2-[2-(4-diethylamino-2-methylphenyl)ethenyl]-4,6-bis(trichloromethyl)-s-triazine, 2-[2-(3,4-dimethoxyphenyl)ethenyl]-4,6-bis(trichloromethyl)-s-triazine, 2-(4-methoxyphenyl)-4,6-bis(trichloromethyl)-s-triazine, 2-(4-ethoxystyryl)-4,6-bis(trichloromethyl)-s-triazine, and 2-(4-n-butoxyphenyl)-4,6-bis(trichloromethyl)-s-triazine.

Specific examples of the O-acyl oxime-based compound may include 1-[4-(phenylthio)phenyl]-heptane-1,2-dione 2-(O-benzoyloxime), 1-[4-(phenylthio)phenyl]-octane-1,2-dione 2-(O-benzoyloxime), 1-[4-(benzoyl)phenyl]-octane-1,2-dione 2-(O-benzoyloxime), 1-[9-ethyl-6-(2-methylbenzoyl)-9H-carbazol-3-yl]-ethanone 1-(O-acetyloxime), 1-[9-ethyl-6-(3-methylbenzoyl)-9H-carbazol-3-yl]-ethanone 1-(O-acetyloxime), 1-(9-ethyl-6-benzoyl-9H-carbazol-3-yl)-ethanone 1-(O-acetyloxime), ethanone-1-[9-ethyl-6-(2-methyl-4-tetrahydrofuranylbenzoyl)-9.H.-carbazol-3-yl]-1-(O-acetyloxime), ethanone-1-[9-ethyl-6-(2-methyl-4-tetrahydropyranylbenzoyl)-9.H.-carbazol-3-yl]-1-(O-acetyloxime), ethanone-1-[9-ethyl-6-(2-methyl-5-tetrahydrofuranylbenzoyl)-9.H.-carbazol-3-yl]-1-(O-acetyloxime), ethanone-1-[9-ethyl-6-(2-methyl-5-tetrahydropyranylbenzoyl)-9.H.-carbazol-3-yl]-1-(O-acetyloxime), ethanone-1-[9-ethyl-6-{2-methyl-4-(2,2-dimethyl-1,3-dioxolanyl)benzoyl}-9.H.-carbazol-3-yl]-1-(O-acetyloxime), ethanone-1-[9-ethyl-6-(2-methyl-4-tetrahydrofuranylmethoxybenzoyl)-9.H.-carbazol-3-yl]-1-(O-acetyloxime), ethanone-1-[9-ethyl-6-(2-methyl-4-tetrahydropyranylmethoxybenzoyl)-9.H.-carbazol-3-yl]-1-(O-acetyloxime), ethanone-1-[9-ethyl-6-(2-methyl-5-tetrahydrofuranylmethoxybenzoyl)-9.H.-carbazol-3-yl]-1-(O-acetyloxime), ethanone,1-[9-ethyl-6-(2-methylbenzoyl)-9H-carbazol-3-yl]-1-(O-acetyloxime), ethanone-1-[9-ethyl-6-(2-methyl-5-tetrahydropyranylmethoxybenzoyl)-9.H.-carbazol-3-yl]-1-(O-acetyloxime), and ethanone-1-[9-ethyl-6-{2-methyl-4-(2,2-dimethyl-1,3-dioxolanyl)methoxybenzoyl}-9.H.-carbazol-3-yl]-1-(O-acetyloxime).

As the photo-radical generator, a commercially available product as it is may be used. Specific examples thereof may include trade name: Irgacure907, Irgacure184, Irgacure369, Irgacure651, Irgacure819, Irgacure907, Irgacure379, and Irgacure OXE02, available from BASF, and trade name: ADEKA OPTOMER N1919 available from ADEKA

CORPORATION.

Examples of the anionic polymerization initiator may include an alkyl lithium compound; a monolithium salt or a monosodium salt of biphenyl, naphthalene, and pyrene; and a polyfunctional initiator such as a dilithium salt, and a trilithium salt.

Examples of the cationic polymerization initiator may include a protonic acid, such as sulfuric acid, phosphoric acid, perchloric acid, and trifluoromethanesulfonic acid; Lewis acids, such as boron trifluoride, aluminum chloride, titanium tetrachloride, and tin tetrachloride; and an aromatic onium salt, and a combination of an aromatic onium salt with a reducing agent.

As the polymerization initiator, one type thereof may be solely used, and two or more types thereof may also be used in combination at any ratio.

The amount of the polymerization initiator with respect to 100 parts by weight of the inverse wavelength polymerizable liquid crystal compound is preferably 0.1 parts by weight or more, and more preferably 0.5 parts by weight or more, and is preferably 30 parts by weight or less, and more preferably 10 parts by weight or less. When the amount of the polymerization initiator falls within the aforementioned range, the polymerization of the inverse wavelength polymerizable liquid crystal compound can efficiently proceed.

Furthermore, examples of the optional component which may be contained in the liquid crystal composition may include additives such as: a polymerizable compound other than the inverse wavelength polymerizable liquid crystal compound; metal; a metal complex; a metal oxide such as titanium oxide; a coloring agent such as a dye and a pigment; a luminescent material such as a fluorescent material and a phosphorescent material; a leveling agent; a thixotropic agent; a gelator; polysaccharides; a UV absorber; an IR absorber; an antioxidant; and an ion exchange resin. As the optional component, one type thereof may be solely used, and two or more types thereof may also be used in combination at any ratio.

The amount of the additive may be appropriately set within the range that does not impair the effects of the present invention. The specific amount of each additive with respect to 100 parts by weight of the inverse wavelength

polymerizable liquid crystal compound may be 0.1 parts by weight to 20 parts by weight.

The liquid crystal composition may be produced by mixing the aforementioned components.

[4. Coating Process]

In the method for producing a multilayer film according to the present invention, a step (coating step) of coating the coating surface of the substrate with the liquid crystal composition to form a layer of the liquid crystal composition is performed. At this time, the liquid crystal composition is directly applied onto the coating surface of the substrate. Here, "directly" coating the coating surface with the liquid crystal composition refers to coating in which there is no any other layer between the layer of the liquid crystal composition formed by coating and the coating surface of the substrate.

Examples of a method for applying the liquid crystal composition may include a curtain coating method, an extrusion coating method, a roll coating method, a spin coating method, a dip coating method, a bar coating method, a spray coating method, a slide coating method, a print coating method, a gravure coating method, a die coating method, a cap coating method, and a dipping method. The thickness of the layer of the applied liquid crystal composition may be appropriately set depending on the thickness required of the optically anisotropic layer.

In the method for producing a multilayer film according to the present invention, coating properties when coating the coating surface of the substrate with the liquid crystal composition is favorable. Specifically, since the coating adherence of the liquid crystal composition onto the coating surface of the substrate is favorable, the applied liquid crystal composition can be stably fixed onto the coating surface of the substrate. Further, since cissing properties of the liquid crystal composition on the coating surface of the substrate is small, generation of a cissing portion in the layer of the liquid crystal composition can be suppressed.

The aforementioned coating adherence and cissing properties may be evaluated by the following methods.

(Coating Adherence)

Fig. 1 is a cross-sectional view which schematically illustrates an example of a liquid crystal composition layer 200 immediately after a coating surface 110 of a substrate 100 was coated with a liquid crystal composition. Fig. 2 is a cross-sectional view which schematically illustrates an example of a liquid crystal composition layer 200 after the time has elapsed since a coating surface 110 of a substrate 100 was coated with a liquid crystal composition. Furthermore, Fig. 3 is a cross-sectional view which schematically illustrates an example of a liquid crystal composition layer 200 after the time has elapsed since a coating surface 110 of a substrate 100 was coated with a liquid crystal composition.

As illustrated in Fig. 1, when a coating surface 110 of a substrate 100 is coated with a liquid crystal composition, a liquid crystal composition layer 200 is formed on the coating surface 110. The position of an outer edge 210 of an area onto which the liquid crystal composition was applied at the time immediately after the liquid crystal composition was applied is referred to as a "coating adherence position 120".

When the coating adherence of the liquid crystal composition onto the coating surface 110 is favorable, the liquid crystal composition tends to fit with the coating surface 110. Accordingly, the liquid crystal composition tends to remain in the region where it was placed immediately after applied, as illustrated in Fig. 1, or to spread out from the region where it was placed immediately after applied, as illustrated in Fig. 2. Therefore, after the time has elapsed, the outer edge 210 of the liquid crystal composition layer 200 usually remains at the coating adherence position 120, or moves outward from the coating adherence position 120.

On the other hand, when the coating adherence of the liquid crystal composition onto the coating surface 110 is poor, the liquid crystal composition does not tend to fit with the coating surface 110. Accordingly, the liquid crystal composition tends to be repelled on the coating surface 110 and gather, as illustrated in Fig. 3. Therefore, after the time has elapsed, the outer edge 210 of the liquid crystal composition layer 200 usually moves inward from the coating adherence position 120. When the coating adherence of the liquid crystal composition becomes further poor, the liquid crystal composition is sometimes repelled on the coating surface 110 all over the region onto which the liquid crystal composition was applied, such that the liquid crystal composition layer 200 is divided into a plurality of portions.

Therefore, the coating adherence may be evaluated by observing the optically anisotropic layer of the produced multilayer film on the basis of the relationship between the edge of the optically anisotropic layer and the coating adherence position of the liquid crystal composition. Specifically, the optically anisotropic layer may be observed by the following method.

A multilayer film is cut out to obtain a sample piece having a specific size (for example, 16 cm square). On a light table, two linear polarizers (a polarizer and an analyzer) are stacked in such a state that the polarized light absorption axes of these linear polarizers are parallel to each other (parallel nicols). The aforementioned sample piece is placed between these linear polarizers in such a direction that the slow axis of the sample piece forms an angle of 45° with respect to the polarized light absorption axes of the linear polarizers. The optically anisotropic layer may be observed by visually inspecting light which is emitted from the light table and passes through the linear polarizer, the test piece,

and the linear polarizer.

(Cissing Properties)

Fig. 4 is a perspective view schematically illustrating an example of a liquid crystal composition layer 200 in which a cissing portion 220 is generated by a foreign substance 130 adhering to a coating surface 110 of a substrate 100.
When the foreign substance 130 such as dirt, dust, and soil adheres to the coating surface 110 of the substrate 100, the liquid crystal composition applied onto the coating surface 110 is repelled by the foreign substance 130. Therefore, a cissing portion 220 in which the liquid crystal composition cannot stay on the coating surface 110 is usually formed on the periphery of the foreign substance 130 in the region onto which the liquid crystal composition was applied. A size D of this cissing portion 220 tends to be larger as the properties of the coating surface 110 repelling the liquid crystal composition are stronger.
Therefore, the cissing properties can be evaluated on the basis of the size of the cissing portion, by observing the optically anisotropic layer of the produced multilayer film and measuring the size of the cissing portion generated by a foreign substance in the region onto which the liquid crystal composition was applied. For this evaluation, the optically anisotropic layer may be observed by the same method as that having been illustrated in the description of the method for evaluating the coating adherence.

[5. Orienting Process]

After the layer of the liquid crystal composition is formed, a step (orienting step) of orienting the inverse wavelength polymerizable liquid crystal compound contained in the layer is usually performed. By the orienting treatment, such as heating, to the layer of the liquid crystal composition, the inverse wavelength polymerizable liquid crystal compound can be oriented in a direction in accordance with the orientation regulating force of the substrate. For example, when a substrate formed of a resin containing an alicyclic structure-containing polymer is used, homogeneous orientation along a direction which is approximately the same as the slow axis direction of the substrate may be achieved by the orienting step. The conditions for the orienting treatment may be appropriately set depending on properties of the liquid crystal composition to be used. A specific example of the conditions of the orienting treatment may be a temperature of 50°C to 160°C for 30 seconds to 5 minutes.
However, orientation of the inverse wavelength polymerizable liquid crystal compound may be instantly achieved by coating with the liquid crystal composition in some cases. In that case, the orienting step proceeds without an orienting treatment. Therefore, an orienting treatment for orienting the inverse wavelength polymerizable liquid crystal compound may not be necessarily performed to the layer of the liquid crystal composition.

[6. Polymerization Process]

After the inverse wavelength polymerizable liquid crystal compound is oriented, there is performed a step (polymerization step) of polymerizing the inverse wavelength polymerizable liquid crystal compound to obtain the optically anisotropic layer. As the method for the polymerization of the inverse wavelength polymerizable liquid crystal compound, a method which is suited for the properties of the components contained in the liquid crystal composition may be selected. Examples of the polymerization method may include an active energy ray irradiation method and a thermopolymerization method. Among these, the active energy ray irradiation method is preferable, because heating is not required, and a polymerization reaction can proceed at room temperature. Active energy rays to be irradiated with may include lights such as visible light, UV light, and IR light, as well as any energy rays such as electron beams.
Among these, a method of irradiating with light such as UV light is preferable, because the operation is simple. The temperature during the irradiation with UV light is preferably equal to or lower than the glass transition temperature of the substrate, preferably 150°C or lower, more preferably 100°C or lower, and particularly preferably 80°C or lower. The lower limit of the temperature during the irradiation with UV light may be 15°C or higher. The irradiation intensity of UV light is preferably 0.1 $mW/cm^2$ or more, and more preferably 0.5 $mW/cm^2$ or more, and is preferably 1000 $mW/cm^2$ or less, and more preferably 600 $mW/cm^2$ or less.

[7. Optional Step]

The method for producing a multilayer film according to the present invention may further include an optional step in addition to the aforementioned steps. For example, the production method may include a step of drying the layer of the liquid crystal composition as necessary, after the coating step or the orienting step and before the polymerization step. Such drying may be achieved by air drying, heat drying, drying under reduced pressure, heat drying under reduced pressure, and the like. By such drying, the solvent can be removed from the layer of the liquid crystal composition.

[8. Multilayer Film]

By the aforementioned production method, a multilayer film which includes a substrate and an optically anisotropic layer formed on a coating surface of this substrate may be obtained. According to the aforementioned production method, the coating properties when coating the coating surface of the substrate with the liquid crystal composition is favorable. Therefore, the optically anisotropic layer obtained by curing the layer of the liquid crystal composition through the polymerization of the inverse wavelength polymerizable liquid crystal compound is stably formed on the region onto which the liquid crystal composition has been applied. Thus, according to the aforementioned production method, the yields of the multilayer film can be improved, and productivity can thereby be improved. Furthermore, since the cissing of the liquid crystal composition on the coating surface can be suppressed, the thickness of the layer of the liquid crystal composition can become uniform. Thus, the thickness of the optically anisotropic layer can be uniform.

The optically anisotropic layer includes a polymer obtained by polymerizing the inverse wavelength polymerizable liquid crystal compound. Since this polymer is obtained by polymerizing the inverse wavelength polymerizable liquid crystal compound while maintaining the molecular orientation in the liquid crystal phase, the polymer has homogeneous orientation regularity.

The orientation regularity of the polymer usually results in being along a direction in accordance with the orientation regulating force of the substrate. For example, when the substrate is formed of a resin including an alicyclic structure-containing polymer, the substrate has an orientation regulating force which causes the inverse wavelength polymerizable liquid crystal compound to be oriented in a direction parallel to the slow axis of the substrate. Therefore, in a multilayer film produced with the substrate formed of the resin including an alicyclic structure-containing polymer, the polymer obtained by polymerizing the inverse wavelength polymerizable liquid crystal compound has homogeneous orientation regularity along a direction which is approximately the same as the direction of the slow axis of the substrate.

Here, "having homogeneous orientation regularity" refers to that the long axis directions of mesogenes among molecules of a polymer are aligned with one direction which is parallel to the surface of the optically anisotropic layer. The homogeneous orientation regularity "along" a certain direction refers to that the aligned direction is the certain direction. Furthermore, the orientation along "approximately" the same direction as the direction of the slow axis of the substrate refers to that an angle formed between the direction of the slow axis of the substrate and the aligned direction of mesogenes is usually within 5° or less, preferably 3° or less, and more preferably 1° or less.

The long axis direction of mesogenes among the molecules of the aforementioned polymer obtained by polymerizing the inverse wavelength polymerizable liquid crystal compound becomes the long axis direction of the mesogenes of the inverse wavelength polymerizable liquid crystal compound which corresponds to the polymer. Furthermore, when a plurality of mesogenes each having a different orientation direction exist in the optically anisotropic layer, like in the case in which a compound (I) is used as the inverse wavelength polymerizable liquid crystal compound, the aligned direction of the longest mesogene becomes the aforementioned aligned direction.

Such an optically anisotropic layer usually has a slow axis which is parallel to the aligned direction of the aforementioned polymer, in correspondence with the orientation regularity of the aforementioned polymer obtained by polymerizing the inverse wavelength polymerizable liquid crystal compound. Whether or not the aforementioned polymer obtained by polymerizing the inverse wavelength polymerizable liquid crystal compound has homogeneous orientation regularity, and the aligned direction of the polymer may be confirmed by the measurement of the slow axis direction and the measurement of a retardation distribution for each incident angle in the slow axis direction, using a retardation meter represented by AxoScan (manufactured by Axometrics, Inc.).

Since the optically anisotropic layer includes the polymer obtained by polymerizing the inverse wavelength polymerizable liquid crystal compound, it has an inverse wavelength dispersion birefringence. Accordingly, the optically anisotropic layer can have an inverse wavelength dispersion retardation. The inverse wavelength dispersion retardation herein refers to a retardation in which a retardation Re(450) at a wavelength of 450 nm, a retardation Re(550) at a wavelength of 550 nm, and a retardation Re(650) at a wavelength of 650 nm usually satisfy the following formula (D3), and preferably satisfy the following formula (D4). With the inverse wavelength dispersion retardation, the optically anisotropic layer can uniformly express its function in a wide band, in optical uses such as a 1/4 wave plate and a 1/2 wave plate.

$$Re(450) < Re(650) \quad (D3)$$

$$Re(450) < Re(550) < Re(650) \quad (D4)$$

The specific range of the retardation of the optically anisotropic layer may be optionally set depending on an intended use of the optically anisotropic layer. For example, when the optically anisotropic layer is intended to serve as

a 1/4 wave plate, the retardation Re(550) of the optically anisotropic layer is preferably 80 nm or more, more preferably 100 nm or more, and particularly preferably 120 nm or more, and is preferably 180 nm or less, more preferably 160 nm or less, and particularly preferably 150 nm or less. As another example, when the optically anisotropic layer is intended to serve as a 1/2 wave plate, the retardation Re(550) of the optically anisotropic layer is preferably 245 nm or more, more preferably 265 nm or more, and particularly preferably 270 nm or more, and is preferably 305 nm or less, more preferably 285 nm or less, and particularly preferably 280 nm or less.

The thickness of the optically anisotropic layer may be appropriately set such that properties such as retardation are within desired ranges. Specifically, the thickness of the optically anisotropic layer is preferably 0.5 μm or more, and more preferably 1.0 μm or more, and is preferably 10 μm or less, and more preferably 7 μm or less.

The shape as well as the length and width of the optically anisotropic layer are not particularly limited. The shape may be a sheet piece shape or a long-length shape, in the same manner as the substrate.

[9. Uses]

The multilayer film produced by the aforementioned production method may be used as it is for any uses. Alternatively, the substrate may be peeled from the optically anisotropic layer so that only the optically anisotropic layer is used for any uses. Furthermore, the optically anisotropic layer may be bonded to any member to be used for any uses. As uses, optical uses are preferable. In particular, wave plates such as a 1/4 wave plate and a 1/2 wave plate are suitable.

For example, the wave plate may include only the optically anisotropic layer. Such a wave plate including only the optically anisotropic layer may be produced by, for example, peeling the optically anisotropic layer formed on a substrate from the substrate, and cutting the peeled optically anisotropic layer to a desired shape, such as a rectangular, depending on the use.

The wave plate may further include the substrate used for the production of the optically anisotropic layer, in addition to the optically anisotropic layer. As such a wave plate including the optically anisotropic layer and the substrate, for example, the optically anisotropic layer formed on the substrate is not peeled from the substrate, and the multilayer film including the substrate and the optically anisotropic layer may be used as it is as a wave plate.

Furthermore, the wave plate may include an optional layer other than the optically anisotropic layer and the substrate. Examples of such an optional layer may include an adhesive layer for bonding with another member, a mat layer for providing favorable sliding properties to a film, a hard coat layer such as an impact-resistant polymethacrylate resin layer, an antireflective layer, and an antifouling layer.

[10. Circularly Polarizing Plate]

With optical anisotropy layer included in the multilayer film produced by the aforementioned production method, a circularly polarizing plate may be produced.

This circularly polarizing plate includes a linear polarizer and an optically anisotropic layer.

As the linear polarizer, a known linear polarizer used in devices such as a liquid crystal display device may be used. Examples of the linear polarizer may include a product obtained by adsorbing iodine or a dichroic dye to a poly(vinyl alcohol) film, and thereafter performing uniaxial stretching in a boric acid bath; and a product obtained by adsorbing iodine or a dichroic dye to a poly(vinyl alcohol) film, performing stretching, and further modifying portion of a poly(vinyl alcohol) unit in the molecular chain into a polyvinylene unit. Other examples of the linear polarizer may include a polarizer having a function of separating polarized light into reflected light and transmitted light, such as a grid polarizer, a multilayer polarizer, and a cholesteric liquid crystal polarizer. Among these, a polarizer containing poly(vinyl alcohol) is preferable.

When natural light enters a linear polarizer, only one polarized light passes through the liner polarizer. The polarization degree of the linear polarizer is preferably 98% or more, and more preferably 99% or more. The average thickness of the linear polarizer is preferably 5 μm to 80 μm.

The optically anisotropic layer preferably has an appropriate retardation so that it can function as a 1/4 wave plate. The angle formed between the slow axis of the optically anisotropic layer and the transmission axis of the linear polarizer is preferably 45° or an angle close to 45°, and specifically preferably 40° to 50°, when viewed from the thickness direction.

One of the uses of such a circularly polarizing plate may be a use as an antireflective film for display devices such as an organic electroluminescent display device. When the circularly polarizing plate is disposed on the surface of a display device such that the surface on the linear polarizer side is directed to the viewing side, incident light from the outside of the device can be inhibited from reflecting in the device to exit toward the outside of the device. As a result, glare on the display surface of the display device can be suppressed. Specifically, only linearly polarized light which is part of the light having entered from the outside of the device passes through the linear polarizer, and subsequently passes through the optically anisotropic layer thereby to become circularly polarized light. The circularly polarized light

is reflected on a constituent which reflects the light in the device (such as a reflective electrode), and passes through the optically anisotropic layer again, thereby to become linearly polarized light having its polarizing axis in a direction orthogonal to the polarizing axis of the incident linearly polarized light. Accordingly, the linearly polarized light does not pass through the linear polarizer. Thus, the function of antireflection is achieved.

The circularly polarizing plate may further include an optional layer, in addition to the linear polarizer and the optically anisotropic layer.

[Examples]

Hereinafter, the present invention will be specifically described with reference to Examples. However, the present invention is not limited to Examples described below. The present invention may be freely modified for implementation without departing from the scope of claims of the present invention and the scope of their equivalents.

Unless otherwise specified, "%" and "part(s)" that represent an amount in the following description are on the basis of weight. Unless otherwise specified, operations described below were performed under conditions of normal temperature and normal pressure. In the following description, a polymerizable liquid crystal compound that is capable of expressing forward wavelength dispersibility may be appropriately referred to as a "forward-wavelength polymerizable liquid crystal compound".

[Methods for Evaluation and Measurement]

<1. Method for Measuring Fluorine Atom Content in Surfactant>

The surfactant as a sample was weighted, and burned in a combustion tube of an analyzer. A gas generated by the burning was absorbed into a solution. After that, part of the absorbing liquid was analyzed by ion chromatography to measure the ratio of a fluorine atom in the molecule of the surfactant. The conditions for each step are as follows.

(1.1. Conditions for Burning and Absorption)

System: AQF-2100, GA-210 (manufactured by Mitsubishi Chemical Corporation)
Electric furnace temperature: 900°C at inlet, 1000°C at outlet
Gas: $Ar/O_2$, 200 mL/min
$O_2$ 400 mL/min
Absorbing liquid: solvent $H_2O_2$ 90 μg/mL,
Internal standard material P 4 μg/mL or Br 8 μg/mL
Absorbing liquid volume: 20 mL

(1.2. Conditions for Ion Chromatography and Anion Analysis)

System: ICS1600 (manufactured by Dionex)
Mobile phase: 2.7 mmol/L $Na_2CO_3$ / 0.3 mmol/L $NaHCO_3$
Flow velocity: 1.50 mL/min
Detector: electric conductivity detector
Injection volume: 20 μL

<2. Method for Measuring Surface Free Energy of Surface of Substrate>

The substrate is cut out to obtain a substrate piece having a size of an approximately 10 cm square. On the surface of this substrate piece, the contact angle of pure water ($H_2O$) and the contact angle of diiodomethane ($CH_2I_2$) were actually measured using an automatic contact angle meter. From the data of contact angles measured in this manner, the surface free energy of the surface of the substrate was calculated using software attached to the contact angle meter. The conditions for the measurement are as follows.

(2.1. Measurement of Contact Angles)

System: DropMaster700 (manufactured by Kyowa Interface Science Co., Ltd.)
Auto Dispenser AD-31 (manufactured by Kyowa Interface Science Co., Ltd.)
Control analysis software: FAMAS ver. 3.13
Contact angle measurement method: pendant drop method
Visual field: STD
Analysis method: Young-Laplace method
Teflon (registered trademark) coated needle: 18G (or 22G)
Liquid volume: 3 μL to 4 μL
Measurement waiting time: 1000 ms
Number of measurement: n = 10 measurements, average value

(2.2. Method for Calculating Surface Free energy)

Analysis software: FAMAS ver. 3.13
Analytical theory name: Owens-Wendt

<3. Method for Measuring Surface Tension of Coating Liquid>

Approximately 5 ml to 10 ml of the coating liquid was poured in a petri dish attached to a measuring device, up to the normal solution line of the petri dish. After that, the surface tension of the coating liquid was measured under an environment of 25°C in temperature and 60% in humidity by the Wilhelmy method (plate method, vertical plate method).

System: DY-200 (manufactured by Kyowa Interface Science Co., Ltd.)
Probe: platinum plate
Number of measurement: n = 3 measurements, average value

<4. Method for Evaluating Coating Adherence and Cissing of Liquid Crystal Composition>

The multilayer film including the stretched substrate and the optically anisotropic layer was cut out to obtain a sample piece having a specific size (for example, 16 cm square).

On a light table, two linear polarizers (a polarizer and an analyzer) were stacked in such a state that the polarized light absorption axes of these linear polarizers are parallel to each other (parallel nicols). The aforementioned sample piece was placed between these linear polarizers in such a direction that the slow axis of the sample piece forms an angle of 45° with respect to the polarized light absorption axes of the linear polarizers. Then, the coating liquid as the liquid crystal composition was visually observed to evaluate the coating adherence and cissing properties according to the following criteria.

(4.1. Coating Adherence)

"I": The edge of the optically anisotropic layer is located at or outside a desired coating adherence position.
"II": The edge of the optically anisotropic layer is apparently inside a desired coating adherence position.
"III": The coating liquid is repelled all over the area onto which the coating liquid was applied, and the optically anisotropic layer is divided into a plurality of parts.
"IV": Cissing of the coating liquid is significant without coating adherence to the substrate at all, and the optically anisotropic layer is divided into a plurality of parts all over the surface.

(4.2. Cissing Properties)

"I": The size of the cissing portion attributable to a foreign substance on the coating surface is 0.5 mm or less in diameter.
"II": The size of the cissing portion attributable to a foreign substance on the coating surface is more than 0.5 mm and 5 mm or less in diameter.
"III": The size of the cissing portion attributable to a foreign substance on the coating surface is more than 5 mm in diameter.
"IV": Since coating adherence is poor with a cissing portion formed all over the coating surface, the size of the cissing portion cannot be discussed.

<5. Method for Measuring In-Plane Retardation of Optically Anisotropic Layer>

The optically anisotropic layer of the multilayer film was bonded to a glass plate. Then, the stretched substrate was peeled from this optically anisotropic layer to obtain a sample including the glass plate and the optically anisotropic layer. With this sample, the in-plane retardation Re at each of wavelengths of 450 nm, 550 nm, and 650 nm of the optically anisotropic layer was measured using a poralimeter ("AxoScan" manufactured by Axometrics, Inc.).

[Example 1: Production of Multilayer Film with Liquid Crystal Composition Containing Inverse Wavelength Polymerizable Liquid Crystal Compound]

<1-1. Production of Pre-stretch Substrate>

A thermoplastic norbornene resin pellet ("ZEONOR 1420R" manufactured by ZEON Corporation) was dried at 90°C for 5 hours. The dried pellet was supplied to an extruder, and melted in the extruder. The melted pellet was passed through a polymer pipe and a polymer filter, extruded from a T die on a casting drum into a sheet shape, and cooled. Thus, a long-length pre-stretch substrate having a thickness of 60 μm and a width of 1490 mm was produced.
The pre-stretch substrate thus produced was wound up to obtain a roll.

<1-2. Stretching Treatment>

The pre-stretch substrate was drawn from the roll, and supplied to a tenter stretching machine. Then, using the tenter stretching machine, stretching was performed such that the slow axis of the stretched substrate obtained after the stretching forms an angle of 45° with respect to the winding-up direction of the stretched substrate. Furthermore, the film was trimmed at both ends in the widthwise direction thereof. Then, the film was wound up to obtain a roll of the stretched long-length substrate having a width of 1350 mm. The in-plane retardation Re at a measurement wavelength of 550 nm of the obtained stretched substrate was 148 nm, and the film thickness was 47 μm.

<1-3. Production of Liquid Crystal Composition>

100.0 parts of an inverse wavelength polymerizable liquid crystal compound (A), 0.30 parts of a surfactant ("Surflon S243" manufactured by AGC Seimi Chemical Co., Ltd.) and 3.0 parts of a polymerization initiator ("IRGACURE 379EG" manufactured by BASF), as well as 188.0 parts of cyclopentanone (manufactured by ZEON Corporation) and 282.0 parts of 1,3-dioxolane (manufactured by Toho Chemical Industry Co., Ltd.) as a solvent were mixed. Thus, a coating liquid (L1) as the liquid crystal composition was produced.

(1-4. Production of Multilayer Film)

The stretched substrate was drawn from the roll, and subjected to the following step while being delivered in the lengthwise direction. First, the coating liquid (L1) was applied onto one surface (coating surface) of the stretched substrate drawn from the roll using a die coater to form a layer of the coating liquid (L1). At this time, the coating liquid (L1) was selectively applied onto only a desired area on the stretched substrate surface (specifically, an area approximately 10 mm or more inside from both edges of the stretched substrate). After that, the layer of the coating liquid (L1) was subjected to an orienting treatment at 110°C for 4 minutes, so that the inverse wavelength polymerizable liquid crystal compound contained in the layer of the coating liquid (L1) was oriented. After that, the layer was irradiated with UV light at 400 $mJ/cm^2$ under $N_2$ atmosphere for polymerizing the inverse wavelength polymerizable liquid crystal compound. Consequently, there was obtained a multilayer film which includes a stretched substrate and an optically anisotropic layer which contained a polymer obtained by polymerizing the inverse wavelength polymerizable liquid crystal compound formed on the stretched substrate. The dry film thickness of the optically anisotropic layer was 2.2 μm.
In the optically anisotropic layer of the multilayer film obtained in this manner, it was confirmed by the following

method using a poralimeter ("AxoScan" manufactured by Axometrics, Inc.) that the polymer obtained by polymerizing the inverse wavelength polymerizable liquid crystal compound is homogeneously oriented.

The slow axis direction of the optically anisotropic layer was measured. The slow axis of the optically anisotropic layer formed an angle of 45° with respect to the winding-up direction, in the same manner as the stretched substrate. Subsequently, the in-plane retardation Re at each incident angle in this slow axis direction was measured every 10° within the incident angle range of -70° to 70°. The measurement wavelength was 550 nm. When the in-plane retardation Re at a minus incident angle and the in-plane retardation Re at a plus incident angle are substantially symmetrical about an incident angle of 0°, it can be said that the polymer obtained by polymerizing the inverse wavelength polymerizable liquid crystal compound is homogeneously oriented. Regarding the optically anisotropic layer obtained in Example 1, the in-plane retardation Re at each incident angle was symmetrical about an angle 0°. Thus, it was confirmed that the optically anisotropic layer was homogeneously oriented.

The in-plane retardation Re of the optically anisotropic layer of the obtained multilayer film was measured, and the result was in-plane retardation Re(450) at a measurement wavelength of 450 nm = 111 nm, in-plane retardation Re(550) at a measurement wavelength of 550 nm = 140 nm, and in-plane retardation Re(650) at a measurement wavelength of 650 nm = 145 nm. From this result, it was confirmed that the birefringence $\Delta n$ of the inverse wavelength polymerizable liquid crystal compound (A) used in Example 1 had properties that it became larger as the measurement wavelength was larger (inverse wavelength dispersibility).

[Examples 2 to 9 and Comparative Examples 1 and 2: Examples and Comparative Examples Using Inverse wavelength Polymerizable Liquid Crystal Compound]

The type of (i) the inverse wavelength polymerizable liquid crystal compound used for preparing the liquid crystal composition, and the type of (ii) the surfactant were changed as illustrated in Table 1. A multilayer film including a stretched substrate and an optically anisotropic layer was produced in the same manner as that in Example 1 except for the aforementioned matters.

The optically anisotropic layer contained in the produced multilayer film contained the polymer that was obtained by polymerizing the inverse wavelength polymerizable liquid crystal compound with homogeneous orientation regularity. The angle of the slow axis of the optically anisotropic layer formed an angle of 45° with respect to the winding-up direction. Furthermore, the in-plane retardation Re of the optically anisotropic layer was measured, and it was confirmed that the birefringence $\Delta n$ of the inverse wavelength polymerizable liquid crystal compound used had properties that it became larger as the measurement wavelength was larger (inverse wavelength dispersibility).

[Comparative Example 3: Production of Multilayer Film with Liquid Crystal Composition Containing Forward-Wavelength Polymerizable Liquid Crystal Compound]

<C3-1. Production of Liquid Crystal Composition>

100.0 parts of a forward-wavelength polymerizable liquid crystal compound (LS242) ("LC242" manufactured by BASF), 0.30 parts of a surfactant ("Surflon S243" manufactured by AGC Seimi Chemical Co., Ltd.), and 3.0 parts of a polymerization initiator ("IRGACURE 379EG" manufactured by BASF), as well as 188.0 parts of cyclopentanone (manufactured by ZEON Corporation) and 282.0 parts of 1,3-dioxolane (manufactured by Toho Chemical Industry Co., Ltd.) as a solvent were mixed. Thus, a coating liquid (L2) as the liquid crystal composition was produced.

<C3-2. Production of Multilayer Film>

The stretched substrate produced in Example 1 was prepared. This stretched substrate was drawn from the roll, and subjected to the following step while being delivered in the lengthwise direction. First, the coating liquid (L2) was applied onto one surface (coating surface) of the stretched substrate drawn from the roll using a die coater to form a layer of the coating liquid (L2). At this time, the coating liquid (L2) was selectively applied onto only a desired area on the stretched substrate surface (specifically, an area approximately 10 mm or more inside from both edges of the stretched substrate). After that, the layer of the coating liquid (L2) was subjected to an orienting treatment at 100°C for 2 minutes, so that the forward-wavelength polymerizable liquid crystal compound contained in the layer of the coating liquid (L2) was oriented. After that, the layer was irradiated with UV light at 400 $mJ/cm^2$ or more under $N_2$ atmosphere for polymerizing the forward-wavelength polymerizable liquid crystal compound. Consequently, there was obtained a multilayer film which included the stretched substrate and an optically anisotropic layer containing the polymer obtained by polymerizing the forward-wavelength polymerizable liquid crystal compound formed on the stretched substrate. The dry film thickness of the optically anisotropic layer was 1.2 $\mu$m. Regarding the optically anisotropic layer of the multilayer obtained in this manner, it was confirmed by a method that is the same as that in Example 1 that the polymer obtained

by polymerizing the forward-wavelength polymerizable liquid crystal compound was homogeneously oriented. The angle of the slow axis of the optically anisotropic layer formed an angle of 45° with respect to the winding-up direction, in the same manner as the stretched substrate.

The in-plane retardation Re of the optically anisotropic layer of the obtained multilayer film was measured, and the result was in-plane retardation Re(450) at a measurement wavelength of 450 nm = 151 nm, in-plane retardation Re(550) at a measurement wavelength of 550 nm = 140 nm, and in-plane retardation Re(650) at a measurement wavelength of 650 nm = 136 nm. From this result, it was confirmed that the birefringence $\Delta n$ of the forward-wavelength polymerizable liquid crystal compound (LC242) used in Comparative Example 3 had properties that it became smaller as the measurement wavelength was larger (forward wavelength dispersibility).

[Comparative Examples 4 to 12: Comparative Examples Using Forward-Wavelength Polymerizable Liquid Crystal Compound]

The type of (i) the forward-wavelength polymerizable liquid crystal compound used for preparing the liquid crystal composition, and the type of (ii) the surfactant were changed as illustrated in Table 1. A multilayer film including a stretched substrate and an optically anisotropic layer was produced in the same manner as Comparative Example 3, except for the aforementioned matter.

The optically anisotropic layer contained in the produced multilayer film contained the polymer that was obtained by polymerizing the forward-wavelength polymerizable liquid crystal compound with homogeneous orientation regularity. The angle of the slow axis of the optically anisotropic layer formed an angle of 45° with respect to the winding-up direction. Furthermore, the in-plane retardation Re of the optically anisotropic layer was measured, and it was confirmed that the birefringence $\Delta n$ of the forward-wavelength polymerizable liquid crystal compound used had properties that it became smaller as the measurement wavelength was larger (forward wavelength dispersibility).

[Evaluation]

The fluorine atom content of the used surfactant and the surface tension of the coating liquid as the liquid crystal composition in each of the aforementioned Examples and Comparative Examples were measured by the aforementioned method. The results are shown in Table 1.

The surface free energy of the coating surface of the stretched substrate produced in Example 1 was measured by the aforementioned method. The result is shown in Table 2. In Table 2, the value of "Total $\gamma$" represents the surface free energy of the coating surface of the stretched substrate.

Furthermore, the coating adherence and the cissing properties of the multilayer film produced in each of the aforementioned Examples and Comparative Examples were evaluated by the aforementioned method. The results are shown in Table 1.

In Tables, meanings of the abbreviations are as follows.

Liquid crystal compound "A": inverse wavelength polymerizable liquid crystal compound represented by formula (A)
Liquid crystal compound "B": inverse wavelength polymerizable liquid crystal compound represented by formula (B)
Liquid crystal compound "C": inverse wavelength polymerizable liquid crystal compound represented by formula (C)
Liquid crystal compound "D": inverse wavelength polymerizable liquid crystal compound represented by formula (D)
Liquid crystal compound "E": inverse wavelength polymerizable liquid crystal compound represented by formula (E)
Liquid crystal compound "LC242": polymerizable liquid crystal compound capable of expressing forward wavelength dispersibility, represented by formula (F1) ("LC242" manufactured by BASF)
Liquid crystal compound "K35": polymerizable liquid crystal compound capable of expressing forward wavelength dispersibility, represented by formula (F2)

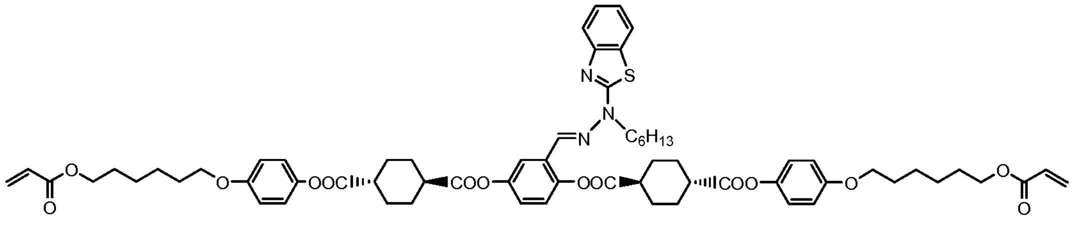

(A)

Inverse wavelength polymerizable liquid crystal compound (A)

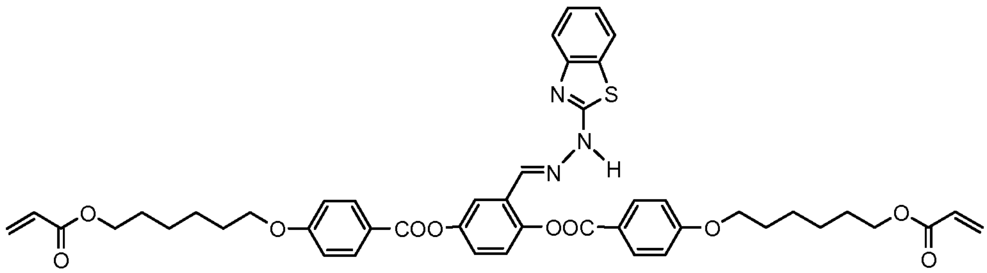

(B)

Inverse wavelength polymerizable liquid crystal compound (B)

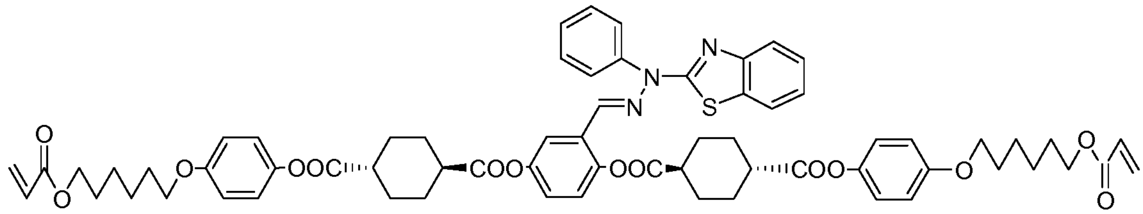

(C)

Inverse wavelength polymerizable liquid crystal compound (C)

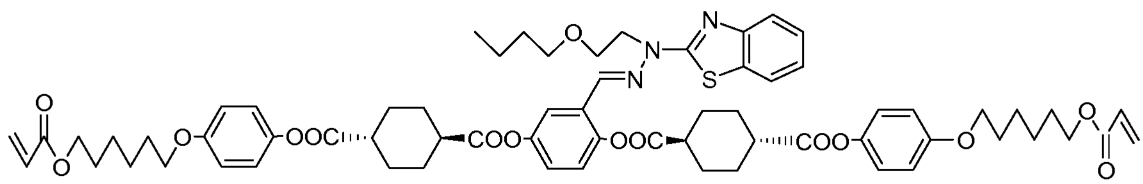

(D)

Inverse wavelength polymerizable liquid crystal compound (D)

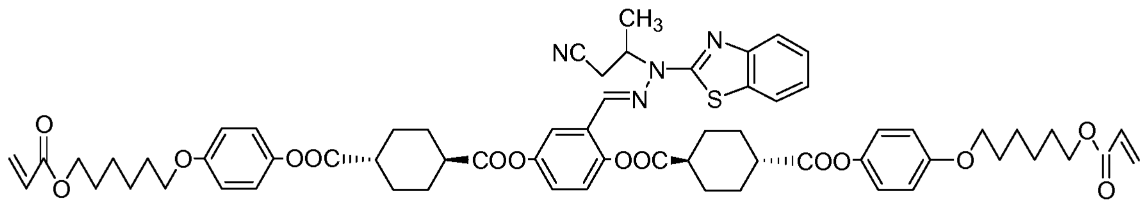

(E)

Inverse wavelength polymerizable liquid crystal compound (E)

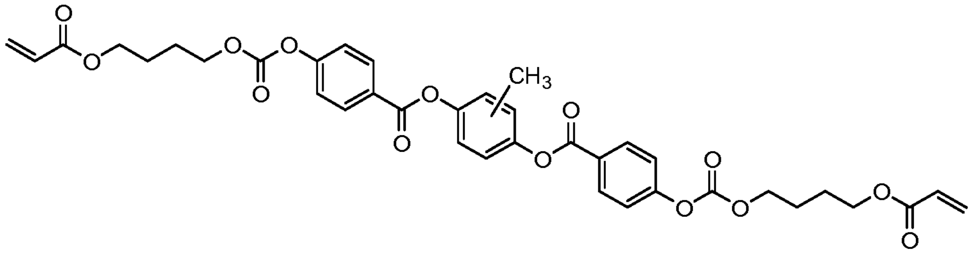

(F1)

Forward wavelength polymerizable liquid crystal compound (LC242)

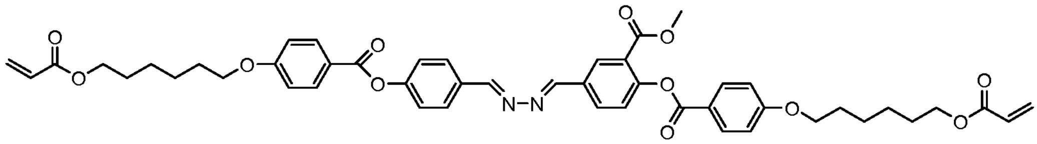

( F2 )

Forward wavelength polymerizable liquid crystal compound (K35)

Surfactant "S242": "Surflon S242" manufactured by AGC Seimi Chemical Co., Ltd.
Surfactant "S243": "Surflon S243" manufactured by AGC Seimi Chemical Co., Ltd.
Surfactant "S611": "Surflon S611" manufactured by AGC Seimi Chemical Co., Ltd.
Surfactant "208G": "Ftergent FTX-208G" manufactured by Neos Corporation
Surfactant "209F": "Ftergent FTX-209F" manufactured by Neos Corporation
Surfactant "FTX218": "Ftergent FTX-218" manufactured by Neos Corporation
Surfactant "601AD": "Ftergent FTX-601AD" manufactured by Neos Corporation
Surfactant F251": "Megaface F-251" manufactured by DIC Corporation
Surfactant "F444": "Megaface F-444" manufactured by DIC Corporation
Surfactant "F554": "Megaface F-554" manufactured by DIC Corporation
Surfactant "F556": "Megaface F-556" manufactured by DIC Corporation
Surfactant "F558": "Megaface F-558" manufactured by DIC Corporation
Surfactant "NS9013": "NS-9013" manufactured by Daikin Industries Ltd.
Surfactant "PF656": "PolyFox PF-656" manufactured by OMNOVA Solutions Inc.
Surfactant "PF6520": "PolyFox PF-6520" manufactured by OMNOVA Solutions Inc.
F amount: ratio of fluorine atom in molecule of surfactant

[Table 1. Results of Examples and Comparative Examples]

| | Liquid crystal compound | | Surfactant | | Coating liquid | Evaluation | |
|---|---|---|---|---|---|---|---|
| | Abbre viati on | Waveleng th dispersi on | Abbrev iation | F amount (wt%) | Surface tension (mN/m) | Coatin g adhere nce | Cissing propert y |
| Ex. 1 | A | Inverse | S243 | 16.8 | 32.4 | I | I |
| Ex. 2 | C | Inverse | S242 | 17.9 | 32.4 | I | I |
| Ex. 3 | A | Inverse | 209F | 50.6 | 31.1 | I | I |
| Ex. 4 | A | Inverse | PF656 | 36.8 | 29.3 | I | II |
| Ex. 5 | B | Inverse | PF6520 | 39.6 | 28.3 | II | II |
| Ex. 6 | A | Inverse | FTX218 | 47.4 | 28.1 | I | I |
| Ex. 7 | D | Inverse | F556 | 11.0 | 28.0 | I | I |
| Ex. 8 | A | Inverse | 601AD | 19.2 | 27.5 | I | I |
| Ex. 9 | E | Inverse | 208G | 54.2 | 26.9 | I | II |
| Comp.Ex. 1 | A | Inverse | F558 | 31.7 | 19.4 | III | IV |
| Comp.Ex. 2 | A | Inverse | NS9013 | 30.7 | 23.0 | III | III |
| Comp.Ex. 3 | LC242 | Forward | S243 | 16.8 | 32.2 | III | IV |
| Comp.Ex. 4 | K35 | Forward | S242 | 17.9 | 32.3 | III | IV |

(continued)

| | Liquid crystal compound | | Surfactant | | Coating liquid | Evaluation | |
|---|---|---|---|---|---|---|---|
| | Abbreviation | Wavelength dispersion | Abbreviation | F amount (wt%) | Surface tension (mN/m) | Coating adherence | Cissing property |
| Comp. Ex. 5 | LC242 | Forward | F444 | 42.4 | 32.0 | IV | IV |
| Comp. Ex. 6 | K35 | Forward | 209F | 50.6 | 31.0 | IV | IV |
| Comp. Ex. 7 | LC242 | Forward | PF656 | 36.8 | 29.7 | III | II |
| Comp. Ex. 8 | LC242 | Forward | PF6520 | 39.6 | 29.0 | III | II |
| Comp. Ex. 9 | LC242 | Forward | 208G | 54.2 | 26.7 | III | II |
| Comp. Ex. 10 | K35 | Forward | F554 | 18.1 | 25.7 | III | III |
| Comp. Ex. 11 | LC242 | Forward | F251 | 23.3 | 23.0 | III | II |
| Comp. Ex. 12 | LC242 | Forward | S611 | 11.8 | 19.0 | II | III |

[Table 2. Results of measurement of surface free energy]

| Contact angle | | Surface free energy | | |
|---|---|---|---|---|
| $H_2O$ (°) | $CH_2I_2$ (°) | γd (mN/m) | γh (mN/m) | Totaly (mN/m) |
| 97.0 | 41.8 | 38.9 | 0.2 | 39.1 |

[Discussion]

As apparent from the results shown in Table 1 and Table 2, the coating liquid having a surface tension of 26 mN/m or more as the liquid crystal composition in Examples has high coating adherence and low cissing properties, even when the coating liquid was applied onto the coating surface having a surface free energy of as low as 39.1 mN/m. On the other hand, the coating liquid having a surface tension of less than 26 mN/m according to Comparative Examples 1 to 2 has low coating adherence and high cissing properties, resulting in poor coating properties.
According to technical common sense, it had been considered that when a liquid is applied onto a surface, coating properties become more favorable as the surface tension of the liquid is lower at a large degree than the surface free energy of the surface. In view of this technical common sense, it can be said that defining the surface tension of the liquid crystal composition as being within the specific range of 26 mN/m or more brings about a specific function in terms of the improvement of coating properties when coating the coating surface having a low surface free energy.
Furthermore, as apparent from the results shown in Table 1 and Table 2, the coating liquid according to each of Comparative Examples 3 to 12 which include the forward-wavelength polymerizable liquid crystal compound instead of the inverse wavelength polymerizable liquid crystal compound has low coating adherence and high in cissing properties, resulting in poor coating properties. Thus, it was confirmed that the specific function of improving coating properties as previously described is a function specific to the liquid crystal composition which had a surface tension within a specific range of 26 mN/m or more, and contained the inverse wavelength polymerizable liquid crystal compound.

[Reference Sign List]

100 substrate

110 coating surface
120 coating adherence position
130 foreign substance
200 liquid crystal composition layer
210 outer edge of liquid crystal composition layer
220 cissing portion

## Claims

**1.** A method for producing a multilayer film including a substrate and an optically anisotropic layer, the method comprising:

a step of coating a surface of the substrate with a liquid crystal composition containing a polymerizable liquid crystal compound capable of expressing an inverse wavelength dispersion birefringence to form a layer of the liquid crystal composition; and
a step of polymerizing the polymerizable liquid crystal compound contained in the layer of the liquid crystal composition to obtain an optically anisotropic layer, wherein
the surface of the substrate has a surface free energy of 50 mN/m or less, and
the liquid crystal composition has a surface tension of 26 mN/m or more.

**2.** The method for producing a multilayer film according to claim 1, wherein the polymerizable liquid crystal compound contains a main-chain mesogene and a side-chain mesogene linked to the main-chain mesogene in a molecule of the polymerizable liquid crystal compound.

**3.** The method for producing a multilayer film according to claim 1 or 2, wherein the polymerizable liquid crystal compound is represented by the following Formula (I):

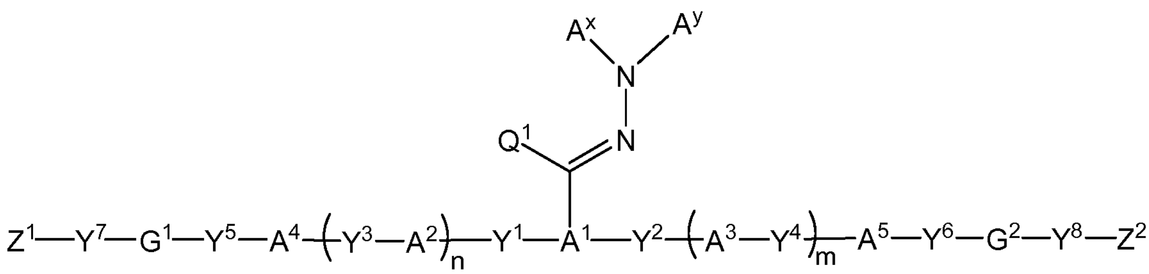

(I)

(in the Formula (I),

$Y^1$ to $Y^8$ are each independently a chemical single bond, -O-, -S-, -O-C(=O)-, -C(=O)-O-, -O-C(=O)-O-, -NR$^1$-C(=O)-, - C(=O)-NR$^1$-, -O-C(=O)-NR$^1$-, -NR$^1$-C(=O)-O-, -NR$^1$-C(=O)-NR$^1$-, - O-NR$^1$-, or -NR$^1$-O-, wherein $R^1$ is a hydrogen atom or an alkyl group of 1 to 6 carbon atoms;
$G^1$ and $G^2$ are each independently a divalent aliphatic group of 1 to 20 carbon atoms optionally having a substituent; the aliphatic groups may have one or more per one aliphatic group of -O-, -S-, -O-C(=O)-, -C(=O)-O-, -O-C(=O)-O-, -NR$^2$-C(=O)-, -C(=O)-NR$^2$-, -NR$^2$-, or -C(=O)-inserted therein; provided that a case where two or more - O- or -S- groups are adjacently inserted are excluded, wherein $R^2$ is a hydrogen atom or an alkyl group of 1 to 6 carbon atoms;
$Z^1$ and $Z^2$ are each independently an alkenyl group of 2 to 10 carbon atoms optionally being substituted by a halogen atom;
$A^x$ is an organic group of 2 to 30 carbon atoms having at least one aromatic ring selected from the group consisting of an aromatic hydrocarbon ring and an aromatic heterocyclic ring;
$A^y$ is a hydrogen atom, an alkyl group of 1 to 20 carbon atoms optionally having a substituent, an alkenyl group of 2 to 20 carbon atoms optionally having a substituent, a cycloalkyl group of 3 to 12 carbon atoms optionally

having a substituent, an alkynyl group of 2 to 20 carbon atoms optionally having a substituent, -C(=O)-$R^3$, -$SO_2$-$R^4$, -C(=S)NH-$R^9$, or an organic group of 2 to 30 carbon atoms having at least one aromatic ring selected from the group consisting of an aromatic hydrocarbon ring and an aromatic heterocyclic ring, wherein $R^3$ is an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, or an aromatic hydrocarbon ring group of 5 to 12 carbon atoms; $R^4$ is an alkyl group of 1 to 20 carbon atoms, an alkenyl group of 2 to 20 carbon atoms, a phenyl group, or a 4-methylphenyl group; $R^9$ is an alkyl group of 1 to 20 carbon atoms optionally having a substituent, an alkenyl group of 2 to 20 carbon atoms optionally having a substituent, a cycloalkyl group of 3 to 12 carbon atoms optionally having a substituent, or an aromatic group of 5 to 20 carbon atoms optionally having a substituent; the aromatic ring that $A^x$ and $A^y$ have may have a substituent; and $A^x$ and $A^y$ may form a ring together;

$A^1$ is a trivalent aromatic group optionally having a substituent;

$A^2$ and $A^3$ are each independently a divalent alicyclic hydrocarbon group of 3 to 30 carbon atoms optionally having a substituent;

$A^4$ and $A^5$ are each independently a divalent aromatic group of 6 to 30 carbon atoms optionally having a substituent;

$Q^1$ is a hydrogen atom or an alkyl group of 1 to 6 carbon atoms optionally having a substituent; and

m and n are each independently 0 or 1).

**4.** The method for producing a multilayer film according to any one of claims 1 to 3, wherein the substrate is a stretched film.

**5.** The method for producing a multilayer film according to any one of claims 1 to 4, wherein the substrate is formed of a resin which includes an alicyclic structure-containing polymer.

**6.** The method for producing a multilayer film according to any one of claims 1 to 5, wherein the surface of the substrate is an untreated surface which is not subjected to a surface treatment.

**7.** A multilayer film comprising:

a substrate; and

an optically anisotropic layer obtained by coating a surface of the substrate having a surface free energy of 50 mN/m or less, with a liquid crystal composition which contains a polymerizable liquid crystal compound capable of expressing an inverse wavelength dispersion birefringence and has a surface tension of 26 mN/m or more, and then polymerizing the polymerizable liquid crystal compound.

FIG.1

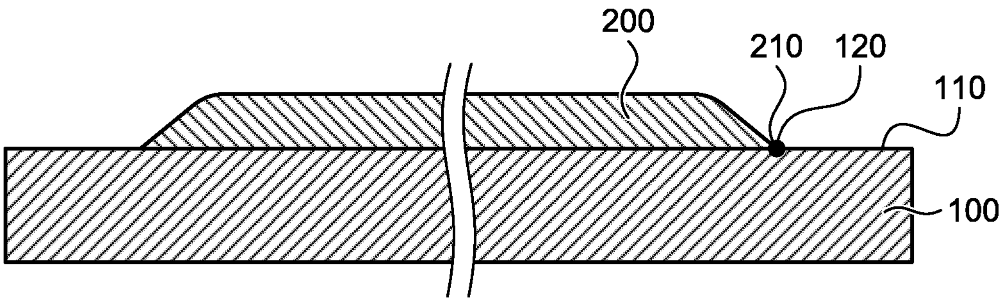


FIG.2

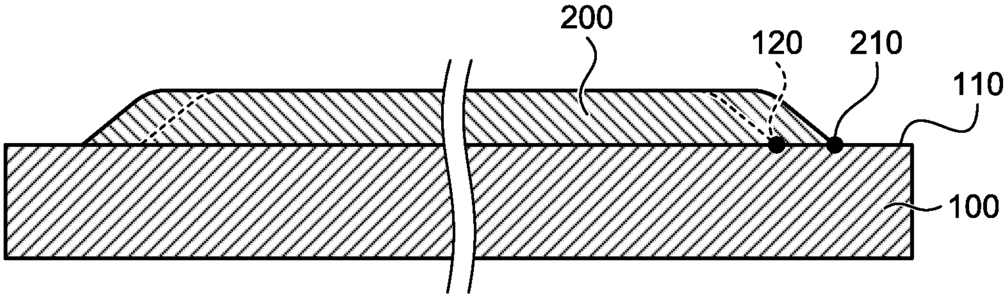

FIG.3

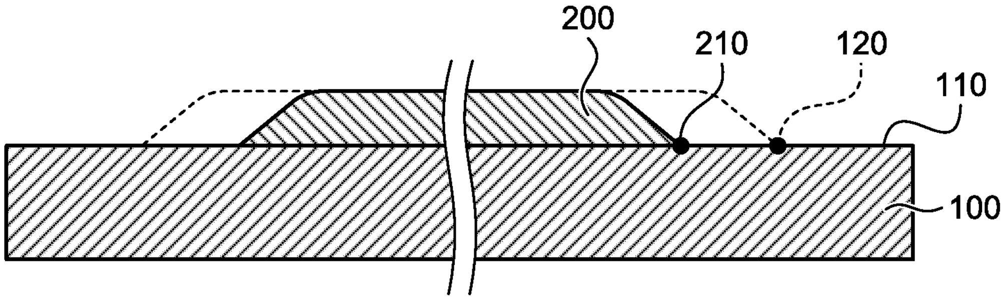


FIG.4

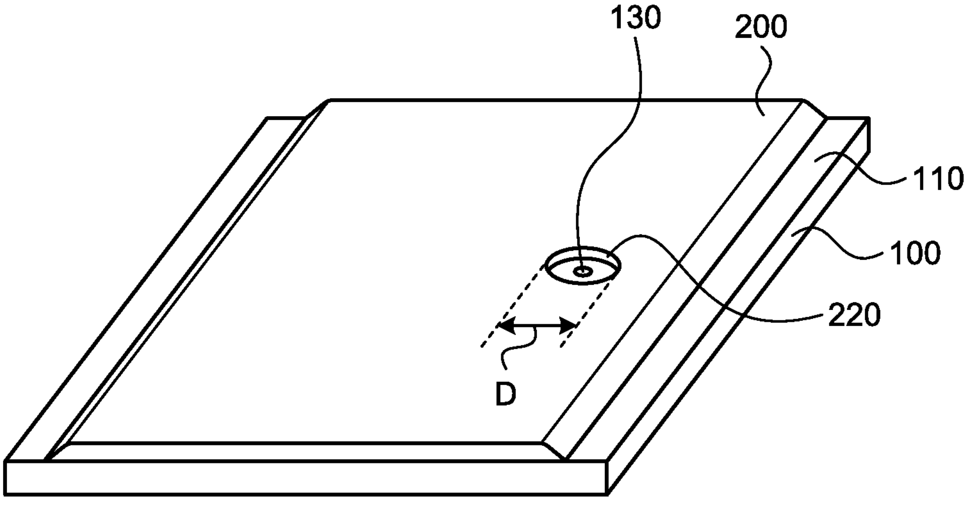

**INTERNATIONAL SEARCH REPORT**

International application No.
PCT/JP2016/061824

A. CLASSIFICATION OF SUBJECT MATTER
*G02B5/30*(2006.01)i, *B05D7/24*(2006.01)i, *B32B7/02*(2006.01)i, *B32B27/00*(2006.01)i, *H01L51/50*(2006.01)i, *H05B33/02*(2006.01)i

According to International Patent Classification (IPC) or to both national classification and IPC

B. FIELDS SEARCHED

Minimum documentation searched (classification system followed by classification symbols)
G02B5/30, B05D7/24, B32B7/02, B32B27/00, H01L51/50, H05B33/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X | WO 2013/018526 A1 (Nippon Zeon Co., Ltd.), 07 February 2013 (07.02.2013), each example | 1-7 |
| X | WO 2014/069515 A1 (Nippon Zeon Co., Ltd.), 08 May 2014 (08.05.2014), each example & CN 104769464 A & KR 10-2015-0081273 A & TW 201425542 A | 1-7 |
| X | WO 2014/065243 A1 (Nippon Zeon Co., Ltd.), 01 May 2014 (01.05.2014), each example & EP 2910986 A1 & CN 104737044 A & KR 10-2015-0073177 A & TW 201418802 A | 1-7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 July 2016 (04.07.16) | 12 July 2016 (12.07.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/061824

C (Continuation). DOCUMENTS CONSIDERED TO BE RELEVANT

| Category* | Citation of document, with indication, where appropriate, of the relevant passages | Relevant to claim No. |
|---|---|---|
| P,X | WO 2015/137446 A1 (Fujifilm Corp.), 17 September 2015 (17.09.2015), each example & TW 201539092 A | 1-7 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001100213 A
- JP 2008209509 A
- JP 2631015 B
- JP 2006281176 A
- JP 2005336103 A
- WO 2009042544 A


### Non-patent literature cited in the description


- **D. K. OWENS ; R. C. WENDT.** *J. Appl. Polym. Sci.,* 1969, vol. 13, 1741
- **YUKI GOSEI.** Jikkenhou Handbook (Organic synthesis experimental method handbook). Maruzen Co., Ltd, 1990, 810
- Shin Jikken Kagaku Koza (New course of experimental chemistry). Maruzen Co., Ltd, 1978, vol. 14
- Jikken Kagaku Koza (Course of experimental chemistry). Maruzen Co., Ltd, 1992, vol. 20
- *The Journal of Organic Chemistry,* 2011, vol. 76, 8082-8087